# EUROPEAN PATENT APPLICATION

(11) **EP 4 835 571 A1**
(43) Date of publication of application: **04.11.2026**
(21) Application number: 24912545.1
(22) Date of filing: 17.12.2024
(51) Int. Cl.: G03F 7/004, G03F 7/20, G03F 7/039

(54) **RESIST MATERIAL, PATTERN FORMATION METHOD, AND PATTERNED STRUCTURE**

(30) Priority: 27.12.2023 JP 2023221801
(71) Applicant: Tokyo Ohka Kogyo Co., Ltd., Kawasaki-shi, Kanagawa 211-0012 (JP)
(72) Inventor: NISHIZAWA, Akito, Kawasaki-shi, Kanagawa 211-0012 (JP); INARI, Takatoshi, Kawasaki-shi, Kanagawa 211-0012 (JP); KIMURA, Kenta, Kawasaki-shi, Kanagawa 211-0012 (JP); NAGATA, Masaya, Kawasaki-shi, Kanagawa 211-0012 (JP)
(74) Representative: Plasseraud IP
(86) International application number: PCT/JP2024/044675
(87) International publication number: WO 2025/142656

(57) **Abstract**

An object of the present invention is to provide a novel resist material containing (A) a heteropolyacid salt having a modified lacunary site or a mixture thereof, a pattern formation method, and a patterned structure.

## Description

### Technical Field

The present invention relates to a resist material, a pattern formation method, and a patterned structure.

### Background Art

The polyacid is an anionic metal oxide cluster represented by the general formula [MₓO_{y}]ⁿ⁻ (wherein x, y, and n all denote natural numbers). The metal atom M constituting the polyacid is referred to as a polyatom and is, for example, Mo (hexavalent or pentavalent), W (hexavalent or pentavalent), V (pentavalent), Nb (pentavalent), Ta (pentavalent), or the like. The polyacid can be broadly divided into an isopolyacid composed of the polyatom M and an oxoacid, and a heteropolyacid ([X_{w}MₓO_{y}]ⁿ⁻ (wherein w, x, y, and n all denote natural numbers)) containing a different type of heteroatom X (for example, P⁵⁺, Si⁴⁺, Ge⁴⁺, B³⁺, or the like as a heteroatom X) in addition to the polyatom M and oxygen.

The physicochemical properties of a polyacid, such as redox ability, actinic radiation reactivity, and acid properties, can be changed depending on the combination and structure of the constituent elements, the type of counter cation, or the like.

Furthermore, it is known that there are a plurality of lacunary species having a defect in part of the basic skeleton in the polyacid. A terminal oxygen atom at a lacunary site having a defect in part of the basic skeleton of the polyacid has a certain degree of negative charge density on the oxygen atom, has high reactivity, and has nucleophilicity. Thus, various functional polyacid complexes or organic/inorganic hybrid structures can be formed by reacting the terminal oxygen atom with an electrophilic atom or molecule.

Patent Literature 1 discloses, as a polyoxometalate compound having a metal-substituted polyoxometalate, a polyoxometalate compound that has a polyoxometalate having a lacunary site, a substituting metal atom (divalent platinum or palladium) introduced into the lacunary site, and an organic ligand.

### Citation List

### Patent Literature

PTL 1: U.S. Patent No. 11420871

### Summary of Invention

### Technical Problem

The present invention aims to provide a novel resist material, a pattern formation method, and a patterned structure.

### Solution to Problem

As a result of extensive studies to solve the above problems, the present inventors have completed the present invention by interestingly finding that a heteropolyacid salt having a modified lacunary site or a mixture thereof can be used as a component of a resist material, and a resist film can be formed by using a resist material containing a heteropolyacid salt having a modified lacunary site or a mixture thereof.

That is, the present invention relates to the following inventions.
<1> A resist material containing (A) a heteropolyacid salt having a modified lacunary site or a mixture thereof.
<2> The resist material according to <1>, wherein the (A) heteropolyacid salt having a modified lacunary site or the mixture thereof has an anion moiety that is a heteropolyacid anion having a lacunary site in which the lacunary site is modified.
<3> The resist material according to <2>, wherein the heteropolyacid anion has a polyatom of Mo, W, V, Nb, or Ta and a heteroatom of P, Si, B, S, or Ge.
<4> The resist material according to <2>, wherein the heteropolyacid anion having the lacunary site is a lacunary Keggin-type heteropolyacid anion or a lacunary Dawson-type heteropolyacid anion.
<5> The resist material according to <2>, wherein the modification is performed by bonding a group having one or more heteroatoms selected from P, Si, Ge, or Sn, to which one or more organic groups are bonded, to the heteropolyacid anion having the lacunary site via a part or all of the heteroatoms.
<6> The resist material according to <5>, in which the organic group has one or more polar groups each having an acid-dissociable group.
<7> The resist material according to <6>, wherein the acid-dissociable group is a tertiary-carbon-type acid-dissociable group, an allyl- or benzyl-type acid-dissociable group, an acetal-type acid-dissociable group, or an aminocarbonyl-type acid-dissociable group.
<8> The resist material according to <1>, wherein (A) the heteropolyacid salt having a modified lacunary site or the mixture thereof has one or more H⁺, metal ions, onium cations, or onium dications in a cation moiety thereof.
<9> The resist material according to <8>, wherein the onium cations or the onium dications are ammonium cations, ammonium dications, phosphonium cations, phosphonium dications, sulfonium cations, sulfonium dications, or iodonium cations.
<10> The resist material according to <1>, wherein the (A) heteropolyacid salt having a modified lacunary site or the mixture thereof is a heteropolyacid salt having a modified lacunary site represented by the general formula (I) or a mixture thereof.

   (A^{m+})ₐ(C^{(am)-}) (I)

   [In the formula (I),
   A^{m+} each independently denotes H⁺, a metal ion, an onium cation, or an onium dication;
   C^{(am)-} denotes a heteropolyacid anion having a lacunary site in which the lacunary site is modified; and
   m denotes an integer in the range of 1 to 5, and a denotes a real number greater than 0]
<11> The resist material according to <10>, wherein the heteropolyacid anion having a lacunary site in which the lacunary site is modified has one or more polar groups each having an acid-dissociable group.
<12> The resist material according to <1>, wherein the (A) heteropolyacid salt having a modified lacunary site or the mixture thereof is a heteropolyacid salt having a modified lacunary site represented by the general formula (I') or a mixture thereof.

   (A'^{m'+})ₐ(Bⁿ⁺)_{b}(C'^{(a'm'+bn)-}) (I)

   [In the formula (I'),
   A'^{m'+} each independently denotes H⁺, a metal ion, an ammonium cation, an ammonium dication, a phosphonium cation, or a phosphonium dication;
   Bⁿ⁺ each independently denotes a sulfonium cation, a sulfonium dication, or an iodonium cation;
   C'^{(a'm'+bn)-} denotes a heteropolyacid anion having a lacunary site in which the lacunary site is modified; and
   m' denotes an integer in the range of 1 to 5, n denotes an integer of 1 or 2, a' denotes a real number, and b denotes a real number greater than 0]
<13> The resist material according to <12>, wherein the heteropolyacid anion having a lacunary site in which the lacunary site is modified has one or more polar groups each having an acid-dissociable group.
<14> The resist material according to <1>, further containing (B) an acid diffusion control agent.
<15> The resist material according to <14>, wherein the (B) acid diffusion control agent is (B1) a photodegradable base.
<16> The resist material according to <1>, further containing an organic solvent.
<17> The resist material according to any one of <1> to <16>, which is a resist material for an electron beam or EUV.
<18> A pattern formation method including:
   a step of forming a resist film using the resist material according to any one of <1> to <16>;
   a step of exposing the resist film; and
   a step of developing the exposed resist film using a developer.
<19> The pattern formation method according to <18>, wherein the step of exposing the resist film includes a step of exposing the resist film to an electron beam with a dose of 2 mC/cm² or less or extreme ultraviolet of 200 mJ/cm² or less.
<20> A patterned structure formed by patterning the resist material according to any one of <1> to <16>.
<21> The resist material according to <4>, wherein the lacunary Keggin-type heteropolyacid anion is represented by the general formula (II-1), (II-2), or (II-3):

   [XM₁₁O₃₉]^{c11-} (II-1)

   [XM₁₀O₃₆]^{c12-} (II-2)

   [XM₉O₃₄]^{c13-} (II-3)

   (wherein
   X denotes a heteroatom of P, Si, B, S, or Ge,
   M denotes a polyatom of Mo, W, V, Nb, or Ta, and
   c11- to c13- denote the number of negative charges, and c11 to c13 denote natural numbers.)
<22> The resist material according to <4>, wherein the lacunary Dawson-type heteropolyacid anion is represented by the general formula (III-1), (III-2), or (III-3):

   [X₂M₁₇O₆₁]^{c21-} (III-I)

   [X₂M₁₆O₅₈]^{c22-} (III-2)

   [X₂M₁₅O₅₆]^{c23-} (III-3)

   (wherein
   X denotes a heteroatom of P, Si, B, S, or Ge,
   M denotes a polyatom of Mo, W, V, Nb, or Ta, and
   c21- to c23- denote the number of negative charges, and c21 to c23 denote natural numbers.)
<23> The resist material according to <2>, wherein the heteropolyacid anion having the modified lacunary site is a heteropolyacid anion having a modified lacunary site represented by any one of the general formulae (VI-1) to (VI-12):

   [XM₁₁O₃₉(R^{1A}X')₂O]^{c31-} (VI-1)

   [XM₁₁O₃₉(R^{1B1}R^{1B2}X')₂]^{c31-} (VI-2)

   [XM₁₁O₃₉(R^{1D}P=O)₂]^{c31-} (VI-3)

   [XM₁₁O₃₉(R^{1E}X")^{c31-} (VI-4)

   [XM₁₀O₃₆(R^{1A}X')₂O]^{c32-} (VI-5)

   [XM₁₀O₃₆(R^{1B1}R^{1B2}X')₂]^{c32-} (VI-6)

   [XM₁₀O₃₆(R^{1C}X'O)₄]^{c32-} (VI-7)

   [XM₁₀O₃₆(R^{1D}P=O)₂]^{c32-} (VI-8)

   [X₂M₁₇O₆₁(R^{1A}X')₂O]^{c33-} (VI-9)

   [X₂M₁₇O₆₁(R^{1B1}R^{1B2}X')₂]^{c33-} (VI-10)

   [X₂M₁₇O₆₁(R^{1D}P=O)₂]^{c33-} (VI-11)

   [X₂M₁₇O₆₁(R^{1E}X")]^{c33-} (VI-12)

   (wherein
   X denotes a heteroatom of P, Si, B, S, or Ge,
   M denotes a polyatom of Mo, W, V, Nb, or Ta, and
   X') denotes a heteroatom of Si or Ge;
   X" denotes a heteroatom of Si, Ge, or Sn;
   R^{1A} to R^{1E} each independently denote a hydro group, an optionally substituted C₁₋₁₈ hydrocarbyl group, an optionally substituted 3- to 18-membered non-aromatic heterocyclic group, or an optionally substituted 5- to 18-membered aromatic heterocyclic group,
      a divalent carbon atom at any position of R^{1A} to R^{1E} excluding the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time),
   a hydrogen atom in R^{1A} to R^{1E} may be substituted with, for example, (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group; and
   c31, c32, and c33 denote natural numbers)

### Advantageous Effects of Invention

The present invention can provide a novel resist material containing a heteropolyacid salt having a modified lacunary site or a mixture thereof, a pattern formation method, and a patterned structure.

A resist material having various functionalities can be provided by customizing an anion moiety and a cation moiety of a heteropolyacid salt having a modified lacunary site or a mixture thereof. For example, a resist material whose solubility in a developer can be changed by the action of an acid can be provided by introducing a polar group having an acid-dissociable group into an anion moiety of a heteropolyacid salt having a modified lacunary site or a mixture thereof. Furthermore, a resist material that generates an acid upon exposure to DUV, XUV, EUV, an electron beam, or the like can be provided by introducing sulfonium cations, sulfonium dications, or iodonium cations into a cation moiety of a heteropolyacid salt having a modified lacunary site or a mixture thereof.

### Description of Embodiments

Preferred embodiments of the present invention will be described in detail below. However, the present invention is not limited to the following embodiments.

In the present description, the term "(meth)acryloyl group" is used to mean both an acryloyl group and a methacryloyl group.

The term "halogen atom", as used herein, refers to a fluorine atom, a chlorine atom, a bromine atom, or an iodine atom.

In the present description, for example, the term "C₁₋₆" or the like means the number of carbon atoms of a group serving as a mother nucleus.

The term "C₁₋₁₈ hydrocarbylene group", as used herein, refers to a divalent hydrocarbon group formed by removing two hydrogen atoms from a hydrocarbon with 1 to 18 carbon atoms. The hydrocarbylene group may be linear, branched, or partially or fully cyclic. Examples of the hydrocarbylene group include an alkylene group and an arylene group.

A divalent carbon atom at any position of the "C₁₋₁₈ hydrocarbylene group" may be substituted with -O-, -S-, -C(=O)-, -COO-, -OCO-, -CONH-, -NHCO-, -NH(C=O)O-, -S-, -SO-, or - SO₂- (provided that adjacent divalent carbon atoms are not replaced at the same time).

The "C₁₋₁₈ hydrocarbylene group" is, for example, but not limited to, a "C₁₋₁₈ alkylene group", such as a methylene group, an ethylene group, a n-propylene group, an i-propylene group, a cyclopentadiyl group, a cyclohexanediyl group, an oxyethane-1,1-diyl group, an oxyethane-1,2-diyl group, an oxypropane-1,3-diyl group, an oxypropane-1,2-diyl group, a 2-methylpropane-1,3-diyl group, or an oxyethyleneoxyethane-1,1-diyl group; a "C₆₋₁₈ arylene group", such as a 1,4-phenylene group, a 1,3-phenylene group, a 1,2-phenylene group, a 1,4-naphthylene group, a 1,5-naphthylene group, a 1,8-naphthylene group, a 4,4-biphenylene group, an anthracenediyl group, a phenanthrenediyl group, a naphthacenediyl group, a pyrenediyl group, a perylenediyl group, or a chrysenediyl group; or the like.

The term "C₁₋₁₈ alkyl group", as used herein, refers to a linear or branched alkyl group with 1 to 18 carbon atoms.

Furthermore, a divalent carbon atom at any position excluding the terminals contained in the "C₁₋₁₈ alkyl group" may be substituted with -O-, -C(=O)-, -C(=O)O-, -OCO-, -CONH-, -NHCO-, - NH(C=O)O-, -S-, or -SO₂-. However, adjacent divalent carbon atoms are not replaced at the same time.

The "C₁₋₁₈ alkyl group" is, for example, but not limited to, a methyl group, an ethyl group, a n-propyl group, an i-propyl group, a n-butyl group, an i-butyl group, a sec-butyl group, a t-butyl group, a n-pentyl group, an i-pentyl group, a sec-pentyl group, a t-pentyl group, a neopentyl group, a 1-methylbutyl group, a 2-methylbutyl group, a 1,1-dimethylpropyl group, a 1,2-dimethylpropyl group, a n-hexyl group, an i-hexyl group, a 1-methylpentyl group, a 2-methylpentyl group, a 3-methylpentyl group, a 1,1-dimethylbutyl group, a 1,2-dimethylbutyl group, a 2,2-dimethylbutyl group, a 1,3-dimethylbutyl group, a 2,3-dimethylbutyl group, a 3,3-dimethylbutyl group, a 1-ethylbutyl group, a 2-ethylbutyl group, a 1,1,2-trimethylpropyl group, a 1,2,2-trimethylpropyl group, a 1-ethyl-1-methylpropyl group, a 1-ethyl-2-methylpropyl group, a n-heptyl group, a n-octyl group, a n-nonyl group, a n-decyl group, a n-undecyl group, a n-dodecyl group, or the like.

The "C₁₋₁₈ alkyl group" in which a divalent carbon atom at any non-terminal position may be substituted with -O-, -C(=O)-, -C(=O)O-, -OCO-, -CONH-, -NHCO-, -NH(C=O)O-, -S-, or -SO₂- is, for example, but not limited to, a 2-methoxyethoxymethyl group, an ethoxycarbonylmethyl group, or the like.

The term "C₁₋₁₈ haloalkyl group", as used herein, refers to a group in which one or more hydrogen atoms of the "C₁₋₁₈ alkyl group" are substituted by a halogen atom.

The "C₁₋₁₈ haloalkyl group" is, for example, but not limited to, a dichloromethyl group, a trifluoromethyl group, a 2,2-difluoroethyl group, a 2,2,2-trifluoroethyl group, a pentafluoroethyl group, a 3,3,3-trifluoropropyl group, or the like.

The term "C₂₋₁₈ alkenyl group", as used herein, refers to an alkenyl group having one or more double bonds in the "C₁₋₁₈ alkyl group" having 2 or more carbon atoms, and includes an alkadienyl group, an alkatrienyl group, or the like.

The "C₂₋₁₈ alkenyl group" is, for example, but not limited to, a vinyl group (ethenyl group), an allyl group (2-propenyl group), a 1-propenyl group, an isopropenyl group (1-methyl vinyl group), a 1-butenyl group, a 2-butenyl group, a 3-butenyl group, a pentenyl group, a hexenyl group, a heptenyl group, an octenyl group, a nonenyl group, a decenyl group, an undecenyl group, a dodecenyl group, or the like.

The term "C₂₋₁₈ alkynyl group", as used herein, refers to an alkynyl group having one or more triple bonds in the "C₁₋₁₈ alkyl group" having 2 or more carbon atoms.

The "C₂₋₁₈ alkynyl group" is, for example, but not limited to, an ethynyl group, a 1-propynyl group, a 2-propynyl group, a pentynyl group, a hexynyl group, a heptynyl group, an octynyl group, a nonynyl group, a decynyl group, an undecynyl group, a dodecynyl group, or the like.

The term "C₃₋₁₈ alicyclic group", as used herein, refers to a hydrocarbon group with 3 to 18 carbon atoms and with a monocyclic or polycyclic structure in whole or in part. The alicyclic group includes a cycloalkyl group, a cycloalkenyl group, a cycloalkynyl group, a monocycloalkyl group, a polycycloalkyl group, or the like.

A divalent carbon atom at any non-terminal position in the "C₃₋₁₈ alicyclic group" may be substituted with -O-, -C(=O)-, -C(=O)O-, -OCO-, -CONH-, -NHCO-, -NH(C=O)O-, -S-, or -SO₂-(provided that adjacent divalent carbon atoms are not replaced at the same time).

The "C₃₋₁₈ cycloalkyl group" is, for example, but not limited to, a cyclopropyl group, a cyclobutyl group, a cyclopentyl group, a 1-i-propylcyclopentane-1-yl group, a cyclohexyl group, a t-butylcyclohexyl group, a tricyclodecanyl group, a cycloheptyl group, a cyclooctyl group, a cyclodecyl group, a 2-methyladamantane-2-yl group, a 2-i-propyladamantane-2-yl group, a bornyl group, a norbornyl group, a fenchyl group, a pinanyl group, an adamantyl group, a tricyclodecyl group, a tetracyclododecyl group, a cyclopropylmethyl group, a cyclobutylmethyl group, a cyclopentylmethyl group, a cyclohexylmethyl group, a bornylmethyl group, a norbornylmethyl group, an adamantylmethyl group, a 1-methylcyclopentyloxycarbonylmethyl group, a cyclopentenyl group, a cyclohexenyl group, a cycloheptenyl group, or the like.

The term "3- to 18-membered non-aromatic heterocyclic group", as used herein, refers to a 3- to 18-membered non-aromatic heterocyclic group containing one or more heteroatoms selected from the group consisting of a nitrogen atom, an oxygen atom, and a sulfur atom, the group being monocyclic, polycyclic, or condensed, and being saturated or partially unsaturated.

The "3- to 18-membered non-aromatic heterocyclic group" is, for example, but not limited to, an aziridinyl group, an azetidyl group, a pyrrolidinyl group, a pyrrolyl group, a piperidinyl group, a piperazinyl group, a morpholinyl group, a thiomorpholinyl group, a tetrahydrofuryl group, a tetrahydropyranyl group, an oxetanyl group, a tetrahydrofuryl group, a tetrahydropyranyl group, an imidazolinyl group, an oxazolinyl group, a 2,5-diazabicyclo[2.2.1]heptyl group, a 2,5-diazabicyclo[2.2.2]octyl group, a 3,8-diazabicyclo[3.2.1]octyl group, a 1,4-diazabicyclo[4.3.0]nonyl group, a 1-azaadamantyl group, a 2-azaadamantyl group, or the like.

The term "C₂₋₁₈ aryl group", as used herein, refers to an aromatic hydrocarbon ring group with 6 to 18 carbon atoms or an aromatic heterocyclic group with 2 to 10 carbon atoms; in the case of an aromatic heterocyclic group, 2 to 10 carbon atoms and one or more heteroatoms selected from the group consisting of a nitrogen atom, an oxygen atom, and a sulfur atom form a ring, and the ring may be monocyclic, polycyclic, or a fused ring.

The "C₂₋₁₈ aryl group" is, for example, but not limited to, a phenyl group, a 1-naphthyl group, a 2-naphthyl group, an azulenyl group, a pentalenyl group, a heptalenyl group, an indacenyl group, an acenaphthyl group, a phenanthrenyl group, an anthracenyl group, or the like.

The term "C₇₋₁₈ aralkyl group", as used herein, refers to a group in which a substitutable portion of a "C₁₋₁₂ alkyl group" is substituted by the "C₂₋₁₂ aryl group".

The "C₇₋₁₈ aralkyl group" is, for example, but not limited to, a benzyl group, a phenethyl group, a 3-phenylpropyl group, a 4-phenylbutyl group, a 1-naphthylmethyl group, or a 2-naphthylmethyl group, or the like.

The term "C₁₋₁₈ hydrocarbyl group", as used herein, refers to a monovalent group formed by removing one hydrogen atom from a hydrocarbon with 1 to 18 carbon atoms. Examples of the hydrocarbyl group include an alkyl group, an alkenyl group, an alkynyl group, an alicyclic group, an aryl group, an aralkyl group, or the like.

A divalent carbon atom at any non-terminal position in the "C₁₋₁₈ hydrocarbyl group" may be substituted with -O-, -C(=O)-, -C(=O)O-, -OCO-, -CONH-, -NHCO-, -NH(C=O)O-, -S-, or -SO₂-(provided that adjacent divalent carbon atoms are not replaced at the same time). The same applies to the "C₁₋₁₈ hydrocarbyl group" or the like used in the following description of the definition of the "C₁₋₁₈ hydrocarbyloxy group" or the like.

The "C₁₋₁₈ hydrocarbyl group" is, for example, but not limited to, a "C₁₋₁₈ alkyl group", a "C₂₋₁₈ alkenyl group", a "C₂₋₁₈ alkynyl group", a "C₃₋₁₈ alicyclic group", a "C₂₋₁₈ aryl group", a "C₇₋₁₈ aralkyl group", or the like.

The term "C₁₋₁₈ hydrocarbyloxy group", as used herein, refers to a group in which an oxygen atom (-O-) is bonded to the "C₁₋₁₈ hydrocarbyl group".

The "C₁₋₁₈ hydrocarbyloxy group" is, for example, but not limited to, a "C₁₋₁₈ alkoxy group", such as a methoxy group, an ethoxy group, a n-propoxy group, an i-propoxy group, a n-butoxy group, an i-butoxy group, a sec-butoxy group, a t-butoxy group, a n-pentoxy group, an i-pentoxy group, a sec-pentoxy group, a n-hexoxy group, an i-hexoxy group, a 1,1-dimethylpropyloxy group, a 1,2-dimethylpropyloxy group, a 2,2-dimethylpropyloxy group, a 1-methyl-2-ethylpropyloxy group, a 1-ethyl-2-methylpropyloxy group, a 1,1,2-trimethylpropyloxy group, a 1,2,2-trimethylpropyloxy group, a 1,1-dimethylbutyloxy group, a 1,2-dimethylbutyloxy group, a 2,2-dimethylbutyloxy group, a 2,3-dimethylbutyloxy group, a 1,3-dimethylbutyloxy group, a 2-ethylbutyloxy group, a 2-methylpentyloxy group, or a 3-methylpentyloxy group; a "C₃₋₁₈ alicyclic oxy group", such as a cyclopropyloxy group, a cyclobutyloxy group, a cyclopentyloxy group, a cyclohexyloxy group, a cycloheptyloxy group, a cyclooctyloxy group, a 1-methylcyclopentyloxycarbonylmethoxy group, a 1-ethylcyclohexyloxycarbonylmethoxy group, or a 1-methyladamantyloxycarbonylmethoxy group; a "C₆₋₁₈ aryloxy group", such as a phenyloxy group, a 1-naphthyloxy group, a 2-naphthyloxy group, an azulenyloxy group, a pentalenyloxy group, a heptalenyloxy group, an indacenyloxy group, an acenaphthyloxy group, a phenanthrenyloxy group, or an anthracenyloxy group; or the like.

In the "C₁₋₁₈ hydrocarbyloxy group", a divalent carbon atom at any non-terminal position in the "C₁₋₁₈ hydrocarbyl group" is preferably substituted with -O-, -C(=O)-, and/or -C(=O)O-, the "C₁₋₁₈ hydrocarbyloxy group" is more preferably a "C₁₋₁₈ hydrocarbyloxycarbonylalkyloxy group", and from the perspective of solubility, a carbon atom bonded to the oxygen atom of the hydrocarbyloxy is still more preferably a tertiary carbon. Specific examples of the hydrocarbyloxy include optionally substituted ethylcyclopentyloxy, methyladamantyloxy, ethyladamantyloxy, t-butyloxy, or the like.

The term "C₁₋₁₈ hydrocarbylcarbonyl group", as used herein, refers to a group in which a carbonyl group (-C(=O)-) is bonded to the "C₁₋₁₈ hydrocarbyl group".

The "C₁₋₁₈ hydrocarbylcarbonyl group" is, for example, but not limited to, a "C₁₋₁₈ alkyl carbonyl group", such as an acetyl group, a propionyl group, an isopropionyl group, a butyryl group, an isobutyryl group, a valeryl group, an isovaleryl group, a pentanoyl group, a 3-methylbutanoyl group, a pivaloyl group, a hexanoyl group, or a heptanoyl group; a "C₃₋₁₈ alicyclic carbonyl group", such as a cyclopropyl carbonyl group, a cyclobutyl carbonyl group, a cyclopentyl carbonyl group, a 2-methylcyclopentyl carbonyl group, a 3-methylcyclopentyl carbonyl group, a cyclohexyl carbonyl group, a 2-methylcyclohexyl carbonyl group, a 3-methylcyclohexyl carbonyl group, a 4-methylcyclohexyl carbonyl group, or an adamantyl carbonyl group; a "C₆₋₁₈ aryl carbonyl group", such as a benzoyl group, a 1-naphthoyl group, or a 2-naphthoyl group; or the like.

The term "C₁₋₁₈ hydrocarbylcarbonyloxy group", as used herein, refers to a group in which an oxygen atom (-O-) is bonded to the "C₁₋₁₈ hydrocarbylcarbonyl group".

The "C₁₋₁₈ hydrocarbylcarbonyloxy group" is, for example, but not limited to, a "C₁₋₁₈ alkyl carbonyloxy group", such as a methyl carbonyloxy group, an ethyl carbonyloxy group, a n-propyl carbonyloxy group, an isopropyl carbonyloxy group, a n-butyl carbonyloxy group, an isobutyl carbonyloxy group, a t-butyl carbonyloxy group, a n-pentyl carbonyloxy group, an isopentyl carbonyloxy group, or a hexyl carbonyloxy group; a "C₃₋₁₈ alicyclic carbonyloxy group", such as a cyclopropyl carbonyloxy group, a cyclobutyl carbonyloxy group, a cyclopentyl carbonyloxy group, or a cyclohexyl carbonyloxy group; a "C₆₋₁₈ aryl carbonyloxy group", such as a phenyl carbonyloxy group, a naphthyl carbonyloxy group, an acenaphthyl carbonyloxy group, a phenanthrenyl carbonyloxy group, or an anthracenyl carbonyloxy group; or the like.

The term "C₁₋₁₈ hydrocarbyloxycarbonyl group", as used herein, refers to a group in which a carbonyl group (-C(=O)-) is bonded to a "C₁₋₁₈ hydrocarbyloxy group".

The "C₁₋₁₈ hydrocarbyloxycarbonyl group" is, for example, but not limited to, a "C₁₋₁₈ alkoxycarbonyl group", such as a methoxycarbonyl group, an ethoxycarbonyl group, a n-propoxycarbonyl group, an i-propoxycarbonyl group, a n-butoxycarbonyl group, an i-butoxycarbonyl group, a sec-butoxycarbonyl group, a t-butoxycarbonyl group, a n-pentoxycarbonyl group, or a neopentyloxycarbonyl group; a "C₃₋₁₈ alicyclic oxycarbonyl group", such as a cyclopropyloxycarbonyl group, a cyclobutyloxycarbonyl group, a cyclopentyloxycarbonyl group, a cyclohexyloxycarbonyl group, a 2-methylcyclopentyloxycarbonyl group, a 3-methylcyclopentyloxycarbonyl group, a 2-methylcyclohexyloxycarbonyl group, a 3-methylcyclohexyloxycarbonyl group, or a 4-methylcyclohexyloxycarbonyl group; a "C₆₋₁₈ aryloxycarbonyl group", such as a phenoxycarbonyl group, a naphthoxycarbonyl group, an acenaphthyloxycarbonyl group, a phenanthrenyloxycarbonyl group, or an anthracenyloxycarbonyl group; or the like.

The term "C₁₋₁₈ hydrocarbyloxycarbonyloxy group", as used herein, refers to a group in which an oxygen atom (-O-) is bonded to the "C₁₋₁₈ hydrocarbyloxycarbonyl group".

The "C₁₋₁₈ hydrocarbyloxycarbonyloxy group" is, for example, but not limited to, a "C₁₋₁₈ alkoxycarbonyloxy group", such as a methoxycarbonyloxy group, an ethoxycarbonyloxy group, a n-propyloxycarbonyloxy group, an i-propyloxycarbonyloxy group, a n-butoxycarbonyloxy group, an i-butoxycarbonyloxy group, a sec-butoxycarbonyloxy group, a t-butoxycarbonyloxy group, a n-pentyloxycarbonyloxy group, an i-pentyloxycarbonyloxy group, or a n-hexyloxycarbonyloxy group; a "C₃₋₁₈ alicyclic oxycarbonyloxy group", such as a cyclopropyloxycarbonyloxy group, a cyclobutyloxycarbonyloxy group, a cyclopentyloxycarbonyloxy group, or a cyclohexyloxycarbonyloxy group; a "C₆₋₁₈ aryloxycarbonyloxy group", such as a phenoxycarbonyloxy group, a naphthoxycarbonyloxy group, an acenaphthyloxycarbonyloxy group, a phenanthrenyloxycarbonyloxy group, or an anthracenyloxycarbonyloxy group; or the like.

The term "C₁₋₁₈ hydrocarbylamino group", as used herein, refers to a group in which one "C₁₋₁₈ hydrocarbyl group" is bonded to an amino group.

The "C₁₋₁₈ hydrocarbylamino group" is, for example, but not limited to, a "C₁₋₁₈ alkylamino group", such as a methylamino group, an ethylamino group, a n-propylamino group, an i-propylamino group, a n-butylamino group, an i-butylamino group, a sec-butylamino group, a t-butylamino group, a n-pentylamino group, an i-pentylamino group, a neopentylamino group, or a n-hexylamino group; a "C₃₋₁₈ alicyclic amino group", such as a cyclopropyl lamino group, a cyclobutyl amino group, a cyclopentyl amino group, a 2-methylcyclopentyl amino group, a 3-methylcyclopentyl amino group, a cyclohexyl amino group, a 2-methylcyclohexyl amino group, a 3-methylcyclohexyl amino group, or a 4-methylcyclohexyl amino group; a "C₆₋₁₈ arylamino group", such as a phenylamino group, a 1-naphthylamino group, or a 2-naphthylamino group; or the like.

The term "di-C₁₋₁₈ hydrocarbylamino group", as used herein, refers to a group in which two identical or different "C₁₋₁₈ hydrocarbyl groups" are bonded to an amino group.

The "di-C₁₋₁₈ hydrocarbylamino group" is, for example, but not limited to, a "di-C₁₋₁₈ alkylamino group", such as a dimethylamino group, a diethylamino group, a di-n-propylamino group, a diisopropylamino group, a di-n-butylamino group, a diisobutylamino group, a di-t-butylamino group, a di-n-pentylamino group, a di-n-hexylamino group, an N-ethyl-N-methylamino group, an N-methyl-N-n-propylamino group, an N-isopropyl-N-methylamino group, an N-n-butyl-N-methylamino group, an N-isobutyl-N-methylamino group, an N-t-butyl-N-methylamino group, an N-methyl-N-n-pentylamino group, an N-n-hexyl-N-methylamino group, an N-ethyl-N-n-propylamino group, an N-ethyl-N-isopropylamino group, an N-n-butyl-N-ethylamino group, an N-ethyl-N-isobutylamino group, an N-t-butyl-N-ethylamino group, an N-ethyl-N-n-pentylamino group, or an N-ethyl-N-n-hexylamino group; a "di-C₃₋₁₈ alicyclic amino group", such as a dicyclopropylamino group, a dicyclobutylamino group, a dicyclopentylamino group, or a dicyclohexylamino group; a "di-C₆₋₁₈ arylamino group", such as a diphenylamino group or a phenylnaphthylamino group; an "N-C₁₋₁₈ alkyl-N-C₃₋₁₈ cycloalkylamino group", such as an N-methylcyclopentaneamino group or an N-methylcyclohexylamino group; an "N-C₁₋₁₈ alkyl-N-C₆₋₁₈ arylamino group", such as an N-methyl-2-phenylethylamino group or an N-ethyl-N-(4-methylphenyl)amino group; or the like.

The term "C₁₋₁₈ hydrocarbylaminocarbonyl group", as used herein, refers to a group in which a carbonyl group (-C(=O)-) is bonded to the "C₁₋₁₈ hydrocarbylamino group".

The "C₁₋₁₈ hydrocarbylaminocarbonyl group" is, for example, but not limited to, a "C₁₋₁₈ alkylaminocarbonyl group", such as a methylaminocarbonyl group, an ethylaminocarbonyl group, a n-propylaminocarbonyl group, an i-propylaminocarbonyl group, a n-butylaminocarbonyl group, a sec-butylaminocarbonyl group, a t-butylaminocarbonyl group, a n-pentylaminocarbonyl group, a 2-pentylaminocarbonyl group, a neopentylaminocarbonyl group, a 4-methyl-2-pentylaminocarbonyl group, a n-hexylaminocarbonyl group, or a 3-methyl-n-pentylaminocarbonyl group; a "C₃₋₁₈ alicyclic aminocarbonyl group", such as a cyclopropylaminocarbonyl group, a cyclobutylaminocarbonyl group, a cyclopentylaminocarbonyl group, a cyclohexylaminocarbonyl group, a 2-methylcyclopentylaminocarbonyl group, a 3-methylcyclopentylaminocarbonyl group, a 2-methylcyclohexylaminocarbonyl group, a 3-methylcyclohexylaminocarbonyl group, or a 4-methylcyclohexylaminocarbonyl group; or a "C₆₋₁₈ arylaminocarbonyl group", such as a phenylaminocarbonyl group, a 1-naphthylaminocarbonyl group, or a 2-naphthylaminocarbonyl group.

The term "di-C₁₋₁₈ hydrocarbylaminocarbonyl group", as used herein, refers to a group in which a carbonyl group (-C(=O)-) is bonded to a "di-C₁₋₁₈ hydrocarbylamino group".

The "di-C₁₋₁₈ hydrocarbylaminocarbonyl group" is, for example, but not limited to, a "di-C₁₋₁₈ alkylaminocarbonyl group", such as a dimethylaminocarbonyl group, a diethylaminocarbonyl group, a di-n-propylaminocarbonyl group, a diisopropylaminocarbonyl group, a di-n-butylaminocarbonyl group, a diisobutylaminocarbonyl group, a di-t-butylaminocarbonyl group, a di-n-pentylaminocarbonyl group, a di-n-hexylaminocarbonyl group, an N-ethyl-N-methylaminocarbonyl group, an N-methyl-N-n-propylaminocarbonyl group, an N-isopropyl-N-methylaminocarbonyl group, an N-n-butyl-N-methylaminocarbonyl group, an N-isobutyl-N-methylaminocarbonyl group, an N-t-butyl-N-methylaminocarbonyl group, an N-methyl-N-n-pentylaminocarbonyl group, an N-n-hexyl-N-methylaminocarbonyl group, an N-ethyl-N-n-propylaminocarbonyl group, an N-ethyl-N-isopropylaminocarbonyl group, an N-n-butyl-N-ethylaminocarbonyl group, an N-ethyl-N-isobutylaminocarbonyl group, an N-t-butyl-N-ethylaminocarbonyl group, an N-ethyl-N-n-pentylaminocarbonyl group, or an N-ethyl-N-n-hexylaminocarbonyl group; a "di-C₃₋₁₈ alicyclic aminocarbonyl group", such as a dicyclopropylaminocarbonyl group, a dicyclobutylaminocarbonyl group, a dicyclopentylaminocarbonyl group, or a dicyclohexylaminocarbonyl group; a "di-C₆₋₁₈ arylaminocarbonyl group", such as a diphenylaminocarbonyl group or a phenylnaphthylaminocarbonyl group; or the like.

The term "C₁₋₁₈ hydrocarbylcarbonylamino group", as used herein, refers to a group in which an amino group is bonded to the "C₁₋₁₈ hydrocarbylcarbonyl group".

The "C₁₋₁₈ hydrocarbylcarbonylamino group" is, for example, but not limited to, a "C₁₋₁₈ alkyl carbonylamino group", such as a methyl carbonylamino group, an ethyl carbonylamino group, a n-propyl carbonylamino group, an i-propyl carbonylamino group, a n-butyl carbonylamino group, an i-butyl carbonylamino group, a sec-butyl carbonylamino group, a t-butyl carbonylamino group, a n-pentyl carbonylamino group, an i-pentyl carbonylamino group, or a n-hexyl carbonylamino group; a "C₃₋₁₈ alicyclic carbonylamino group", such as a cyclopropyl carbonylamino group, a cyclobutyl carbonylamino group, a cyclopentyl carbonylamino group, or a cyclohexyl carbonylamino group; a "C₆₋₁₈ aryl carbonylamino group", such as a phenyl carbonylamino group, a naphthyl carbonylamino group, an acenaphthyl carbonylamino group, a phenanthrenyl carbonylamino group, or an anthracenyl carbonylamino group; or the like.

The term "C₁₋₁₈ hydrocarbylaminocarbonyloxy group", as used herein, refers to a group in which an oxygen atom (-O-) is bonded to the "C₁₋₁₈ hydrocarbylaminocarbonyl group".

The "C₁₋₁₈ hydrocarbylaminocarbonyloxy group" is, for example, but not limited to, a "C₁₋₁₈ alkylaminocarbonyloxy group", such as a methylaminocarbonyloxy group, an ethylaminocarbonyloxy group, or a n-propylaminocarbonyloxy group; a "C₃₋₁₈ alicyclicaminocarbonyloxy group", such as a cyclopropylaminocarbonyloxy group or a cyclohexylaminocarbonyloxy group; a "C₆₋₁₈ arylaminocarbonyloxy group", such as a phenylaminocarbonyloxy group or a 1-naphthylaminocarbonyloxy group; or the like.

The term "di-C₁₋₁₈ hydrocarbylaminocarbonyloxy group", as used herein, refers to a group in which an oxygen atom (-O-) is bonded to the "di-C₁₋₁₈ hydrocarbylaminocarbonyl group".

The "di-C₁₋₁₈ hydrocarbylaminocarbonyloxy group" is, for example, but not limited to, a "di-C₁₋₁₈ alkylaminocarbonyloxy group", such as a dimethylaminocarbonyloxy group, a diethylaminocarbonyloxy group, or a di-n-propylaminocarbonyloxy group; or the like.

The term "C₁₋₁₈ hydrocarbylaminocarbonylamino group", as used herein, refers to a group in which the "C₁₋₁₈ hydrocarbylaminocarbonyl group" is bonded to an amino group.

The "C₁₋₁₈ hydrocarbylaminocarbonylamino group" is, for example, but not limited to, a "C₁₋₁₈ alkylaminocarbonylamino group", such as a methylaminocarbonylamino group, an ethylaminocarbonylamino group, or a n-propylaminocarbonylamino group; a "C₃₋₁₈ alicyclic aminocarbonylamino group", such as a cyclopropylaminocarbonylamino group or a cyclohexylaminocarbonylamino group; a "C₆₋₁₈ arylaminocarbonylamino group", such as a phenylaminocarbonylamino group or a 1-naphthylaminocarbonylamino group; or the like.

The term "di-C₁₋₁₈ hydrocarbylaminocarbonylamino group", as used herein, refers to a group in which a "di-C₁₋₁₈ hydrocarbylaminocarbonyl group" is bonded to an amino group.

The "di-C₁₋₁₈ hydrocarbylaminocarbonylamino group" is, for example, but not limited to, a "di-C₁₋₁₈ alkylaminocarbonylamino group", such as a dimethylaminocarbonylamino group, a diethylaminocarbonylamino group, or a di-n-propylaminocarbonylamino group; or the like.

The term "C₁₋₁₈ hydrocarbyloxycarbonylamino group", as used herein, refers to a group in which the "C₁₋₁₈ hydrocarbyloxycarbonyl group" is bonded to an amino group.

The "C₁₋₁₈ hydrocarbyloxycarbonylamino group" is, for example, but not limited to, a "C₁₋₁₈ alkoxycarbonylamino group", such as a methoxycarbonylamino group, an ethoxycarbonylamino group, a n-propoxycarbonylamino group, an i-propoxycarbonylamino group, a n-butoxycarbonylamino group, or a t-butoxycarbonylamino group; a "C₃₋₁₈ alicyclic oxycarbonylamino group", such as a cyclopropyloxycarbonylamino group or a cyclohexyloxycarbonylamino group; a "C₆₋₁₈ aryloxycarbonylamino group", such as a phenyloxycarbonylamino group or a 1-naphthyloxycarbonylamino group; or the like.

The term "C₁₋₁₈ hydrocarbylthio group", as used herein, refers to a group in which a sulfur atom (-S-) is bonded to the "C₁₋₁₈ hydrocarbyl group".

The "C₁₋₁₈ hydrocarbylthio group" is, for example, but not limited to, a "C₁₋₁₈ alkylthio group", such as a methylthio group, an ethylthio group, a n-propylthio group, an i-propylthio group, a n-butylthio group, an i-butylthio group, a t-butylthio group, a n-pentylthio group, or a n-hexylthio group; a "C₃₋₁₈ alicyclicthio group", such as a cyclopropylthio group, a cyclobutylthio group, a cyclopentylthio group, a cyclohexylthio group, a 2-methylcyclopentylthio group, a 3-methylcyclopentylthio group, a 2-methylcyclohexylthio group, a 3-methylcyclohexylthio group, or a 4-methylcyclohexylthio group; a "C₆₋₁₈ arylthio group", such as a phenylthio group, a 1-naphthylthio group, a 2-naphthylthio group, an acenaphthylthio group, a phenanthrenylthio group, or an anthracenylthio group; or the like.

The term "C₁₋₁₈ hydrocarbylsulfinyl group", as used herein, refers to a group in which a sulfinyl group (-S(=O)-) is bonded to the "C₁₋₁₈ hydrocarbyl group".

The "C₁₋₁₈ hydrocarbylsulfinyl group" is, for example, but not limited to, a "C₁₋₁₈ alkylsulfinyl group", such as a methylsulfinyl group, an ethylsulfinyl group, a n-propylsulfinyl group, an i-propylsulfinyl group, a n-butylsulfinyl group, a t-butylsulfinyl group, a pentylsulfinyl group, or a hexylsulfinyl group; a "C₃₋₁₈ alicyclic sulfinyl group", such as a cyclopropylsulfinyl group, a cyclobutylsulfinyl group, a cyclopentylsulfinyl group, a cyclohexylsulfinyl group, a 2-methylcyclopentylsulfinyl group, a 3-methylcyclopentylsulfinyl group, a 2-methylcyclohexylsulfinyl group, a 3-methylcyclohexylsulfinyl group, or a 4-methylcyclohexylsulfinyl group; a "C₆₋₁₈ arylsulfinyl group", such as a phenylsulfinyl group, a naphthylsulfinyl group, an acenaphthylsulfinyl group, a phenanthrenylsulfinyl group, or an anthracenylsulfinyl group; or the like.

The term "C₁₋₁₈ hydrocarbylsulfonyl group", as used herein, refers to a group in which a sulfonyl group (-SO₂-) is bonded to the "C₁₋₁₈ hydrocarbyl group".

The "C₁₋₁₈ hydrocarbylsulfonyl group" is, for example, but not limited to, a "C₁₋₁₈ alkylsulfonyl group", such as a methylsulfonyl group, an ethylsulfonyl group, a n-propylsulfonyl group, an i-propylsulfonyl group, a n-butylsulfonyl group, a t-butylsulfonyl group, or a pentylsulfonyl group; a "C₃₋₁₈ alicyclicsulfonyl group", such as a cyclopropylsulfonyl group, a cyclobutylsulfonyl group, a cyclopentylsulfonyl group, a cyclohexylsulfonyl group, a 2-methylcyclopentylsulfonyl group, a 3-methylcyclopentylsulfonyl group, a 2-methylcyclohexylsulfonyl group, a 3-methylcyclohexylsulfonyl group, or a 4-methylcyclohexylsulfonyl group; a "C₆₋₁₈ arylsulfonyl group", such as a phenylsulfonyl group, a naphthylsulfonyl group, an acenaphthylsulfonyl group, a phenanthrenylsulfonyl group, or an anthracenylsulfonyl group; or the like.

In the present specification, the term "acid-dissociable group" refers to a group that substitutes for a hydrogen atom of a polar group, such as a hydroxy group (including a phenolic hydroxy group or the like), a carboxy group, an amino group, a sulfo group, or the like, and that is dissociated by the action of an acid.

In a compound having the above acid-dissociable group, the acid-dissociable group can be dissociated by the action of an acid to generate the polar group, thus increasing polarity of the compound. This enables solubility of the compound in a developer to be changed. More specifically, when a highly polar developer such as an alkaline aqueous solution is used as the developer, solubility of the compound in the developer relatively increases, whereas, when a low-polarity organic developer is used as the developer, solubility of the compound in the developer relatively decreases.

The polar group is preferably a hydroxy group (including a phenolic hydroxy group or the like) or a carboxy group.

The acid-dissociable group is not particularly limited, and a known and commonly used acid-dissociable group usable for a chemically amplified resist can be used. Examples of the acid-dissociable group include an acid-dissociable group G for polar groups having an acid-dissociable group and represented by the following general formula (G-1) to (G-4).

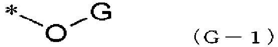

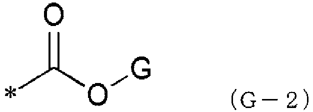

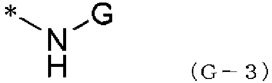

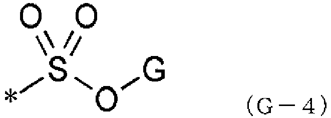

The acid-dissociable group G is not particularly limited, provided that it can be dissociated by the action of an acid, and may be a known and commonly used group. The acid-dissociable group G is, for example, a "tertiary-carbon-type acid-dissociable group G_{A}" represented by the following general formula (g-1), an "allyl- or benzyl-type acid-dissociable group G_{B}" represented by the following general formula (g-2), an "acetal-type acid-dissociable group Gc" represented by the following general formula (g-3), an "aminocarbonyl-type acid-dissociable group G_{D}" represented by the following general formula (g-4), or the like. Each of them will be sequentially described below.

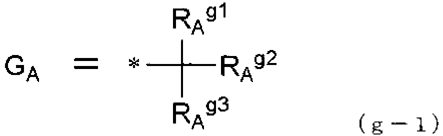

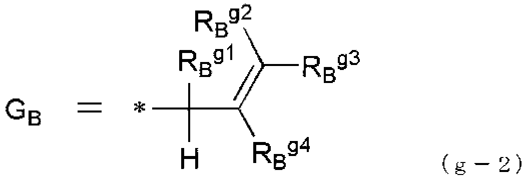

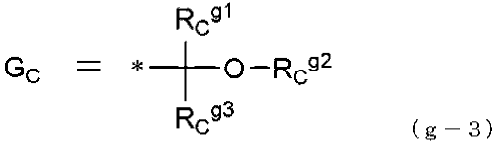

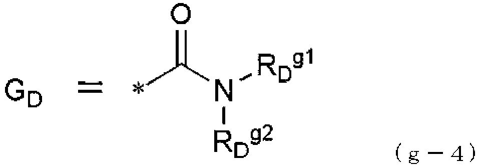

### <Tertiary-carbon-type Acid-Dissociable Group G_{A}>

As the acid-dissociable group G, an acid-dissociable group in which a carbon that is directly bonded to a polar group and to which R_{A}^{g1} to R_{A}^{g3} are bonded is a tertiary carbon atom, such as a "tertiary-carbon-type acid-dissociable group G_{A}" represented by the following general formula (g-1), can be used.

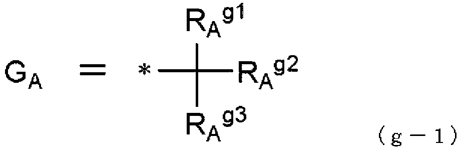

"R_{A}^{g1}" denotes an optionally substituted C₁₋₁₂ hydrocarbyl group in which any divalent carbon atom at any non-terminal position may be substituted with -O-, -C(=O)-, -C(=O)O-, -OCO-, -CONH-, - NHCO-, -S-, or -SO₂- (provided that adjacent divalent carbon atoms are not replaced at the same time).

R_{A}^{g1} preferably denotes a C₁₋₁₂ alkyl group, a C₃₋₁₂ alicyclic group, a C₆₋₁₂ aryl group, or a C₇₋₁₂ aralkyl group each optionally having a substituent and any divalent carbon atom at any non-terminal position may be substituted with -O-, -C(=O)-, -C(=O)O-, -OCO-, -CONH-, -NHCO-, -S-, or - SO₂- (provided that adjacent divalent carbon atoms are not replaced at the same time),
and more preferably a C₁₋₁₂ alkyl group or a C₃₋₁₂ alicyclic group each optionally having a substituent and any divalent carbon atom any non-terminal position may be substituted with -O-, -C(=O)-, -C(=O)O-, -OCO-, -CONH-, -NHCO-, -S-, or -SO₂- (provided that adjacent divalent carbon atoms are not replaced at the same time).

"R_{A}^{g2}" and "R_{A}^{g3}" each independently denote an optionally substituted C₁₋₁₂ hydrocarbyl group, and a divalent carbon atom at any non-terminal position may be substituted with -O-, -C(=O)-, - C(=O)O-, -OCO-, -CONH-, -NHCO-, -S-, or -SO₂- (provided that adjacent divalent carbon atoms are not substituted at the same time), or R_{A}^{g2} and R_{A}^{g3} may be combined to form a C₃₋₁₈ alicyclic group or a 3-to 18-membered non-aromatic heterocyclic group, each optionally having a substituent, and a divalent carbon atom at any position except the terminal positions may be substituted with -O-, -C(=O)-, - C(=O)O-, -OCO-, -CONH-, -NHCO-, -S-, or -SO₂- (provided that adjacent divalent carbon atoms are not substituted at the same time).

In R_{A}^{g2} and R_{A}^{g3}, preferably, R_{A}^{g2} and R_{A}^{g3} may be combined to form a C₃₋₁₈ alicyclic group or a 3- to 18-membered non-aromatic heterocyclic group, each optionally having a substituent, and a divalent carbon atom at any non-terminal position may be substituted with -O-, -C(=O)-, -C(=O)O-, - OCO-, -CONH-, -NHCO-, -S-, or -SO₂- (provided that adjacent divalent carbon atoms are not substituted at the same time).

More preferably, the substituted C₃₋₁₈ alicyclic group or the 3- to 18-membered non-aromatic heterocyclic group, each optionally having a substituent, has a cyclopentane skeleton, a cyclohexane skeleton, a cycloheptane skeleton, a cyclooctane skeleton, a cyclononane skeleton, a cyclodecane skeleton, a cyclododecane skeleton, a cyclopentene skeleton, a cyclohexene skeleton, a cycloheptene skeleton, a cyclooctene skeleton, a cyclodecene skeleton, a norbornane skeleton, an adamantane skeleton, a tricyclodecane skeleton, a tetracyclododecane skeleton, a norbornene skeleton, or a tricyclodecene skeleton, and a divalent carbon atom at any position except the terminal positions may be substituted with -O-, -C(=O)-, -C(=O)O-, -OCO-, -CONH-, -NHCO-, -S-, or -SO₂- (provided that adjacent divalent carbon atoms are not substituted at the same time).

A tertiary-carbon-type acid-dissociable group G_{A} represented by the general formula (g-1) is, for example, but not limited to, a t-butyl group, a t-amyl group, a 1,1-dimethylpropyl group, a 1-methyl-1-cyclopentyl group, a 1-ethyl-1-cyclopentyl group, a 1-methyl-1-cyclohexyl group, a 1-ethyl-1-cyclohexyl group, a 2-methyl-2-adamantyl group, a 2-ethyl-2-adamantyl group, a 1-(1-methoxy-2-methylpropan-2-yl)cyclopentyl group, a 1-(1-ethoxy-2-methylpropan-2-yl)cyclopentyl group, or the like.

### <<Tertiary-Carbon-Type Acid-Dissociable Group G_{A1} and G_{A2}>>

In the "tertiary-carbon-type acid-dissociable group G_{A}" represented by the general formula (g-1), the case where R_{A}^{g2} and R_{A}^{g3} may be combined to form a C₃₋₁₈ alicyclic group or a 3- to 18-membered non-aromatic heterocyclic group, each optionally having a substituent, is, for example, a tertiary-carbon-type acid-dissociable group G_{A1} represented by the following general formula (g-1-1), a tertiary-carbon-type acid-dissociable group G_{A2}>> represented by the following general formula (g-1-2), or the like.

### <<Tertiary-Carbon-Type Acid-Dissociable Group G_{A1} Represented by General Formula (g-1-1)>>

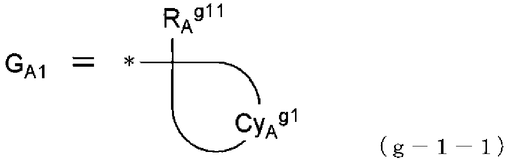

In the tertiary-carbon-type acid-dissociable group G_{A1} represented by the general formula (g-1-1), R_{A}^{g11} denotes a C₁₋₁₂ alkyl group, a C₃₋₁₂ alicyclic group, a C₆₋₁₂ aryl group, or a C₇₋₁₂ aralkyl group, each optionally having a substituent, and any divalent carbon atom at any non-terminal position may be substituted with -O-, -C(=O)-, -C(=O)O-, -OCO-, -CONH-, -NHCO-, -S-, or -SO₂- (provided that adjacent divalent carbon atoms are not substituted at the same time).

Cy_{A}^{g1}, together with the tertiary carbon atom, forms a C₃₋₁₈ alicyclic group or a 3- to 18-membered non-aromatic heterocyclic group, each optionally having a substituent, and any divalent carbon atom may be substituted with -O-, -C(=O)-, -C(=O)O-, -OCO-, -CONH-, -NHCO-, -S-, or -SO₂-(provided that adjacent divalent carbon atoms are not substituted at the same time).

Preferably, Cy_{A}^{g1}, together with the tertiary carbon atom, forms a cyclopentane skeleton, a cyclohexane skeleton, a cycloheptane skeleton, a cyclooctane skeleton, a cyclononane skeleton, a cyclodecane skeleton, a cyclododecane skeleton, a cyclopentene skeleton, a cyclohexene skeleton, a cycloheptene skeleton, a cyclooctene skeleton, a cyclodecene skeleton, a norbornane skeleton, an adamantane skeleton, a tricyclodecane skeleton, a tetracyclododecane skeleton, a norbornene skeleton, or a tricyclodecene skeleton, each optionally having a substituent, and a divalent carbon atom at any position except the terminal positions may be substituted with -O-, -C(=O)-, -C(=O)O-, -OCO-, - CONH-, -NHCO-, -S-, or -SO₂- (provided that adjacent divalent carbon atoms are not substituted at the same time).

The tertiary-carbon-type acid-dissociable groups G_{A1} represented by the general formula (g-1-1) is, for example, the following tertiary-carbon-type acid-dissociable group.

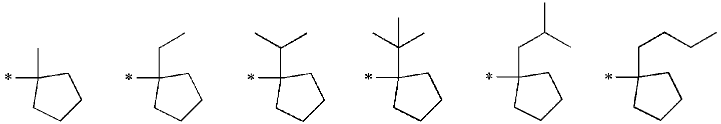

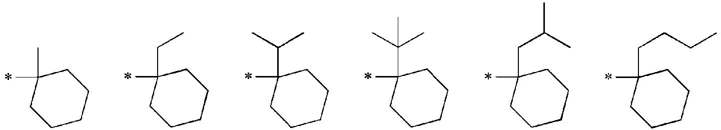

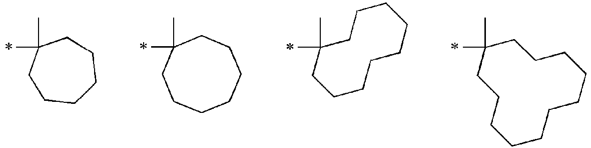

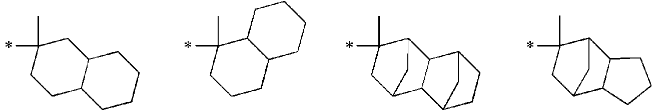

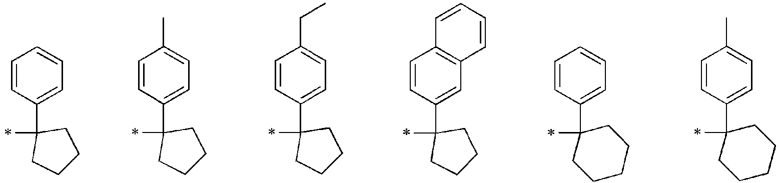

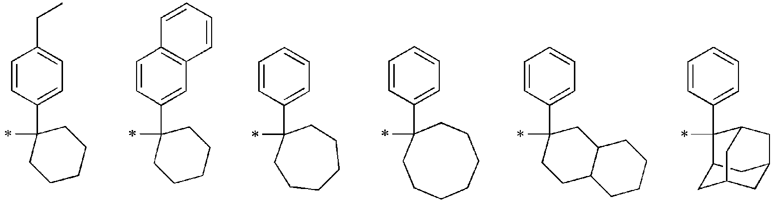

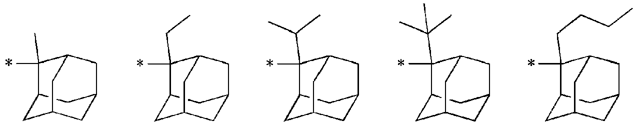

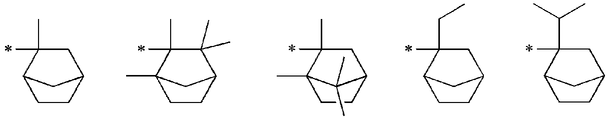

### <<Tertiary-Carbon-Type Acid-Dissociable Group G_{A2}>> Represented by General Formula (g-1-2)>>

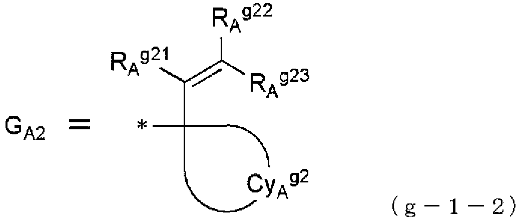

In the general formula (g-1-2), R_{A}^{g21} to R_{A}^{g23} each independently denote a hydro group or an optionally substituted C₁₋₁₂ hydrocarbyl group, any divalent carbon atom except the terminal positions may be substituted with -O-, -C(=O)-, -C(=O)O-, -OCO-, -CONH-, -NHCO-, -S-, or -SO₂- (provided that adjacent divalent carbon atoms are not substituted at the same time), and R_{A}^{g21} and R_{A}^{g22}, and/or R_{A}^{g22} and R_{A}^{g23} may be directly bonded to each other by a single bond or may be bonded to each other via a divalent linker such as, -O-, -S-, -C(=O)-, -S(=O)-, -S(=O)₂-, -C(=O)O-, or a C₁₋₃ alkylene group, to form a ring.

The case where R_{A}^{g21} and R_{A}^{g22}, and/or R_{A}^{g22} and R_{A}^{g23} form a ring together with a carbon atom contained in the ethylenically unsaturated double bond is, for example, a case where they form a cyclopentenyl group, a cyclohexenyl group, a cyclopentylidene ethenyl group, a cyclohexylidene ethenyl group, or the like, each optionally having a substituent.

Cy_{A}^{g2}, together with the tertiary carbon atom, forms a C₃₋₁₈ alicyclic group or a 3- to 18-membered non-aromatic heterocyclic group, each optionally having a substituent, and any divalent carbon atom may be substituted with -O-, -C(=O)-, -C(=O)O-, -OCO-, -CONH-, -NHCO-, -S-, or -SO₂-(provided that adjacent divalent carbon atoms are not substituted at the same time).

Preferably, Cy_{A}^{g2}, together with the tertiary carbon atom, forms a cyclopentane skeleton, a cyclohexane skeleton, a cycloheptane skeleton, a cyclooctane skeleton, a cyclononane skeleton, a cyclodecane skeleton, a cyclododecane skeleton, a cyclopentene skeleton, a cyclohexene skeleton, a cycloheptene skeleton, a cyclooctene skeleton, a cyclodecene skeleton, a norbornane skeleton, an adamantane skeleton, a tricyclodecane skeleton, a tetracyclododecane skeleton, a norbornene skeleton, or a tricyclodecene skeleton, each optionally having a substituent, and a divalent carbon atom at any position except the terminal positions may be substituted with -O-, -C(=O)-, -C(=O)O-, -OCO-, - CONH-, -NHCO-, -S-, or -SO₂- (provided that adjacent divalent carbon atoms are not substituted at the same time).

The tertiary-carbon-type acid-dissociable groups G_{A2}>> represented by the general formula (g-1-2) is, for example, the following tertiary-carbon-type acid-dissociable group.

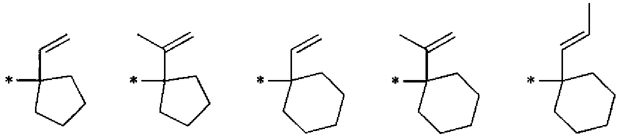

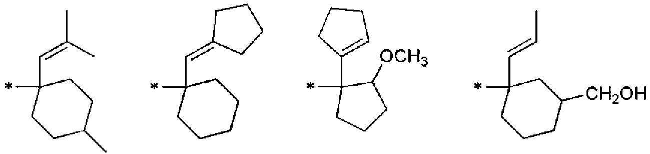

### <Allyl-Type or Benzyl-Type Acid-Dissociable Group G_{B}>

As the acid-dissociable group G, an acid-dissociable group in which a carbon that is directly bonded to a polar group corresponds to the allylic position or the benzylic position, such as an "allyl-type or benzyl-type acid-dissociable group G_{B}" represented by the following general formula (g-2), can be used.

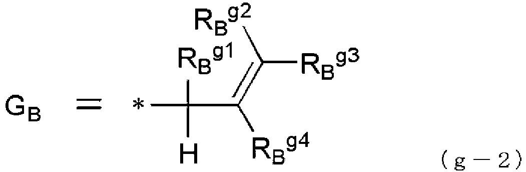

"R_{B}^{g1}" denotes an optionally substituted C₁₋₁₂ hydrocarbyl group in which any divalent carbon atom except the terminal positions may be substituted with -O-, -C(=O)-, -C(=O)O-, -OCO-, - CONH-, -NHCO-, -S-, or -SO₂- (provided that adjacent divalent carbon atoms are not replaced at the same time).

R_{B}^{g1} preferably denotes a C₁₋₁₂ alkyl group, a C₃₋₁₂ alicyclic group, a C₆₋₁₂ aryl group, or a C₇₋₁₂ aralkyl group each optionally having a substituent and any divalent carbon atom except the terminal positions may be substituted with -O-, -C(=O)-, -C(=O)O-, -OCO-, -CONH-, -NHCO-, -S-, or -SO₂- (provided that adjacent divalent carbon atoms are not replaced at the same time),
more preferably a C₁₋₁₂ alkyl group or a C₃₋₁₂ alicyclic group each optionally having a substituent and any divalent carbon atom except the terminal positions may be substituted with -O-, -C(=O)-, -C(=O)O-, -OCO-, -CONH-, -NHCO-, -S-, or -SO₂- (provided that adjacent divalent carbon atoms are not replaced at the same time).

"R_{B}^{g2}" to "R_{B}^{g4}" each independently denote a hydro group, or an optionally substituted C₁₋₁₂ hydrocarbyl group in which any divalent carbon atom except the terminal positions may be substituted with -O-, -C(=O)-, -C(=O)O-, -OCO-, -CONH-, -NHCO-, -S-, or -SO₂- (provided that adjacent divalent carbon atoms are not replaced at the same time).

R_{B}^{g1} and R_{B}^{g2}, R_{B}^{g2} and R_{B}^{g3}, and/or R_{B}^{g3} and R_{B}^{g4} may be linked to each other directly by a single bond or via divalent linking -O-, -S-, -C(=O)-, -S(=O)-, -S(=O)₂-, -C(=O)O-, or a C₁₋₃ alkylene group to form a ring.

In the allyl-type or benzyl-type acid-dissociable group G_{B} represented by general formula (g-2), the case where R_{B}^{g1} and R_{B}^{g2}, R_{B}^{g2} and R_{B}^{g3}, and/or R_{B}^{g3} and R_{B}^{g4} form a ring together with a carbon atom contained in an ethylenically unsaturated double bond is, for example, a case where they form a cyclopentenyl group, a cyclohexenyl group, a cyclopentylidene ethenyl group, a cyclohexylidene ethenyl group, a benzyl group, a 2,3-dihydro-1H-indanyl group, or the like, each optionally having a substituent.

Examples of the allyl-type or benzyl-type acid-dissociable group G_{B} represented by general formula (g-2) include the following allyl-type or benzyl-type acid-dissociable groups.

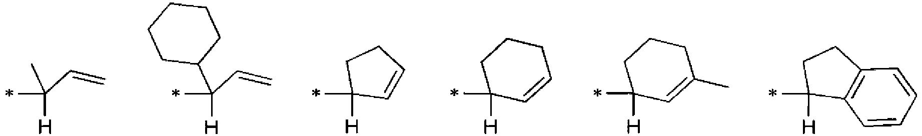

### <Acetal-type Acid-Dissociable Group Gc>

The acid-dissociable group G can be an acid-dissociable group in which an oxygen atom is bonded to a carbon atom directly bonded to a polar group, such as an "acetal-type acid-dissociable group G_{C}" represented by the following general formula (g-3).

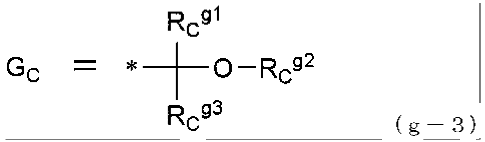

"R_{C}^{g1}" and "R_{C}^{g3}" each independently denote a hydro group, or an optionally substituted C₁₋₁₂ hydrocarbyl group in which any divalent carbon atom except the terminal positions may be substituted with -O-, -C(=O)-, -C(=O)O-, -OCO-, -CONH-, -NHCO-, -S-, or -SO₂- (provided that adjacent divalent carbon atoms are not replaced at the same time).

Preferably, R_{C}^{g1} and R_{C}^{g3} denote a hydro group, or a C₁₋₁₂ alkyl group or a C₃₋₁₂ alicyclic group, the alkyl group and the alicyclic group each optionally having a substituent, and any divalent carbon atom except the terminal positions may be substituted with -O-, -C(=O)-, -C(=O)O-, -OCO-, - CONH-, -NHCO-, -S-, or -SO₂- (provided that adjacent divalent carbon atoms are not substituted at the same time),
more preferably a hydro group, or a C₁₋₆ alkyl group or a C₃₋₈ alicyclic group, the alkyl group and the alicyclic group each optionally having a substituent, and any divalent carbon atom except the terminal positions may be substituted with -O-, -C(=O)-, -C(=O)O-, -OCO-, -CONH-, -NHCO-, - S-, or -SO₂- (provided that adjacent divalent carbon atoms are not substituted at the same time).

"R_{C}^{g2}" denotes an optionally substituted C₁₋₁₂ hydrocarbyl group in which any divalent carbon atom except the terminal positions may be substituted with -O-, -C(=O)-, -C(=O)O-, -OCO-, - CONH-, -NHCO-, -S-, or -SO₂- (provided that adjacent divalent carbon atoms are not replaced at the same time).

Preferably, R_{C}^{g2} denotes a C₁₋₁₂ alkyl group or a C₃₋₁₂ alicyclic group, the alkyl group and the alicyclic group each optionally having a substituent, and any divalent carbon atom except the terminal positions may be substituted with -O-, -C(=O)-, -C(=O)O-, -OCO-, -CONH-, -NHCO-, -S-, or -SO₂- (provided that adjacent divalent carbon atoms are not substituted at the same time), more preferably a C₁₋₆ alkyl group or a C₃₋₈ alicyclic group, the alkyl group and the alicyclic group each optionally having a substituent, and any divalent carbon atom except the terminal positions may be substituted with -O-, -C(=O)-, -C(=O)O-, -OCO-, -CONH-, -NHCO-, -S-, or -SO₂- (provided that adjacent divalent carbon atoms are not substituted at the same time).

The acetal-type acid-dissociable group Gc represented by the general formula (g-3) is, for example, a methoxymethoxy group, an ethoxymethoxy group, a n-propoxymethoxy group, a n-butoxymethoxy group, a 2,2-dimethylpropoxymethoxy group, a 2,2-dimethylbutoxymethoxy group, a cyclohexyloxymethoxy group, a 1-ethoxyethoxy group, a 1-n-butoxyethoxy group, a 1-cyclohexyloxyethoxy group, or the like.

### <Aminocarbonyl-Type Acid-Dissociable Group G_{D}>

The acid-dissociable group G can be an acid-dissociable group in which an aminocarbonyl group is bonded to a polar group, such as an "aminocarbonyl-type acid-dissociable group G_{D}" represented by the following general formula (g-4).

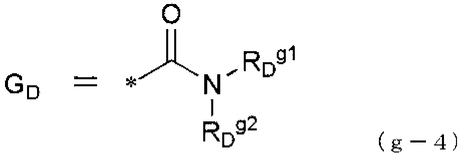

"R_{D}^{g1}" and "R_{D}^{g2}" each independently denote a hydro group, or an optionally substituted C₁₋₁₂ hydrocarbyl group in which any divalent carbon atom except the terminal positions may be substituted with -O-, -C(=O)-, -C(=O)O-, -OCO-, -CONH-, -NHCO-, -S-, or -SO₂- (provided that adjacent divalent carbon atoms are not replaced at the same time).

Preferably, R_{D}^{g1} and R_{D}^{g2} denote a hydro group, or a C₁₋₁₂ alkyl group or a C₃₋₁₂ alicyclic group, the alkyl group and the alicyclic group each optionally having a substituent, and any divalent carbon atom except the terminal positions may be substituted with -O-, -C(=O)-, -C(=O)O-, -OCO-, - CONH-, -NHCO-, -S-, or -SO₂- (provided that adjacent divalent carbon atoms are not substituted at the same time),
more preferably a hydro group, or a C₁₋₆ alkyl group or a C₃₋₈ alicyclic group, the alkyl group and the alicyclic group each optionally having a substituent, and any divalent carbon atom except the terminal positions may be substituted with -O-, -C(=O)-, -C(=O)O-, -OCO-, -CONH-, -NHCO-, - S-, or -SO₂- (provided that adjacent divalent carbon atoms are not substituted at the same time).

The aminocarbonyl-type acid-dissociable group G_{D} represented by the general formula (g-4) is, for example, a dimethylaminocarbonyl group, a diethylaminocarbonyl group, a diisopropylaminocarbonyl group, an N-phenyl-N-methyl-aminocarbonyl group, or the like.

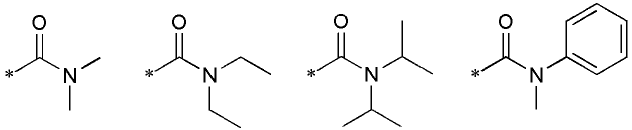

The term "a hydroxy or carboxy group having a protective group", as used herein, refers to a hydroxy or carboxy group in which the hydroxy group (including a phenolic hydroxy group) or the carboxy group is protected by an ether protective group, a silyl ether protective group, an acyl protective group, or the like.

The ether protective group is, for example, but not limited to, a methyl group, a benzyl group, a p-methoxybenzyl group, a t-butyl group, a triphenylmethyl group, a p-methoxyphenyldiphenylmethyl group, a di(p-methoxyphenyl)phenylmethyl group, or the like.

The silyl ether protective group is, for example, but not limited to, a t-butyldimethylsilyl group (TBS), a triisopropylsilyl group (TIPS), a trimethylsilyl group (TMS), a triethylsilyl group (TES), a t-butyldiphenylsilyl group (TBDPS), or the like.

The acyl protective group is, for example, but not limited to, an acetyl group, a pivaloyl group, a benzoyl group, or the like.

The phrase "optionally substituted" or "optionally having a substituent", as used herein, is not particularly limited provided that it is chemically acceptable and has the advantages of the present invention.

The "substituent" is, for example, (1) a halogen atom, (2) a haloalkyl group, (3) a hydroxy group, (4) a thiol group, (5) a nitro group, (6) a cyano group, (7) a carboxy group, (8) an amino group, (9) a sulfo group, (10) a vinyl group, (11) an allyl group, (12) a (meth)acryloyl group, (13) a (meth)acryloyloxy group, (14) a (meth)acrylamide group, (15) a styryl group, (16) an epoxy group, (17) a glycidyl group, (18) an amide group, (19) a hydroxy group or a carboxy group each having a protective group, (20) a polar group having an acid-dissociable group, or (21) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, a C₁₋₁₈ hydrocarbylamino group, a di-C₁₋₁₈ hydrocarbylamino group, a C₁₋₁₈ hydrocarbylaminocarbonyl group, a di-C₁₋₁₈ hydrocarbylaminocarbonyl group, a C₁₋₁₈ hydrocarbylcarbonylamino group, a C₁₋₁₈ hydrocarbylaminocarbonyloxy group, a di-C₁₋₁₈ hydrocarbylaminocarbonyloxy group, a C₁₋₁₈ hydrocarbylaminocarbonylamino group, a di-C₁₋₁₈ hydrocarbylaminocarbonylamino group, a C₁₋₁₈ hydrocarbyloxycarbonylamino group, a C₁₋₁₈ hydrocarbylthio group, a C₁₋₁₈ hydrocarbylsulfinyl group, or a C₁₋₁₈ hydrocarbylsulfonyl group, in which at least part of hydrogen atoms may be substituted with (1) to (20), and a divalent carbon atom at any position of these substituents except the terminal positions may be substituted with -O-, -C(=O)-, -C(=O)O-, -OCO-, -CONH-, -NHCO-, -NH(C=O)O-, -S-, or - SO₂- (provided that adjacent divalent carbon atoms are not substituted at the same time), or the like.

### [1. Resist Material]

A resist material according to the present embodiment contains (A) a heteropolyacid salt having a modified lacunary site or a mixture thereof.

The resist material according to the present embodiment may also contain (B) an acid diffusion control agent, an organic solvent, or the like as optional components.

### [1-1. (A) Heteropolyacid Salt Having Modified Lacunary Site or Mixture Thereof]

(A) The heteropolyacid salt having a modified lacunary site or the mixture thereof has an anion moiety composed of a heteropolyacid anion having a lacunary site in which the lacunary site is modified. The heteropolyacid salt having a modified lacunary site or the mixture thereof has a cation moiety composed of H⁺, a metal ion, an onium cation, or an onium dication.

### [1-1-1. Anion Moiety of Heteropolyacid Salt Having Modified Lacunary Site or Mixture Thereof]

The heteropolyacid anion having a lacunary site in which the lacunary site is modified can be a heteropolyacid anion having a modified lacunary site produced by reacting a terminal oxygen atom of the lacunary site in the heteropolyacid anion having the lacunary site with a P, Si, Ge, or Sn compound having one or more organic groups and two or more leaving groups.

### [1-1-1-1. Heteropolyacid Anion Having Lacunary Site]

The heteropolyacid anion having the lacunary site according to the present embodiment is not particularly limited and may be a lacunary species having a defect in part of the basic skeleton of the heteropolyacid anion, and any of a mono-lacunary species, a di-lacunary species, a tri-lacunary species, or the like may be used. The heteropolyacid anion having the lacunary site is, for example, a lacunary Keggin-type heteropolyacid anion, a lacunary Dawson-type heteropolyacid anion, or the like.

### [1-1-1-1-1. Lacunary Keggin-Type Heteropolyacid Anion]

The lacunary Keggin-type heteropolyacid anion is, for example, a mono-lacunary Keggin-type heteropolyacid anion represented by the following general formula (II-1), a di-lacunary Keggin-type heteropolyacid anion represented by the following general formula (II-2), a tri-lacunary Keggin-type heteropolyacid anion represented by the following general formula (II-3), or the like.

[XM₁₁O₃₉]^{c11-} (II-1)

[XM₁₀O₃₆]^{c12-} (II-2)

[XM₉O₃₄]^{c13-} (II-3)

(wherein
X denotes a heteroatom of P, Si, B, S, or Ge,
M denotes a polyatom of Mo, W, V, Nb, or Ta, and
c11- to c13- denote the number of negative charges, and c11 to c13 denote natural numbers.)

In the general formulae (II-1) to (II-3), the values of c11 to c13 vary with the types of X and M.

For example, in the general formula (II-1), when X denotes P and M denotes Mo or W, c11 is 7 ([PMo₁₁O₃₉]⁷⁻, [PW₁₁O₃₉]⁷⁻), when X denotes Si and M denotes Mo or W, c11 is 8 ([SiMo₁₁O₃₉]⁸⁻, [SiW₁₁O₃₉]⁸⁻), when X denotes S and M denotes Mo or W, c11 is 6 ([SMo₁₁O₃₉]⁶⁻, [SW₁₁O₃₉]⁶⁻), when X denotes B and M denotes Mo or W, c11 is 9 ([BMo₁₁O₃₉]⁹⁻, [BW₁₁O₃₉]⁹⁻), and when X denotes Ge and M denotes Mo or W, c11 is 8 ([GeMo₁₁O₃₉]⁸⁻, [GeW₁₁O₃₉]⁻⁸).

In the general formula (II-2), when X denotes P and M denotes Mo or W, c12 is 7 ([PMo₁₀O₃₆]⁷⁻, [PW₁₀O₃₆]⁷⁻), when X denotes Si and M denotes Mo or W, c12 is 8 ([SiMo₁₀O₃₆]⁸⁻, [SiW₁₀O₃₆]⁸⁻), when X denotes B and M denotes Mo or W, c12 is 9 ([BMo₁₀O₃₆]⁹⁻, [BW₁₀O₃₆]⁹⁻), and when X denotes Ge and M denotes Mo or W, c12 is 8 ([GeMo₁₀O₃₆]⁸⁻, [GeW₁₀O₃₆]⁸⁻).

In the general formula (II-3), for example, when X denotes P and M denotes Mo or W, c13 is 9 ([PMo₉O₃₄]⁹⁻, [PW₉O₃₄]⁹⁻), when X denotes Si and M denotes Mo or W, c13 is 10 ([SiMo₉O₃₄]¹⁰⁻, [SiW₉O₃₄]¹⁰⁻), when X denotes S and M denotes Mo or W, c13 is 8 ([SMo₉O₃₄]⁸⁻, [SW₉O₃₄]⁸⁻), and when X denotes Ge and M denotes Mo or W, c13 is 10 ([GeMo₉O₃₄]¹⁰⁻, [GeW₉O₃₄]¹⁰⁻).

The isomer structure of the lacunary Keggin-type heteropolyacid anion is preferably an α-form, a β-form, or a γ-form.

The isomer structure of the mono-lacunary Keggin-type heteropolyacid anion represented by the general formula (II-1) is preferably [α-PW₁₁O₃₉]⁷⁻, [β-PW₁₁O₃₉]⁷⁻, [γ-PW₁₁O₃₉]⁷⁻, [α-PMo₁₁O₃₉]⁷⁻, [β-PMo₁₁O₃₉]⁷⁻, [γ-PW₁₁O₃₉]⁷⁻, [α-SiW₁₁O₃₉]⁸⁻, [β-SiW₁₁O₃₉]⁸⁻, [γ-SiW₁₁O₃₉]⁸⁻, [α-SiMo₁₁O₃₉]⁸⁻, [β-SiMo₁₁O₃₉]⁸⁻, or [γ-SiW₁₁O₃₉]⁸⁻, more preferably [α-PW₁₁O₃₉]⁷⁻, [α-PMo₁₁O₃₉]⁷⁻, [α-SiW₁₁O₃₉]⁸⁻, or [α-SiMo₁₁O₃₉]⁸⁻.

The isomer structure of the di-lacunary Keggin-type heteropolyacid anion represented by the general formula (II-1) is preferably [α-PW₁₀O₃₆]⁷⁻, [β-PW₁₀O₃₆]⁷⁻, [γ-PW₁₀O₃₆]⁷⁻, [α-PMo₁₀O₃₆]⁷⁻, [β-PMo₁₀O₃₆]⁷⁻, [γ-PW₁₀O₃₆]⁷⁻, [α-SiW₁₀O₃₆]⁸⁻, [β-SiW₁₀O₃₆]⁸⁻, [γ-SiW₁₀O₃₆]⁸⁻, [α-SiMo₁₀O₃₆]⁸⁻, [β-SiMo₁₀O₃₆]⁸⁻, or [γ-SiW₁₀O₃₆]⁸⁻, more preferably [γ-PW₁₀O₃₆]⁷⁻, [γ-PMo₁₀O₃₆]⁷⁻, [γ-SiW₁₀O₃₆]⁸⁻, or [γ-SiMO₁₀O₃₆]⁸⁻.

The isomer structure of the tri-lacunary Keggin-type heteropolyacid anion represented by the general formula (III-I1 is preferably [α-PW₉O₃₄]⁹⁻, [β-PW₉O₃₄]⁹⁻, [γ-PW₉O₃₄]⁹⁻, [α-PMo₉O₃₄]⁹⁻, [β-PMo₉O₃₄]⁹⁻, [γ-PW₉O₃₄]⁹⁻, [α-SiW₉O₃₄]¹⁰⁻, [β-SiW₉O₃₄]¹⁰⁻, [γ-SiW₉O₃₄]¹⁰⁻, [α-SiMo₉O₃₄]¹⁰⁻, [β-SiMo₉O₃₄]¹⁰⁻, or [γ-SiW₉O₃₄]¹⁰⁻.

### [1-1-1-1-2. Lacunary Dawson-Type Heteropolyacid Anion]

The lacunary Dawson-type heteropolyacid anion is, for example, a mono-lacunary Dawson-type heteropolyacid anion represented by the following general formula (III-1), a di-lacunary Dawson-type heteropolyacid anion represented by the following general formula (III-2), a tri-lacunary Dawson-type heteropolyacid anion represented by the following general formula (111-3), or the like.

[X₂M₁₇O₆₁]^{c21-} (III-I1)

[X₂M₁₆O₅₈]^{c22-} (III-2)

[X₂M₁₅O₅₆]^{c23-} (III-3)

(wherein
X denotes a heteroatom of P, Si, B, S, or Ge,
M denotes a polyatom of Mo, W, V, Nb, or Ta, and
c21- to c23- denote the number of negative charges, and c21 to c23 denote natural numbers.)

In the general formulae (III-I1 to (III-3), the values of c21 to c23 vary with the types of X and M.

For example, in the general formula (III-1), when X denotes P and M denotes Mo or W, c21 is 10 ([P₂Mo₁₇O₆₁]¹⁰⁻, [P₂W₁₇O₆₁]¹⁰⁻), and when X denotes S and M denotes W, c21 is 8 ([S₂W₁₇O₆₁]⁸⁻).

In the general formula (III-2), when X denotes Ge and M denotes Mo, c22 is 12 ([Ge₂Mo₁₆O₅₈]¹²⁻).

In the general formula (III-3), when X denotes P and M denotes Mo or W, c23 is 12 ([P₂Mo₁₅O₅₆]¹²⁻, [P₂W₁₅O₅₆]¹²⁻).

The isomer structure of the lacunary Dawson-type heteropolyacid anion is preferably an α-form, a β-form, or a γ-form.

The isomer structure of the lacunary Dawson-type heteropolyacid anion represented by the general formula (III-I), (III-2), or (III-3) is preferably [α-P₂W₁₇O₆₁]¹⁰⁻, [α-P₂W₁₅O₅₆]¹²⁻, [α-S₂W₁₇O₆₁]⁸⁻, or the like.

### [1-1-1-2. Modification of Lacunary Site]

The lacunary site of the heteropolyacid anion having the lacunary site according to the present embodiment is modified by reacting a terminal oxygen atom of the lacunary site with a P, Si, Ge, or Sn compound having one or more organic groups and two or more leaving groups. In this reaction, the terminal oxygen atom of the lacunary site of the heteropolyacid anion is bonded to a group having a heteroatom of P, Si, Ge, or Sn bonded to one or more organic groups via a part or all of the heteroatom, whereby the lacunary site is modified.

### [1-1-1-2-1. Binding Form of Lacunary Site and Notation Thereof]

In the heteropolyacid anion having the modified lacunary site according to the present embodiment, a terminal oxygen atom of the lacunary site in the heteropolyacid anion having the lacunary site is modified by a group having a heteroatom of P, Si, Ge, or Sn bonded to one or more organic groups.

The binding form between the terminal oxygen atom of the lacunary site of the heteropolyacid anion and the group having a heteroatom of P, Si, Ge, or Sn bonded to one or more organic groups is not particularly limited and may be represented by, for example, the following general formulae (IV-1) to (IV-5). 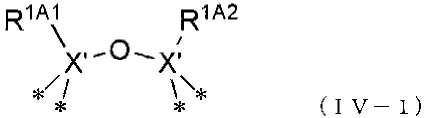 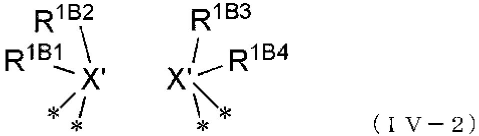 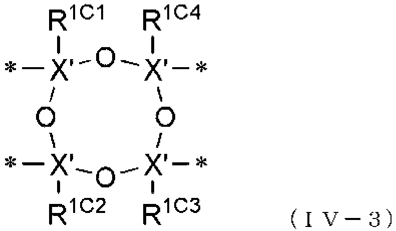 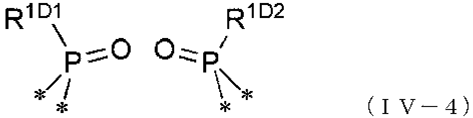 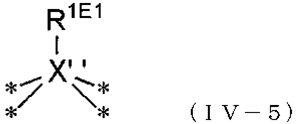 [In the formula (IV-1)~(IV-5)
X' denotes Si or Ge;
X" denotes a heteroatom of Si, Ge, or Sn;
R^{1A1} to R^{1E1} each independently denote an optionally substituted C₁₋₁₈ hydrocarbyl group, an optionally substituted 3- to 18-membered non-aromatic heterocyclic group, or an optionally substituted 5- to 18-membered aromatic heterocyclic group,
a divalent carbon atom at any position of R^{1A1} to R^{1E1} excluding the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time),
a hydrogen atom in R^{1A1} to R^{1E1} may be substituted with, for example, (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group; and
* denotes a terminal oxygen atoms of the lacunary site.]

In the present description, for convenience, a heteropolyacid anion having a lacunary site modified with a group having a heteroatom of Si or Ge bonded to one or more organic groups represented by the general formula (IV-1) can be represented by the following general formula (V-1).

[X_{w}MₓO_{y}(R^{1A1}X')(R^{1A2}X')O]^{c-} (V-1)

(In the formula, w, x, y, and c all denote natural numbers, and X, M, X', R^{1A1}, and R^{1A2} are the same as above.)

When R^{1A1} and R^{1A2} are identical, they can be denoted as R^{1A} in the following general formula (V-1').

[X_{w}MₓO_{y}(R^{1A}X')₂O]^{c-} (V-1')

The heteropolyacid anion having the modified lacunary site represented by the general formula (V-1) or (V-1') is not particularly limited and may be produced by, for example, reacting a heteropolyacid anion having a lacunary site with (R^{1A})X'Y₃ (Y denotes a leaving group, for example, a halogen atom, a hydroxy group, an alkoxy group (preferably a C₁₋₄ alkoxy group, more preferably a C₁₋₂ alkoxy group), an alkylcarbonyloxy group (preferably a C₁₋₄ alkylcarbonyloxy group), a hydrocarbylsulfonyloxy group (preferably a C₁₋₆ alkylsulfonyloxy group or a C₇₋₁₀ aralkylsulfonyloxy group, for example, a methanesulfonyloxy group, a p-toluenesulfonyloxy group, or the like)).

Likewise, in the present description, for convenience, a heteropolyacid anion having a lacunary site modified with a group having a heteroatom of Si or Ge bonded to one or more organic groups represented by the general formula (IV-2) can be represented by the following general formula (V-2).

[X_{w}MₓO_{y}(R^{1B1}R^{1B2}X')(R^{1B3}R^{1B4}Si)]^{c-} (V-2)

(In the formula, w, x, y, and c all denote natural numbers, and X, M, X', R^{1B1}, R^{1B2}, R^{1B3}, and R^{1B4} are the same as above.)

When R^{1B1}R^{1B2} and R^{1B3}R^{1B4} are identical, they can be represented by the following general formula (V-2').

[X_{w}MₓO_{y}(R^{1B1}R^{1B2}X')₂]^{c-} (V-2')

The heteropolyacid anion having the modified lacunary site represented by the general formula (V-2) or (V-2') is not particularly limited and may be produced by, for example, reacting a heteropolyacid anion having a lacunary site with (R^{1B1})(R^{1B2})X'Y₂ (Y denotes a leaving group as described above).

In the present description, for convenience, a heteropolyacid anion having a lacunary site modified with a group having a heteroatom of Si or Ge bonded to one or more organic groups represented by the general formula (IV-3) can be represented by the following general formula (V-3).

[X_{w}MₓO_{y}(R^{1C1}X'O)(R^{1C2}X'O)(R^{1C3}X'O)(R^{1C4}X'O)]^{c-} (V-3)

(In the formula, w, x, y, and c all denote natural numbers, and X, M, X', R^{1C1}, R^{1C2}, R^{1C3}, and R^{1C4} are the same as above.)

When R^{1C1}, R^{1C2}, R^{1C3}, and R^{1C4} are identical, they can be denoted as R^{1C} in the following general formula (V-3').

[X_{w}MₓO_{y}(R^{1C}X'O)₄]^{c-} (V-3')

The heteropolyacid anion having the modified lacunary site represented by the general formula (V-3) or (V-3') is not particularly limited and may be produced by, for example, reacting a di-lacunary Keggin-type or Dawson-type heteropolyacid anion with R^{1C}X'Y₃ (Y denotes a leaving group as described above).

In the present description, for convenience, a heteropolyacid anion having a lacunary site modified with a group having a heteroatom of P bonded to one or more organic groups represented by the general formula (IV-4) can be represented by the following general formula (V-4).

[X_{w}MₓO_{y}(R^{1D1}P=O)(R^{1D2}P=O)]^{c-} (V-4)

(In the formula, w, x, y, and c all denote natural numbers, and X, M, X', R^{1D1}, and R^{1D2} are the same as above.)

When R^{1D1} and R^{1D2} are identical, they can be denoted as R^{1D} in the following general formula (V-4').

[X_{w}MₓO_{y}(R^{1D}P=O)₂]^{c-} (V-4')

The heteropolyacid anion having the modified lacunary site represented by the general formula (V-4) or (V-4') is not particularly limited and may be produced by, for example, reacting a heteropolyacid anion having a lacunary site with R^{1D}P(=O)Y₂ (Y denotes a leaving group as described above).

In the present description, for convenience, a heteropolyacid anion having a lacunary site modified with a group having a heteroatom of Si, Ge, or Sn bonded to one or more organic groups represented by the general formula (IV-5) can be represented by the following general formula (V-5).

[X_{w}MₓO_{y}(R^{1E1}X")]^{c-} (V-5)

(In the formula, w, x, y, and c all denote natural numbers, and X, M, X", and R^{1E1} are the same as above.)

(V-5) may be represented by the following general formula (V-5') in some cases. Note that R^{1E} is defined in the same manner as R^{1E1}.

[X_{w}MₓO_{y}(R^{1E}X")]^{c-} (V-5')

The heteropolyacid anion having the modified lacunary site represented by the general formula (V-5) or (V-5') is not particularly limited and may be produced by, for example, reacting a heteropolyacid anion having a lacunary site with R^{1E}X"Y₃ (Y denotes a leaving group as described above).

Among the heteropolyacid anions having the modified lacunary site represented by the general formulae (V-1) to (V-5) and (V-1') to (V-5'), heteropolyacid anions having a modified lacunary site represented by the following general formulae (VI-1) to (VI-12) are preferred from the perspective of being relatively stable and capable of controlling the reactivity.

[XM₁₁O₃₉(R^{1A}X')₂O]^{c31-} (VI-1)

[XM₁₁O₃₉(R^{1B1}R^{1B2}X')₂]^{c31-} (VI-2)

[XM₁₁O₃₉(R^{1D}P=O)₂]^{c31-} (VI-3)

[XM₁₁O₃₉(R^{1E}X")]^{c31-} (VI-4)

[XM₁₀O₃₆(R^{1A}X')₂O]^{c32-} (VI-5)

[XM₁₀O₃₆(R^{1B1}R^{1B2}X')₂]^{c32-} (VI-6)

[XM₁₀O₃₆(R^{1C}X'O)₄]^{c32-} (VI-7)

[XM₁₀O₃₆(R^{1D}P=O)₂]^{c32-} (VI-8)

[X₂M₁₇O₆₁(R^{1A}X')₂O]^{c33-} (VI-9)

[X₂M₁₇O₆₁(R^{1B1}R^{1B2}X')₂]^{c33-} (VI-10)

[X₂M₁₇O₆₁(R^{1D}P=O)₂]^{c33-} (VI-11)

[X₂M₁₇O₆₁(R^{1E}X")]^{c33-} (VI-12)

(wherein
X denotes a heteroatom of P, Si, B, S, or Ge,
M denotes a polyatom of Mo, W, V, Nb, or Ta, and
X' denotes a heteroatom of Si or Ge;
X" denotes a heteroatom of Si, Ge, or Sn;
R^{1A} to R^{1E} each independently denote an optionally substituted C₁₋₁₈ hydrocarbyl group, an optionally substituted 3- to 18-membered non-aromatic heterocyclic group, or an optionally substituted 5- to 18-membered aromatic heterocyclic group,
   a divalent carbon atom at any position of R^{1A} to R^{1E} excluding the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time),
a hydrogen atom in R^{1A} to R^{1E} may be substituted with, for example, (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group;
c31, c32, and c33 denote natural numbers.)

In the heteropolyacid anion having the modified lacunary site, since four terminal oxygen atoms of the lacunary site are modified, in general, the value of c31 is c11 - 4, the value of c32 is c12 - 4, and the value of c33 is c21 - 4.

On the other hand, for example, when the organic group contains an amino group and the amino group is protonated to be an ammonium cation, or when the organic group contains a carboxy group and the carboxy group is converted into a carboxy anion, the values of c31 to c33 are different from the above values.

### [1-1-1-2-2. Organic Group]

The organic groups represented by R^{1A}, R^{1B1} or R^{1B2}, R^{1C}, R^{1D}, and R^{1E} are not particularly limited and may be those known and commonly used.

From the perspective of providing a functional building block, the organic group is preferably an organic group having one or more substituents, such as a hydroxy group, a halogen atom, and an epoxy group, an organic group having one or more ethylenically unsaturated double bonds, or an organic group having one or more polar groups each having an acid-dissociable group.

<Organic Group Having One or More Substituents, such as Hydroxy Group, Halogen Atom, or Epoxy Group>

In the organic group represented by R^{1A}, R^{1B1} or R^{1B2}, R^{1C}, R^{1D}, and R^{1E}, preferably, R^{1A} to R^{1E} denote
a C₁₋₁₈ hydrocarbyl group optionally having a substituent; any divalent carbon atom excluding the terminals in R^{1A} to R^{1E} may be substituted with -O-, -C(=O)-, -C(=O)O-, -OCO-, - CONH-, -NHCO-, -NH(C=O)O-, -S-, or -SO₂- (provided that adjacent divalent carbon atoms are not substituted at the same time); and one or more hydrogen atoms in R^{1A} to R^{1E} are substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (p) an epoxy group, (q) a glycidyl group, or (r) an amide group,
more preferably, R^{1A} to R^{1E} denote a C₁₋₁₈ alkyl group, a C₃₋₁₈ alicyclic group, or a C₇₋₁₈ aralkyl group, each optionally having a substituent; any divalent carbon atom excluding the terminals in R^{1A1} to R^{1E1} may be substituted with -O-, -C(=O)-, -C(=O)O-, -OCO-, -CONH-, -NHCO-, - NH(C=O)O-, -S-, or -SO₂- (provided that adjacent divalent carbon atoms are not substituted at the same time); and one or more hydrogen atoms in R^{1A} to R^{1E} are substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (p) an epoxy group, (q) a glycidyl group, or (r) an amide group.

Specific examples of R^{1A} to R^{1E} include, but are not limited to, a 1-glycidyloxypropan-3-yl group, a 1-glycidyloxy-n-octan-8-yl group, a 1-aminopropan-3-yl group, a 1-(2-aminoethylamino)-propan-3-yl group, a 3,3,3-trifluoropropan-1-yl group, a chloromethyl group, a 1-chloropropan-3-yl group, a 1-bromopropan-3-yl group, a 1-iodopropan-3-yl group, or the like.

### <Organic Group Having One or More Ethylenically Unsaturated Double Bonds>

From the perspective of having a building block having actinic radiation reactivity, the organic groups represented by R^{1A}, R^{1B1} or R^{1B2}, R^{1C}, R^{1D}, and R^{1E} preferably contain one or more ethylenically unsaturated double bonds.

In the above case, R^{1A} to R^{1E} preferably denote
a C₁₋₁₈ hydrocarbyl group optionally having a substituent; any divalent carbon atom excluding the terminals in R^{1A} to R^{1E} may be substituted with -O-, -C(=O)-, -C(=O)O-, -OCO-, - CONH-, -NHCO-, -NH(C=O)O-, -S-, or -SO₂- (provided that adjacent divalent carbon atoms are not substituted at the same time); and one or more hydrogen atoms in R^{1A} to R^{1E} are substituted with (j) a vinyl group, (k) an allyl group, (l) a (meth)acryloyl group, (m) a (meth)acryloyloxy group, (n) a (meth)acrylamide group, or (o) a styryl group,
more preferably a C₁₋₁₈ alkyl group, a C₃₋₁₈ alicyclic group, or a C₇₋₁₈ aralkyl group, each optionally having a substituent; any divalent carbon atom excluding the terminals in R^{1A} to R^{1E} may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time); and one or more hydrogen atoms in R^{1A} to R^{1E} are substituted with (j) a vinyl group, (k) an allyl group, (l) a (meth)acryloyl group, (m) a (meth)acryloyloxy group, (n) a (meth)acrylamide group, or (o) a styryl group.

Specific examples of the organic groups R^{1A} to R^{1E} having an ethylenically unsaturated double bond include, but are not limited to, a vinyl group, an allyl group, a 5-hexen-1-yl group, a 6-hepten-1-yl group, a 7-octen-1-yl group, a 1-acryloyloxypropan-3-yl group, a 1-methacryloyloxypropan-3-yl group, a 1-vinylbenzene-4-yl group, or the like.

### <Organic Group Having One or More Polar Groups Each Having Acid-Dissociable Group>

From the perspective of providing a building block that can change the solubility in a developer by the action of an acid or the like, the organic groups represented by R^{1A}, R^{1B1} or R^{1B2}, R^{1C}, R^{1D}, and R^{1E} preferably contain one or more polar groups each having an acid-dissociable group.

The organic groups R^{1A} to R^{1E} having one or more polar groups each having an acid-dissociable group are preferably
a C₁₋₁₈ hydrocarbyl group optionally having a substituent;
a divalent carbon atom at any position of R^{1A} to R^{1E} excluding the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time);
   a hydrogen atom in R^{1A} to R^{1E} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group; and at least one hydrogen atom in R^{1A}, R^{1B1} or R^{1B2}, R^{1C}, R^{1D}, and R^{1E} is substituted with (t) a hydroxy group, a carboxy group, an amino group, or a sulfo group, each having an acid-dissociable group,
more preferably a C₁₋₁₈ alkyl group, a C₃₋₁₈ alicyclic group, a C₆₋₁₈ aryl group, or a C₇₋₁₈ aralkyl group, each optionally having a substituent;
a divalent carbon atom at any position of R^{1A} to R^{1E} excluding the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time),
   ; a hydrogen atom in R^{1A} to R^{1E} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group; and at least one hydrogen atom in R^{1A}, R^{1B1} or R^{1B2}, R^{1C}, R^{1D}, and R^{1E} is substituted with the (t) polar group having an acid-dissociable group,
still more preferably a C₁₋₁₈ alkyl group, a C₆₋₁₈ aryl group, or a C₇₋₁₈ aralkyl group, each optionally having a substituent;
a divalent carbon atom at any position of R^{1A} to R^{1E} excluding the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time);
and at least one hydrogen atom in R^{1A}, R^{1B1} or R^{1B2} R^{1C}, R^{1D}, and R^{1E} is substituted with the (t) polar group having an acid-dissociable group.

R^{1A}, R^{1B1} or R^{1B2}, R^{1C}, R^{1D}, and R^{1E} are characterized by having one or more polar groups each having an acid-dissociable group; for example, they incorporate a polar group, such as a hydroxy group, a carboxy group, an amino group, or a sulfo group, each having an acid-dissociable group. The acid-dissociable group is, for example, a tertiary-carbon-type acid-dissociable group G_{A}, an allyl- or benzyl-type acid-dissociable group G_{B}, an acetal-type acid-dissociable group Gc, an aminocarbonyl-type acid-dissociable group G_{D}, or the like.

R^{1A}, R^{1B1} or R^{1B2}, R^{1C}, R^{1D}, and R^{1E}, each having one or more polar groups each having an acid-dissociable group, are, for example, the following. 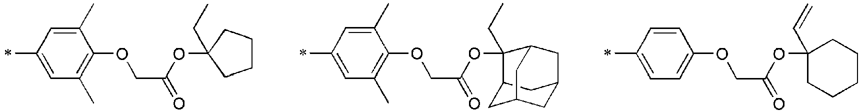 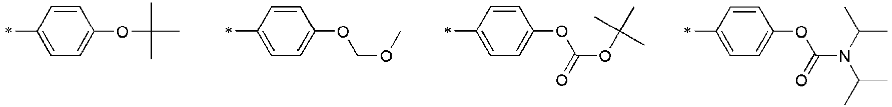 [* denotes a binding site with a heteroatom of P, Si, Ge, or Sn bonded to one or more organic groups each having a polar group having an acid-dissociable group.]

### [1-1-2. Cation Moiety of Heteropolyacid Salt Having Modified Lacunary Site or Mixture Thereof]

In the cation moiety of the heteropolyacid salt having the modified lacunary site or the mixture thereof according to the present embodiment, H⁺, a metal ion, an onium cation, or an onium dication can be used.

### [1-1-2-1. Metal Ion]

A metal ion that can be used as the cation moiety of the heteropolyacid salt having the modified lacunary site or the mixture thereof is not particularly limited but is, for example, Li⁺, Na⁺, K⁺, Rb⁺, Cs⁺, Be²⁺, Mg²⁺, Ca²⁺, Sr²⁺, Ba²⁺, Al³⁺, Co³⁺, Bi³⁺, Zr⁴⁺, Hf⁴⁺, Bi⁵⁺, or the like.

The metal ion is preferably Li⁺, Na⁺, K⁺, Rb⁺, Cs⁺, Mg²⁺, Ca²⁺, Sr²⁺, Ba²⁺, Al³⁺, or Co³⁺, more preferably Na⁺, K⁺, Rb⁺, Cs⁺, Ca²⁺, Al³⁺, or Co³⁺.

These metal ions may be used alone or in combination of two or more thereof.

### [1-1-2-2. Onium Cation or Dication]

The onium cation or dication that can be used as the cation moiety of the heteropolyacid salt having the modified lacunary site or the mixture thereof is not particularly limited and may be a known and commonly used one.

The onium cation or dication is, for example, an ammonium cation, an ammonium dication, a phosphonium cation, a phosphonium dication, a sulfonium cation, a sulfonium dication, an iodonium cation, or the like.

These onium cations or onium dications may be used alone or in combination of two or more thereof.

From the perspective of providing a building block that generates an acid upon exposure to DUV, XUV, EUV, an electron beam, or the like, the onium cation or dication is preferably a sulfonium cation, a sulfonium dication, or an iodonium cation.

### [1-1-2-2-1. Ammonium Cation]

The ammonium cation is not particularly limited and may be a known and commonly used one. The ammonium cation is not particularly limited but is, for example, an ammonium ion (NH₄⁺), a primary ammonium cation (NH₃(R^{2A})⁺), a secondary ammonium cation (NH₂(R^{2A})(R^{2B})⁺), a tertiary ammonium cation (NH(R^{2A})(R^{2B})(R^{2C})⁺), or a quaternary ammonium cation (N(R^{2A})(R^{2B})(R^{2C})(R^{2D})⁺). R^{2A} to R^{2D} denote the same as defined below.

The ammonium cation is preferably an ammonium ion (NH₄⁺) or a quaternary ammonium cation; particularly, an ammonium ion (NH₄⁺) or an organic quaternary ammonium cation represented by the following general formula (VII-1) is more preferred.

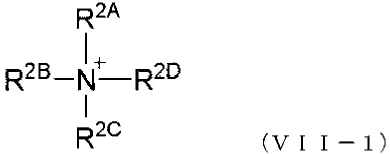

In general formula (VII-1), R^{2A} to R^{2D} each independently represent a C₁₋₁₈ hydrocarbyl group, a 3- to 18-membered non-aromatic heterocyclic group, or a 5- to 18-membered aromatic heterocyclic group, the hydrocarbyl group and the heterocyclic groups each optionally having a substituent, and
a divalent carbon atom at any position of R^{2A} to R^{2D} except the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time);
a hydrogen atom in R^{2A} to R^{2D} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, a C₁₋₁₈ hydrocarbylamino group, a di-C₁₋₁₈ hydrocarbylamino group, a C₁₋₁₈ hydrocarbylaminocarbonyl group, a di-C₁₋₁₈ hydrocarbylaminocarbonyl group, a C₁₋₁₈ hydrocarbylcarbonylamino group, a C₁₋₁₈ hydrocarbylaminocarbonyloxy group, a di-C₁₋₁₈ hydrocarbylaminocarbonyloxy group, a C₁₋₁₈ hydrocarbylaminocarbonylamino group, a di-C₁₋₁₈ hydrocarbylaminocarbonylamino group, a C₁₋₁₈ hydrocarbyloxycarbonylamino group, or a C₁₋₁₈ hydrocarbylthio group, in which at least a part of the hydrogen atoms may be substituted with (a) to (t), wherein a divalent carbon atom at any position excluding the terminal positions of these substituents may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time); and
any two of R^{2A} to R^{2D} may be bonded to each other directly by a single bond or via a divalent linking group -O-, -S-, -C(=O)-, -S(=O)-, -S(=O)2-, -C(=O)O-, or a C1-3 alkylene group to form a ring together with a nitrogen atom in the formula (VII-1).

### <Organic Quaternary Ammonium Cation Having One or More Substituents>

From the perspective of providing a functional building block, in the organic quaternary ammonium cation represented by the general formula (VII-1),
R^{2A} to R^{2D} more preferably each independently denote
a C₁₋₁₈ hydrocarbyl group, a 3- to 18-membered non-aromatic heterocyclic group, or a 5- to 18-membered aromatic heterocyclic group, each optionally having a substituent;
a divalent carbon atom at any position of R^{2A} to R^{2D} except the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time);
   at least one hydrogen atom in R^{2A} to R^{2D} is substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group,
more preferably a C₁₋₁₈ alkyl group, a C₃₋₁₈ alicyclic group, a C₆₋₁₈ aryl group, or a C₇₋₁₈ aralkyl group, each optionally having a substituent;
a divalent carbon atom at any position of R^{2A} to R^{2D} except the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time);
at least one hydrogen atom in R^{2A} to R^{2D} is substituted with (a) a halogen atom, (b) a C₁₋₃ haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group.

R^{2A} to R^{2D} each having one or more substituents are not particularly limited but are, for example, a C₁₋₁₈ hydrocarbyl group having a hydroxy group or a glycidyl group, such as a 2-trifluoromethylbenzyl group, a 2-hydroxyethyl group, a 3-hydroxypropyl group, or a 1-glycidyloxypropan-3-yl group; a C₁₋₁₈ hydrocarbyl group having an ethylenically unsaturated group, such as a vinyl group, an allyl group, a vinylbenzyl group, a propenyl group, a butenyl group, a pentenyl group, a hexenyl group, a heptenyl group, an acryloylethyl group, an acryloylpropyl group, a methacryloylethyl group, a methacryloylpropyl group, an acryloyloxyethyl group, an acryloyloxypropyl group, a methacryloyloxyethyl group, a methacryloyloxypropyl group, an acryloylaminoethyl group, an acryloylaminopropyl group, a methacryloylaminoethyl group, a methacryloylaminopropyl group, or a styryl group; or a C₁₋₁₈ hydrocarbyl group having an acid-dissociable group, such as a 4-methoxymethoxyphenyl group, a methoxymethyl group, an ethoxyethyl group, a methoxyethoxymethyl group, a t-butoxycarbonyl group, a 1-methylcyclopentyl group, a 1-ethylcyclopentyl group, a 1-phenylcyclopentyl group, a 1-tolylcyclopentyl group, a 1-methylcyclohexyl group, a 1-ethylcyclohexyl group, a 1-phenylcyclohexyl group, a 1-tolylcyclohexyl group, a 1-(naphthalen-2-yl)cyclohexyl group, a 1-(1-methoxy-2-methylpropan-2-yl)cyclopentyl group, a 1-(1-ethoxy-2-methylpropan-2-yl)cyclopentyl group, a 2-methyladamantan-2-yl group, a 2-ethyladamantan-2-yl group, a 2-phenyladamantan-2-yl group, a diethylaminocarbonyl group, or a diisopropylaminocarbonyl group; or the like.

### <Examples of Organic Quaternary Ammonium Cation>

Specific examples of the organic quaternary ammonium cation include a diallyldimethylammonium cation, a (3-acrylamidopropyl)trimethylammonium cation, a trimethyl-2-methacryloyloxyethylammonium cation, an N-(2-acryloyloxyethyl)-N-benzyl-N,N-dimethylammonium cation, a trimethylvinylammonium cation, an N-4-vinylbenzyltriallylammonium cation, a 3-hydroxypropyltriallylammonium cation, a 2-trifluoromethylbenzyltriallylammonium cation, a di-2-(N-methylacrylamido)ethyldimethylammonium cation, an allyltrimethylammonium cation, a butyl(2-methacryloyloxyethyl)dimethylammonium cation, an ethoxycarbonylmethyltriethylammonium cation, a 2-hydroxyethyltrimethylammonium cation, a 2-acetylethyltrimethylammonium cation, a (4-((diisopropylcarbamoyl)oxy)phenyl)trimethylammonium cation, a (4-(methacryloyloxy)phenyl)trimethylammonium cation, a trimethyl(4-(nonanoyloxy)phenyl)ammonium cation, or the like.

### [1-1-2-2-2. Ammonium Dication]

The ammonium dication is not particularly limited and may be known and commonly used. The ammonium dication is, for example, an organic quaternary ammonium dication represented by the following general formula (VII-2).

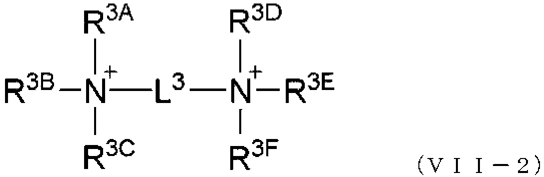

In the general formula (VII-2),
R^{3A} to R^{3F} each independently denote a C₁₋₁₈ hydrocarbyl group, a 3- to 18-membered non-aromatic heterocyclic group, or a 5- to 18-membered aromatic heterocyclic group, each optionally having a substituent,
a divalent carbon atom at any position of R^{3A} to R^{3F} excluding the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time),
L³ represents a C₁₋₁₈ hydrocarbylene group optionally having a substituent,
a divalent carbon atom at any position of L³ may be substituted with -O-, -C(=O)-, - C(=O)O-, -OCO-, -CONH-, -NHCO-, -S-, or -SO₂- (provided that adjacent divalent carbon atoms are not substituted at the same time); and
a hydrogen atom in R^{3A} to R^{3F} and L³ may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, a C₁₋₁₈ hydrocarbylamino group, a di-C₁₋₁₈ hydrocarbylamino group, a C₁₋₁₈ hydrocarbylaminocarbonyl group, a di-C₁₋₁₈ hydrocarbylaminocarbonyl group, a C₁₋₁₈ hydrocarbylcarbonylamino group, a C₁₋₁₈ hydrocarbylaminocarbonyloxy group, a di-C₁₋₁₈ hydrocarbylaminocarbonyloxy group, a C₁₋₁₈ hydrocarbylaminocarbonylamino group, a di-C₁₋₁₈ hydrocarbylaminocarbonylamino group, a C₁₋₁₈ hydrocarbyloxycarbonylamino group, or a C₁₋₁₈ hydrocarbylthio group, in which at least a part of the hydrogen atoms may be substituted with (a) to (t), wherein a divalent carbon atom at any position excluding the terminal positions of these substituents may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time); and
any two of R^{3A} to R^{3F} may be bonded to each other directly by a single bond or via a divalent linking group -O-, -S-, -C(=O)-, -S(=O)-, -S(=O)₂-, -C(=O)O-, or a C₁₋₃ alkylene group to form a ring together with a nitrogen atom in the formula (VII-2).

The organic quaternary ammonium dication represented by the general formula (VII-2) is not particularly limited but is, for example, 1,4-diallyl-1,4-diazabicyclo[2.2.2]octane-1,4-diium, 1,4-di(2-(meth)acryloyloxyethyl)-1,4-diazabicyclo[2.2.2]octane-1,4-diium, 1,4-bis(2-(meth)acrylamidoethyl)-1,4-diazabicyclo[2.2.2]octane-1,4-diium, or the like.

### [1-1-2-2-3. Phosphonium Cation]

The phosphonium cation is not particularly limited and may be known and commonly used. The phosphonium cation is, for example, an organic quaternary phosphonium cation represented by the following general formula (VII-3).

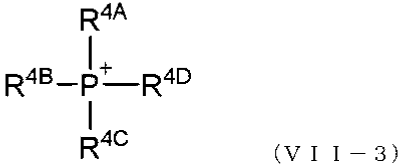

In general formula (VII-3), R^{4A} to R^{4D} each independently denote an optionally substituted C₁₋₁₈ hydrocarbyl group, an optionally substituted 3- to 18-membered non-aromatic heterocyclic group, or an optionally substituted 5- to 18-membered aromatic heterocyclic group,
a divalent carbon atom at any position of R^{4A} to R^{4D} except the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time);
a hydrogen atom in R^{4A} to R^{4D} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamido group, (o) a styryl group, (p) an epoxy group, (q) a glycidyl group, (r) an amide group, (s) a hydroxy or carboxy group having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, a C₁₋₁₈ hydrocarbylamino group, a di-C₁₋₁₈ hydrocarbylamino group, a C₁₋₁₈ hydrocarbylaminocarbonyl group, a di-C₁₋₁₈ hydrocarbylaminocarbonyl group, a C₁₋₁₈ hydrocarbylcarbonylamino group, a C₁₋₁₈ hydrocarbylaminocarbonyloxy group, a di-C₁₋₁₈ hydrocarbylaminocarbonyloxy group, a C₁₋₁₈ hydrocarbylaminocarbonylamino group, a di-C₁₋₁₈ hydrocarbylaminocarbonylamino group, a C₁₋₁₈ hydrocarbyloxycarbonylamino group, or a C₁₋₁₈ hydrocarbylthio group, in which at least a part of the hydrogen atoms may be substituted with (a) to (t), wherein a divalent carbon atom at any position excluding the terminal positions of these substituents may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time); and
any two of R^{4A} to R^{4D} may be bonded to each other directly by a single bond or via a divalent linking group -O-, -S-, -C(=O)-, -S(=O)-, -S(=O)₂-, -C(=O)O-, or a C₁₋₃ alkylene group to form a ring together with a phosphorus atom in the formula (VII-3).

### <Organic Quaternary Phosphonium Cation Having One or More Substituents>

In the organic quaternary phosphonium cation represented by the general formula (VII-3), from the perspective of providing a functional building block,
R^{4A} to R^{4D} preferably each independently denote
a C₁₋₁₈ hydrocarbyl group, a 3- to 18-membered non-aromatic heterocyclic group, or a 5- to 18-membered aromatic heterocyclic group, each optionally having a substituent;
a divalent carbon atom at any position of R^{4A} to R^{4D} except the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time);
at least one hydrogen atom in R^{4A} to R^{4D} is substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy or carboxy group having a protective group, or (t) a polar group having an acid-dissociable group,
more preferably a C₁₋₁₈ alkyl group, a C₃₋₁₈ alicyclic group, a C₆₋₁₈ aryl group, or a C₇₋₁₈ aralkyl group, each optionally having a substituent;
a divalent carbon atom at any position of R^{4A} to R^{4D} except the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time);
at least one hydrogen atom in R^{4A} to R^{4D} is substituted with (a) a halogen atom, (b) a C1-3 haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamido group, (o) a styryl group, (p) an epoxy group, (q) a glycidyl group, (r) an amide group, (s) a hydroxy or carboxy group having a protective group, or (t) a polar group having an acid-dissociable group.

R^{4A} to R^{4D} having one or more substituents are not particularly limited but are, for example, a C₁₋₁₈ hydrocarbyl group having a halogen atom, a hydroxy group, or a glycidyl group, such as a 2-trifluoromethylbenzyl group, a 2-hydroxyethyl group, a 3-hydroxypropyl group, or a 1-glycidyloxypropan-3-yl group; a C₁₋₁₈ hydrocarbyl group having an ethylenically unsaturated double bond, such as a vinyl group, an allyl group, a propenyl group, a butenyl group, a pentenyl group, a hexenyl group, a heptenyl group, an acryloylethyl group, an acryloylpropyl group, a methacryloylethyl group, a methacryloylpropyl group, an acryloyloxyethyl group, an acryloyloxypropyl group, a methacryloyloxyethyl group, a methacryloyloxypropyl group, an acryloylaminoethyl group, an acryloylaminopropyl group, a methacryloylaminoethyl group, a methacryloylaminopropyl group, or a styryl group; a C₁₋₁₈ hydrocarbyl group having an acid-dissociable group, such as a methoxymethyl group, an ethoxyethyl group, a methoxyethoxymethyl group, a t-butoxycarbonyl group, a 1-methylcyclopentyl group, a 1-ethylcyclopentyl group, a 1-phenylcyclopentyl group, a 1-tolylcyclopentyl group, a 1-methylcyclohexyl group, a 1-ethylcyclohexyl group, a 1-phenylcyclohexyl group, a 1-tolylcyclohexyl group, a 1-(naphthalen-2-yl)cyclohexyl group, a 1-(1-methoxy-2-methylpropan-2-yl)cyclopentyl group, a 1-(1-ethoxy-2-methylpropan-2-yl)cyclopentyl group, a 2-methyladamantan-2-yl group, a 2-ethyladamantan-2-yl group, a 2-phenyladamantan-2-yl group, a diethylaminocarbonyl group, or a diisopropylaminocarbonyl group; or the like.

### <Examples of Organic Quaternary Phosphonium Cation>

The organic quaternary phosphonium cation represented by the general formula (VII-3) is not particularly limited but is, for example, a tributylcyanomethylphosphonium cation, a methyltriphenylphosphonium cation, an ethyltriphenylphosphonium cation, a cyanomethyltriphenylphosphonium cation, a formylmethyltriphenylphosphonium cation, a methoxymethyltriphenylphosphonium cation, a chloromethyltriphenylphosphonium cation, an acetonyltriphenylphosphonium cation, a tributyl-1,3-dioxan-2-ylmethylphosphonium cation, a triphenylpropargylphosphonium cation, an allyltriphenylphosphonium cation, a cyclopropyltriphenylphosphonium cation, a benzyltriphenylphosphonium cation, a tetrakis(hydroxymethyl)phosphonium cation, a 2-carboxyethyltriphenylphosphonium cation, a methoxycarbonylmethyltriphenylphosphonium cation, a t-butoxycarbonylmethyltriphenylphosphonium cation, a (4-((diisopropylcarbamoyl)oxy)phenyl)triphenylphosphonium cation, a (4-(methacryloyloxy)phenyl)triphenylphosphonium cation, a triphenyl(4-(nonanoyloxy)phenyl)phosphonium cation, or the like.

### [1-1-2-2-4. Phosphonium Dication]

The phosphonium dication is not particularly limited and may be a known and commonly used one. The phosphonium dication is, for example, an organic quaternary phosphonium dication represented by the following general formula (VII-4).

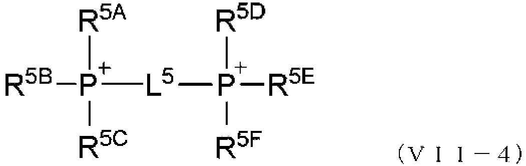

In general formula (VII-4), R^{5A} to R^{5F} each independently denote an optionally substituted C₁₋₁₈ hydrocarbyl group, an optionally substituted 3- to 18-membered non-aromatic heterocyclic group, or an optionally substituted 5- to 18-membered aromatic heterocyclic group,
a divalent carbon atom at any position of R^{5A} to R^{5F} except the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time);
L⁵ represents a C₁₋₁₈ hydrocarbylene group optionally having a substituent,
a divalent carbon atom at any position of L⁵ may be substituted with -O-, -C(=O)-, - C(=O)O-, -OCO-, -CONH-, -NHCO-, -S-, or -SO₂- (provided that adjacent divalent carbon atoms are not substituted at the same time);
a hydrogen atom in R^{5A} to R^{5F} and L⁵ may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamido group, (o) a styryl group, (p) an epoxy group, (q) a glycidyl group, (r) an amide group, (s) a hydroxy or carboxy group having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, a C₁₋₁₈ hydrocarbylamino group, a di-C₁₋₁₈ hydrocarbylamino group, a C₁₋₁₈ hydrocarbylaminocarbonyl group, a di-C₁₋₁₈ hydrocarbylaminocarbonyl group, a C₁₋₁₈ hydrocarbylcarbonylamino group, a C₁₋₁₈ hydrocarbylaminocarbonyloxy group, a di-C₁₋₁₈ hydrocarbylaminocarbonyloxy group, a C₁₋₁₈ hydrocarbylaminocarbonylamino group, a di-C₁₋₁₈ hydrocarbylaminocarbonylamino group, a C₁₋₁₈ hydrocarbyloxycarbonylamino group, or a C₁₋₁₈ hydrocarbylthio group, in which at least a part of the hydrogen atoms may be substituted with (a) to (t), wherein a divalent carbon atom at any position excluding the terminal positions of these substituents may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time); and
any two of R^{5A} to R^{5F} may be bonded to each other directly by a single bond or via a divalent linking group -O-, -S-, -C(=O)-, -S(=O)-, -S(=O)₂-, -C(=O)O-, or a C₁₋₃ alkylene group to form a ring together with a phosphorus atom in the formula (VII-4).

The organic quaternary phosphonium dication represented by the general formula (VII-4) is not particularly limited but is, for example, a trans-2-butene-1,4-bis(triphenylphosphonium) dication, an ethylene bis(triphenylphosphonium) dication, a pentamethylene bis(triphenylphosphonium) dication, or the like.

### [1-1-2-2-5. Sulfonium Cation]

The sulfonium cation is not particularly limited and may be a known and commonly used one. The sulfonium cation is, for example, an organic sulfonium cation represented by the following general formula (VII-5).

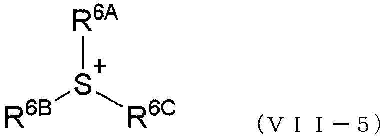

In general formula (VII-5), R^{6A}, R^{6B} and R^{6C} each independently denote an optionally substituted C₁₋₁₈ hydrocarbyl group, an optionally substituted 3- to 18-membered non-aromatic heterocyclic group, or an optionally substituted 5- to 18-membered aromatic heterocyclic group,
a divalent carbon atom at any position of R^{6A}, R^{6B} and R^{6C} except the terminal positions may be substituted with -O-, -C(=O)-, -C(=O)O-, -OCO-, -CONH-, -NHCO-, -NH(C=O)O-, -S-, or - SO₂- (provided that adjacent divalent carbon atoms are not substituted at the same time);
a hydrogen atom in R^{6A}, R^{6B}, and R^{6C} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamido group, (o) a styryl group, (p) an epoxy group, (q) a glycidyl group, (r) an amide group, (s) a hydroxy or carboxy group having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, a C₁₋₁₈ hydrocarbylamino group, a di-C₁₋₁₈ hydrocarbylamino group, a C₁₋₁₈ hydrocarbylaminocarbonyl group, a di-C₁₋₁₈ hydrocarbylaminocarbonyl group, a C₁₋₁₈ hydrocarbylcarbonylamino group, a C₁₋₁₈ hydrocarbylaminocarbonyloxy group, a di-C₁₋₁₈ hydrocarbylaminocarbonyloxy group, a C₁₋₁₈ hydrocarbylaminocarbonylamino group, a di-C₁₋₁₈ hydrocarbylaminocarbonylamino group, a C₁₋₁₈ hydrocarbyloxycarbonylamino group, or a C₁₋₁₈ hydrocarbylthio group, in which at least a part of the hydrogen atoms may be substituted with (a) to (t), wherein a divalent carbon atom at any position excluding the terminal positions of these substituents may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time); and
furthermore, any two of R^{6A}, R^{6B}, and R^{6C} may be bonded to each other directly by a single bond or via a divalent linking group -O-, -S-, -C(=O)-, -S(=O)-, -S(=O)₂-, -C(=O)O-, or a C₁₋₃ alkylene group to form a ring together with a sulfur atom in the formula (VII-5).

R^{6A}, R^{6B} and R^{6C} are each independently preferably a C₁₋₁₈ hydrocarbyl group optionally having a substituent; in which a divalent carbon atom at any position of R^{6A}, R^{6B} and R^{6C} except the terminal positions may be substituted with -O-, -C(=O)-, -C(=O)O-, -OCO-, -CONH-, -NHCO-, - NH(C=O)O-, -S-, or -SO₂- (provided that adjacent divalent carbon atoms are not substituted at the same time); and a hydrogen atom contained in R^{6A}, R^{6B} and R^{6C} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamido group, (o) a styryl group, (p) an epoxy group, (q) a glycidyl group, (r) an amide group, (s) a hydroxy group or a carboxy group each having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, or a C₁₋₁₈ hydrocarbylthio group, in which at least part of the hydrogen atoms may be substituted with (a) to (t) above, and a divalent carbon atom at any position of these substituents except the terminal positions may be substituted with -O-, -C(=O)-, -C(=O)O-, - OCO-, -CONH-, -NHCO-, -NH(C=O)O-, -S-, or -SO₂- (provided that adjacent divalent carbon atoms are not substituted at the same time), and
more preferably a C₁₋₁₈ alkyl group, a C₃₋₁₈ alicyclic group, a C₆₋₁₈ aryl group, or a C₇₋₁₈ aralkyl group, each optionally having a substituent; in which a divalent carbon atom at any position of R^{6A}, R^{6B} and R^{6C} except the terminal positions may be substituted with -O-, -C(=O)-, -C(=O)O-, - OCO-, -CONH-, -NHCO-, -NH(C=O)O-, -S-, or -SO₂- (provided that adjacent divalent carbon atoms are not substituted at the same time); and a hydrogen atom contained in R^{6A}, R^{6B} and R^{6C} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamide group, (o) a styryl group, (p) an epoxy group, (q) a glycidyl group, (r) an amide group, (s) a hydroxy group or a carboxy group each having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, or a C₁₋₁₈ hydrocarbylthio group, in which at least part of the hydrogen atoms may be substituted with (a) to (t) above, and a divalent carbon atom at any position of these substituents except the terminal positions may be substituted with -O-, -C(=O)-, - C(=O)O-, -OCO-, -CONH-, -NHCO-, -NH(C=O)O-, -S-, or -SO₂- (provided that adjacent divalent carbon atoms are not substituted at the same time).

In the case where any two of R^{6A}, R^{6B}, and R^{6C} are linked to each other directly by a single bond or via a divalent linking group -O-, -S-, -C(=O)-, -S(=O)-, -S(=O)₂-, -C(=O)O-, or a C₁₋₃ alkylene group to form a ring together with the sulfur atom in formula (VII-5), the organic sulfonium cation is, for example, one having a thian-1-ium skeleton, a thiophen-1-ium skeleton, a 1,4-oxathian-4-ium skeleton, a 1,4-dithian-1-ium skeleton, a 1H-thiophen-1-ium skeleton, a benzo[b]thiophen-1-ium skeleton, a dibenzothiophenium skeleton, a 9,10-dihydrothioxanthylium skeleton, a 10H-phenoxathiin-10-ium skeleton, or a 5H-thianthren-5-ium skeleton, or the like, and examples thereof include the following. Note that * indicates a binding site to R^{6A}, R^{6B}, or R^{6C} which is not involved in formation of the ring.

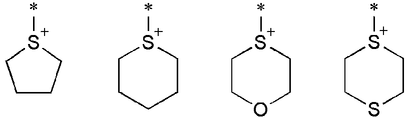

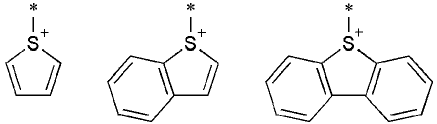

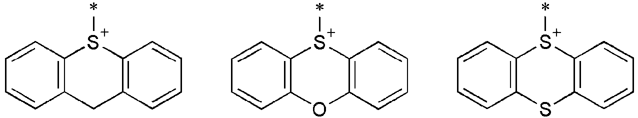

The organic sulfonium cation is, for example, a dibutyl(pentyl)sulfonium cation, a triethylsulfonium cation, a (2-carboxyethyl)dimethylsulfonium cation, a trimethylsulfonium cation, a dimethylphenacylsulfonium cation, a 1-(4-hydroxynaphthalen-1-yl)hexahydrothiopyrylium cation, a dimethylphenylsulfonium cation, a triphenylsulfonium cation, a tris(4-methylphenyl)sulfonium cation, a 4-methoxyphenyldiphenylsulfonium cation, a 4-iodophenyldiphenylsulfonium cation, a tris(4-fluorophenyl)sulfonium cation, a 1-phenylhexahydrothiopyrylium cation, a di(naphthalen-1-yl)(phenyl)sulfonium cation, a phenylbis(2-(trifluoromethyl)phenyl)sulfonium cation, a mesitylbis(2-(trifluoromethyl)phenyl)sulfonium cation, a bis(3,5-difluorophenyl)(phenyl)sulfonium cation, a tris(3,5-difluorophenyl)sulfonium cation, a (4-(dodecanoyloxy-3,5-dimethylphenyl))diphenylsulfonium cation, a diphenyl(3-(trifluoromethoxy)phenyl)sulfonium cation, a (4-(1-adamantylcarbonyloxy)phenyl)diphenylsulfonium cation, a (4-phenylthiophenyl)diphenylsulfonium cation, a 5-phenyl-5H-thianthren-5-ium cation, a 5-(2,5-dimethylphenyl)thianthren-5-ium cation, a 5-phenyl-5H-dibenzo[b,d]thiophen-5-ium cation, a 5-(3-(trifluoromethyl)phenyl)-5H-dibenzo[b,d]thiophen-5-ium cation, a 1-(4-(t-butyl)phenyl)-1H-benzo[b]thiophen-1-ium cation, a methyldiphenylsulfonium cation, a (2-bromoethyl)diphenylsulfonium cation, a (3-chloropropyl)diphenylsulfonium cation, a benzyl(4-hydroxyphenyl)methylsulfonium cation, a (4-hydroxyphenyl)methyl(2-methylbenzyl)sulfonium cation, a 4-hydroxyphenyldimethylsulfonium cation, a diphenyl(methyl)sulfonium cation, a diphenyl(4-(phenylthio)phenyl)sulfonium cation, a (2-bromoethyl)diphenylsulfonium cation, a dimesityl(trifluoromethyl)sulfonium cation, a tri-p-tolylsulfonium cation, or the like.

### [1-1-2-2-6. Sulfonium Dication]

The sulfonium dication is not particularly limited and may be a known and commonly used one. The sulfonium dication is, for example, an organic sulfonium dication represented by the following general formula (VII-6).

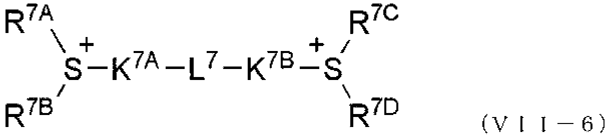

In general formula (VII-6), R^{7A}, R^{7B}, R^{7C}, and R^{7D} each independently denote an optionally substituted C₁₋₁₈ hydrocarbyl group, an optionally substituted 3- to 18-membered non-aromatic heterocyclic group, or an optionally substituted 5- to 18-membered aromatic heterocyclic group,
a divalent carbon atom at any position of R^{7A}, R^{7B}, R^{7C}, and R^{7D} except the terminal positions may be substituted with -O-, -C(=O)-, -C(=O)O-, -OCO-, -CONH-, -NHCO-, -NH(C=O)O-, - S-, or -SO₂- (provided that adjacent divalent carbon atoms are not substituted at the same time);
K^{7A}, K^{7B}, and L⁷ each independently represent a C₁₋₁₈ hydrocarbylene group optionally having a substituent,
a divalent carbon atom at any position of K^{7A}, K^{7B}, and L⁷ may be substituted with -O-, - C(=O)-, -C(=O)O-, -OCO-, -CONH-, -NHCO-, -S-, or -SO₂- (provided that adjacent divalent carbon atoms are not substituted at the same time);
a hydrogen atom in R^{7A}, R^{7B}, R^{7C}, R^{7D}, K^{7A}, K^{7B}, and L⁷ may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamido group, (o) a styryl group, (p) an epoxy group, (q) a glycidyl group, (r) an amide group, (s) a hydroxy or carboxy group having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, a C₁₋₁₈ hydrocarbylamino group, a di-C₁₋₁₈ hydrocarbylamino group, a C₁₋₁₈ hydrocarbylaminocarbonyl group, a di-C₁₋₁₈ hydrocarbylaminocarbonyl group, a C₁₋₁₈ hydrocarbylcarbonylamino group, a C₁₋₁₈ hydrocarbylaminocarbonyloxy group, a di-C₁₋₁₈ hydrocarbylaminocarbonyloxy group, a C₁₋₁₈ hydrocarbylaminocarbonylamino group, a di-C₁₋₁₈ hydrocarbylaminocarbonylamino group, a C₁₋₁₈ hydrocarbyloxycarbonylamino group, or a C₁₋₁₈ hydrocarbylthio group, in which at least a part of the hydrogen atoms may be substituted with (a) to (t), wherein a divalent carbon atom at any position excluding the terminal positions of these substituents may be substituted with -O-, -C(=O)-, -C(=O)O-, -OCO-, -CONH-, -NHCO-, -NH(C=O)O-, -S-, or - SO₂- (provided that adjacent divalent carbon atoms are not substituted at the same time); and
any two of R^{7A}, R^{7B}, and K^{7A} and/or any two of R^{1C}, R^{7D}, and K^{7B} may be bonded to each other directly by a single bond or via a divalent linking group -O-, -S-, -C(=O)-, -S(=O)-, -S(=O)₂-, - C(=O)O-, or a C₁₋₃ alkylene group to form a ring together with a sulfur atom in the formula (VII-6).

R^{7A} to R^{7D} are each independently preferably a C₁₋₁₈ hydrocarbyl group optionally having a substituent; in which a divalent carbon atom at any position of R^{7A} to R^{7D} except the terminal positions may be substituted with -O-, -C(=O)-, -C(=O)O-, -OCO-, -CONH-, -NHCO-, -NH(C=O)O-, -S-, or - SO₂- (provided that adjacent divalent carbon atoms are not substituted at the same time); and a hydrogen atom contained in R^{7A} to R^{7D} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamido group, (o) a styryl group, (p) an epoxy group, (q) a glycidyl group, (r) an amide group, (s) a hydroxy group or a carboxy group each having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, or a C₁₋₁₈ hydrocarbylthio group, in which at least part of the hydrogen atoms may be substituted with (a) to (t) above, and a divalent carbon atom at any position of these substituents except the terminal positions may be substituted with -O-, -C(=O)-, -C(=O)O-, -OCO-, -CONH-, -NHCO-, -NH(C=O)O-, -S-, or - SO₂- (provided that adjacent divalent carbon atoms are not substituted at the same time), and
more preferably a C₁₋₁₈ alkyl group, a C₃₋₁₈ alicyclic group, a C₆₋₁₈ aryl group, or a C₇₋₁₈ aralkyl group, each optionally having a substituent; in which a divalent carbon atom at any position of R^{7A} to R^{7D} except the terminal positions may be substituted with -O-, -C(=O)-, -C(=O)O-, -OCO-, - CONH-, -NHCO-, -NH(C=O)O-, -S-, or -SO₂- (provided that adjacent divalent carbon atoms are not substituted at the same time); and a hydrogen atom contained in R^{7A} to R^{7D} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamido group, (o) a styryl group, (p) an epoxy group, (q) a glycidyl group, (r) an amide group, (s) a hydroxy group or a carboxy group each having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, or a C₁₋₁₈ hydrocarbylthio group, in which at least part of the hydrogen atoms may be substituted with (a) to (t) above, and a divalent carbon atom at any position of these substituents except the terminal positions may be substituted with -O-, -C(=O)-, -C(=O)O-, - OCO-, -CONH-, -NHCO-, -NH(C=O)O-, -S-, or -SO₂- (provided that adjacent divalent carbon atoms are not substituted at the same time).
K^{7A}, K^{7B}, and L⁷ each independently denote a C₁₋₁₈ alkylene group or a C₁₋₁₈ arylene group, each optionally having a substituent;
a divalent carbon atom at any position of K^{7A}, K^{7B}, and L⁷ may be substituted with -O-, - C(=O)-, -C(=O)O-, -OCO-, -CONH-, -NHCO-, -S-, or -SO₂- (provided that adjacent divalent carbon atoms are not substituted at the same time); a hydrogen atom in K^{7A}, K^{7B}, and L⁷ may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamido group, (o) a styryl group, (p) an epoxy group, (q) a glycidyl group, (r) an amide group, (s) a hydroxy or carboxy group having a protective group, or (t) a polar group having an acid-dissociable group.

### [1-1-2-2-7. Iodonium Cation]

The iodonium cation is not particularly limited and may be a known and commonly used one. The iodonium cation is, for example, an organic iodonium cation represented by the following general formula (VII-7).

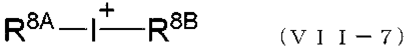

In general formula (VII-7), R^{8A} and R^{8B} each independently denote an optionally substituted C₁₋₁₈ hydrocarbyl group, an optionally substituted 3- to 18-membered non-aromatic heterocyclic group, or an optionally substituted 5- to 18-membered aromatic heterocyclic group,
a divalent carbon atom at any position of R^{8A} and R^{8B} except the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time);
a hydrogen atom in R^{8A} and R^{8B} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamido group, (o) a styryl group, (p) an epoxy group, (q) a glycidyl group, (r) an amide group, (s) a hydroxy or carboxy group having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, a C₁₋₁₈ hydrocarbylamino group, a di-C₁₋₁₈ hydrocarbylamino group, a C₁₋₁₈ hydrocarbylaminocarbonyl group, a di-C₁₋₁₈ hydrocarbylaminocarbonyl group, a C₁₋₁₈ hydrocarbylcarbonylamino group, a C₁₋₁₈ hydrocarbylaminocarbonyloxy group, a di-C₁₋₁₈ hydrocarbylaminocarbonyloxy group, a C₁₋₁₈ hydrocarbylaminocarbonylamino group, a di-C₁₋₁₈ hydrocarbylaminocarbonylamino group, a C₁₋₁₈ hydrocarbyloxycarbonylamino group, or a C₁₋₁₈ hydrocarbylthio group, in which at least a part of the hydrogen atoms may be substituted with (a) to (t), wherein a divalent carbon atom at any position excluding the terminal positions of these substituents may be substituted with -O-, -C(=O)-, -C(=O)O-, -OCO-, -CONH-, -NHCO-, -NH(C=O)O-, -S-, or -SO₂- (provided that adjacent divalent carbon atoms are not substituted at the same time); and
R^{8A} and R^{8B} may be bonded to each other directly by a single bond or via a divalent linking group -O-, -S-, -C(=O)-, -S(=O)-, -S(=O)₂-, -C(=O)O-, or a C₁₋₃ alkylene group to form a ring together with an iodine atom in the formula (VII-7).
R^{8A} and R^{8B} are preferably a C₁₋₁₈ hydrocarbyl group optionally having a substituent; in which a divalent carbon atom at any position of R^{8A} and R^{8B} except the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time); and a hydrogen atom contained in R^{8A} and R^{8B} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamido group, (o) a styryl group, (p) an epoxy group, (q) a glycidyl group, (r) an amide group, (s) a hydroxy group or a carboxy group each having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, or a C₁₋₁₈ hydrocarbylthio group, in which at least part of the hydrogen atoms may be substituted with (a) to (t) above, and a divalent carbon atom at any position of these substituents except the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time), and
more preferably a C₁₋₁₈ alkyl group, a C₃₋₁₈ alicyclic group, a C₆₋₁₈ aryl group, or a C₇₋₁₈ aralkyl group, each optionally having a substituent; in which a divalent carbon atom at any position of R^{8A} and R^{8B} except the terminal positions may be substituted with -O-, -C(=O)-, -C(=O)O-, -OCO-, - CONH-, -NHCO-, -NH(C=O)O-, -S-, or -SO₂- (provided that adjacent divalent carbon atoms are not substituted at the same time); and a hydrogen atom contained in R^{8A} and R^{8B} may be substituted with (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a vinyl group, (k) an allyl group, (l) a (meth)acryloyl group, (m) a (meth)acryloyloxy group, (n) a (meth)acrylamido group, (o) a styryl group, (p) an epoxy group, (q) a glycidyl group, (r) an amide group, (s) a hydroxy group or a carboxy group each having a protective group, (t) a polar group having an acid-dissociable group, or (u) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, or a C₁₋₁₈ hydrocarbylthio group, in which at least part of the hydrogen atoms may be substituted with (a) to (t) above, and a divalent carbon atom at any position of these substituents except the terminal positions may be substituted with -O-, -C(=O)-, -C(=O)O-, - OCO-, -CONH-, -NHCO-, -NH(C=O)O-, -S-, or -SO₂- (provided that adjacent divalent carbon atoms are not substituted at the same time).

### [1-1-3. Heteropolyacid Salt Having Modified Lacunary Site or Mixture Thereof]

### <Heteropolyacid Salt Having Modified Lacunary Site Represented by General Formula (l) or Mixture Thereof>

The heteropolyacid salt having the modified lacunary site or the mixture thereof according to the present embodiment can be a heteropolyacid salt having a modified lacunary site represented by the following general formula (I) or a mixture thereof.

(A^{m+})ₐ(C(^{am)-}) (I)

[In the formula (I),

A^{m+} each independently denotes H⁺, a metal ion, an onium cation, or an onium dication;
C^{(am)-} denotes a heteropolyacid anion having a lacunary site in which the lacunary site is modified; and
m denotes an integer in the range of 1 to 5, and a denotes a real number greater than 0]

In the heteropolyacid salt having the modified lacunary site represented by the general formula (I) or the mixture thereof, the "metal ion", the "onium cation or onium dication", and the "heteropolyacid anion having a lacunary site in which the lacunary site is modified" can appropriately be those described above.

The heteropolyacid anion having the modified lacunary site represented by the general formula (I) preferably has one or more polar groups each having an acid-dissociable group from the perspective of imparting a function of changing the solubility in a developer by the action of an acid or the like.

The acid-dissociable group is, for example, a tertiary-carbon-type acid-dissociable group G_{A}, an allyl- or benzyl-type acid-dissociable group G_{B}, an acetal-type acid-dissociable group G_{C}, an aminocarbonyl-type acid-dissociable group G_{D}, or the like.

The mixture of the heteropolyacid salt having the modified lacunary site represented by the general formula (I) may contain a plurality of types of A^{m+}. In this case, the content ratio of the plurality of types of A^{m+} can be determined by, for example, NMR analysis, XRF analysis, XPS analysis, or the like.

### <Heteropolyacid Salt Having Modified Lacunary Site Represented by General Formula (I') or Mixture Thereof>

Another heteropolyacid salt having a modified lacunary site or a mixture thereof according to the present embodiment can be a heteropolyacid salt having a modified lacunary site represented by the following general formula (I') or a mixture thereof.

(A'^{m'+})_{a'}(Bⁿ⁺)_{b}(C'^{a'm'+bn)-}) (I')

[In the formula (I'),
A'^{m'+} each independently denotes H⁺, a metal ion, an ammonium cation, an ammonium dication, a phosphonium cation, or a phosphonium dication;
Bⁿ⁺ each independently denotes a sulfonium cation, a sulfonium dication, or an iodonium cation;
C'^{(a'm'+bn)-} denotes a heteropolyacid anion having a lacunary site in which the lacunary site is modified; and
m' denotes an integer in the range of 1 to 5, n denotes an integer of 1 or 2, a' denotes a real number, and b denotes a real number greater than 0]

In the heteropolyacid salt having the modified lacunary site represented by the general formula (I') or the mixture thereof, the "metal ion", the "ammonium cation", the "ammonium dication", the "phosphonium cation", the "phosphonium dication", the "sulfonium cation", the "sulfonium dication", the "iodonium cation", and the "heteropolyacid anion having a lacunary site in which the lacunary site is modified" can appropriately be those described above.

The heteropolyacid salt having the modified lacunary site represented by the general formula (I') or the mixture thereof has a sulfonium cation, a sulfonium dication, or an iodonium cation in the cation moiety thereof and can therefore have a function of generating an acid upon exposure to DUV, XUV, EUV, an electron beam, or the like.

A mixture of heteropolyacid salts having a modified lacunary site represented by the general formula (I') may contain a plurality of heteropolyacid salts having a modified lacunary site in which the ratio of A'^{m'+} to Bⁿ⁺ is different. In this case, the values of a' and b can be determined by, for example, NMR analysis, XRF analysis, XPS analysis, or the like.

The ratio of a' to b depends on the types of the heteropolyacid anions having a modified lacunary site, A'^{m'+}, and Bⁿ⁺, and is preferably a':b = 0 to 8:1 to 12, more preferably 0 to 4:2 to 8, still more preferably 0 to 2:1 to 4.

In particular, when the value of a'm'+bn is an integer in the range of 2 to 8 and m' and n are 1, it is preferable that a' is a real number in the range of 0 to 7 and b is a real number in the range of 1 to 8, and it is more preferable that a' is a real number in the range of 0 to 4 and b is a real number in the range of 2 to 8.

### [1-1-4. Component (A) Content]

The component (A) content of the resist material is not particularly limited and may be appropriately determined according to the method for applying the resist material to a substrate or the like, the thickness of the film to be applied, or the like. The component (A) content of the resist material preferably ranges from 0.01% to 20% by mass, more preferably 0.1% to 15% by mass, still more preferably 0.2% to 10% by mass, relative to 100% by mass of the resist material.

### [1-2. (B) Acid Diffusion Control Agent]

The resist material according to the present embodiment contains, (B) an acid diffusion control agent that traps an acid generated upon exposure to light.

The acid diffusion control agent is not particularly limited, and a known and commonly used acid diffusion control agent can be used. Examples of the acid diffusion control agent include (B1) a photodegradable base that is decomposed by exposure and loses acid diffusion controllability, and (B2) a nitrogen-containing organic compound that does not correspond to the component (B1), and these may be used alone or in combination of two or more thereof.

### [1-2-1. (B1) Photodegradable Base]

The (B1) photodegradable base loses acid diffusion controllability by being decomposed by exposure, while acting as a quencher in a non-exposed portion, thereby making it possible to control diffusion of an acid. Therefore, characteristics such as higher sensitivity, reduction of roughness, and suppression of occurrence of coating defects can be improved by incorporating the (B1) photodegradable base into the resist material.

The photodegradable base is not particularly limited and may be a known and commonly used one. The photodegradable base is, for example, a "carboxylate compound B_{A}" represented by the following general formula (VIII-1), a "sulfonate compound B_{B}" represented by the following general formula (VIII-2), a "sulfonyl amide salt compound B_{C}" represented by the following general formula (VIII-3), or the like. In the following, a carboxylate anion, a sulfonate anion, a sulfonyl amide anion, or an onium cation or onium dication (D^{p+}) will be sequentially described.

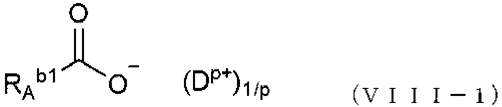

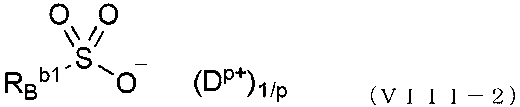

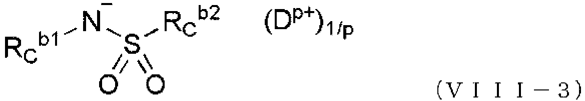

### [1-2-1-1. Carboxylate Compound B_{A}]

The (B1) photodegradable base can be a salt of a carboxylate anion and an onium cation or onium dication (D^{p+}), such as the "carboxylate compound B_{A}" represented by the following general formula (VIII-1).

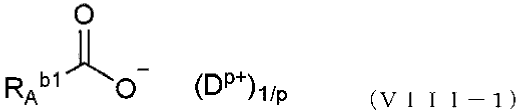

"R_{A}^{b1}" denotes an optionally substituted C₁₋₁₈ hydrocarbyl group, 3- to 18-membered non-aromatic heterocyclic group, or 5- to 18-membered aromatic heterocyclic group in which any divalent carbon atom except the terminal positions may be substituted with -O-, -C(=O)-, -C(=O)O-, -OCO-, - CONH-, -NHCO-, -S-, or -SO₂- (provided that adjacent divalent carbon atoms are not replaced at the same time).

Preferably, R_{A}^{b1} denotes a C₁₋₁₈ hydrocarbyl group optionally having a substituent, and any divalent carbon atom except the terminal positions may be substituted with -O-, -C(=O)-, -C(=O)O-, - OCO-, -CONH-, -NHCO-, -S-, or -SO₂- (provided that adjacent divalent carbon atoms are not substituted at the same time),
more preferably a C₁₋₁₈ alkyl group, a C₃₋₁₈ alicyclic group, a C₆₋₁₈ aryl group, or a C₇₋₁₈ aralkyl group, each optionally having a substituent, and any divalent carbon atom except the terminal positions may be substituted with -O-, -C(=O)-, -C(=O)O-, -OCO-, -CONH-, -NHCO-, -S-, or -SO₂-(provided that adjacent divalent carbon atoms are not substituted at the same time).

### <Carboxylate Compound B_{A1}>

The carboxylate compound B_{A} represented by the general formula (VIII-1) may be a carboxylate compound B_{A1} represented by the following general formula (VIII-1-1).

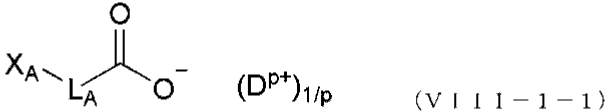

"X_{A}" is a C₁₋₁₈ alkyl group, a C₃₋₁₈ alicyclic group, a C₆₋₁₈ aryl group, or a C₇₋₁₈ aralkyl group, each optionally having a substituent, and any divalent carbon atom except the terminals may be substituted with -O-, -C(=O)-, -C(=O)O-, -OCO-, -CONH-, -NHCO-, -S-, or -SO₂- (provided that adjacent divalent carbon atoms are not substituted at the same time).

X_{A} preferably denotes a C₃₋₁₈ alicyclic group, a C₆₋₁₈ aryl group, or a C₇₋₁₈ aralkyl group each optionally having a substituent and any divalent carbon atom except the terminal positions may be substituted with -O-, -C(=O)-, -C(=O)O-, -OCO-, -CONH-, -NHCO-, -S-, or -SO₂- (provided that adjacent divalent carbon atoms are not replaced at the same time),
more preferably a C₃₋₁₈ alicyclic group or a C₆₋₁₈ aryl group each optionally having a substituent and any divalent carbon atom except the terminal positions may be substituted with -O-, - C(=O)-, -C(=O)O-, -OCO-, -CONH-, -NHCO-, -S-, or -SO₂- (provided that adjacent divalent carbon atoms are not replaced at the same time).

"L_{A}" denotes a group that binds X_{A} and -COO⁻ and may be a linking group represented by any one of the following general formulae (L_{A}-1) to (L_{A}-7). 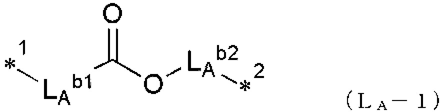 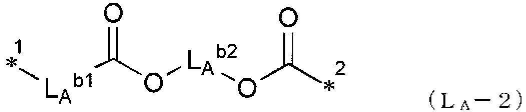 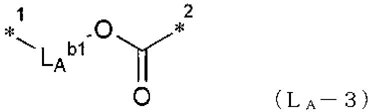 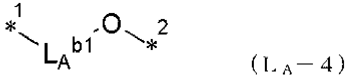 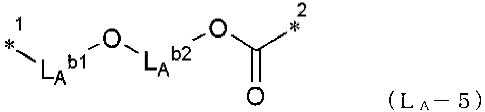 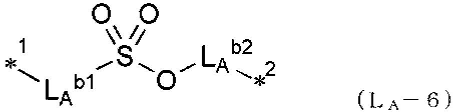 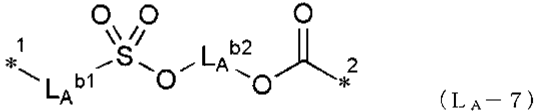 [In the formulae, L_{A}^{b1} and L_{A}^{b2} denote a single bond or a C₁₋₈ hydrocarbylene group optionally having a substituent, *1 denotes a linking portion to X_{A}, and *2 denotes a linking portion to -COO⁻.]

L_{A}^{b1} and L_{A}^{b2} are preferably a single bond, or a C₁₋₈ alkylene group or a C₆₋₈ arylene group each optionally having a substituent, and more preferably a single bond or a C₁₋₈ alkylene group optionally having a substituent.

### <Examples of Carboxylate Anion>

The carboxylate anion of the above-mentioned carboxylate compound B_{A} or B_{A1} is, for example, but not limited to, a trifluoroacetate anion, a pentafluoropropionate anion, a 2-methoxyacetate anion, a 2-methoxy-2-methylpropionate anion, a 2-hydroxyacetate anion, a 2-hydroxy-2-methylpropionate anion, a 2-acetoxyacetate anion, an adamantane-1-carboxylate anion, a 9,10-dihydro-9,10-ethanoanthracene-11-carboxylate anion, a 9,10-dihydro-9,10-[1,2]benzenoanthracene-9-carboxylate anion, a benzoate anion, a salicylate anion, a 3-hydroxybenzoate anion, a 3-trifluoromethylbenzoate anion, or the like.

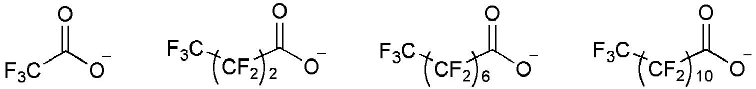

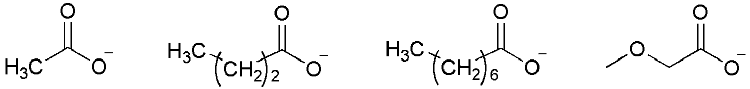

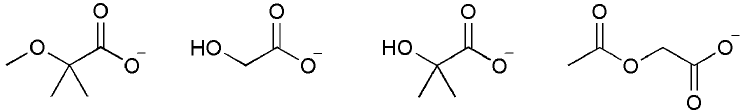

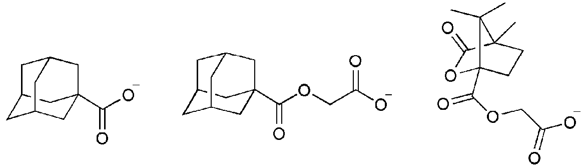

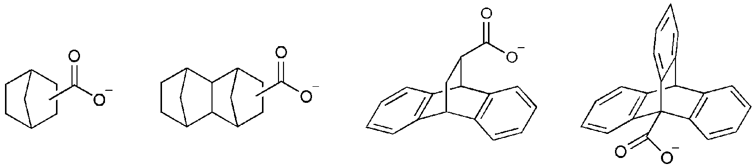

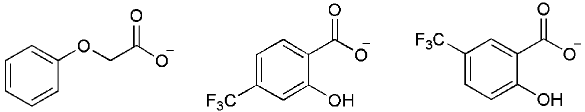

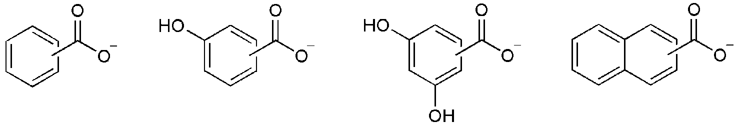

### [1-2-1-2. Sulfonate Compound B_{B}]

The (B1) photodegradable base can be a salt of a sulfonate anion and an onium cation or onium dication (D^{p+}), such as the "sulfonate compound B_{B}" represented by the following general formula (VIII-2).

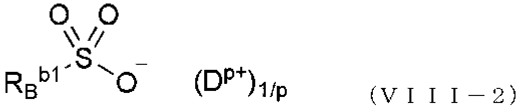

"R_{B}^{b1}" denotes an optionally substituted C₁₋₁₈ hydrocarbyl group, 3- to 18-membered non-aromatic heterocyclic group, or 5- to 18-membered aromatic heterocyclic group in which any divalent carbon atom except the terminal positions may be substituted with -O-, -C(=O)-, -C(=O)O-, -OCO-, - CONH-, -NHCO-, -S-, or -SO₂- (provided that adjacent divalent carbon atoms are not replaced at the same time).

Preferably, R_{B}^{b1} denotes a C₁₋₁₈ hydrocarbyl group optionally having a substituent, and any divalent carbon atom except the terminal positions may be substituted with -O-, -C(=O)-, -C(=O)O-, - OCO-, -CONH-, -NHCO-, -S-, or -SO₂- (provided that adjacent divalent carbon atoms are not substituted at the same time),
more preferably a C₁₋₁₈ alkyl group, a C₃₋₁₈ alicyclic group, a C₆₋₁₈ aryl group, or a C₇₋₁₈ aralkyl group, each optionally having a substituent, and any divalent carbon atom except the terminal positions may be substituted with -O-, -C(=O)-, -C(=O)O-, -OCO-, -CONH-, -NHCO-, -S-, or -SO₂-(provided that adjacent divalent carbon atoms are not substituted at the same time).

### <Sulfonate Compound B_{B1}>

The sulfonate compound B_{B} represented by the general formula (VIII-2) may be a sulfonate compound B_{B1} represented by the following general formula (VIII-2-1).

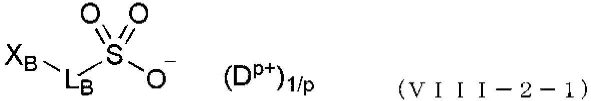

"X_{B}" is a C₁₋₁₈ alkyl group, a C₃₋₁₈ alicyclic group, a C₆₋₁₈ aryl group, or a C₇₋₁₈ aralkyl group, each optionally having a substituent, and any divalent carbon atom except the terminals may be substituted with -O-, -C(=O)-, -C(=O)O-, -OCO-, -CONH-, -NHCO-, -S-, or -SO₂- (provided that adjacent divalent carbon atoms are not substituted at the same time).

X_{B} preferably denotes a C₃₋₁₈ alicyclic group, a C₆₋₁₈ aryl group, or a C₇₋₁₈ aralkyl group each optionally having a substituent and any divalent carbon atom except the terminal positions may be substituted with -O-, -C(=O)-, -C(=O)O-, -OCO-, -CONH-, -NHCO-, -S-, or -SO₂- (provided that adjacent divalent carbon atoms are not replaced at the same time),
more preferably a C₃₋₁₈ alicyclic group or a C₆₋₁₈ aryl group each optionally having a substituent and any divalent carbon atom except the terminal positions may be substituted with -O-, - C(=O)-, -C(=O)O-, -OCO-, -CONH-, -NHCO-, -S-, or -SO₂- (provided that adjacent divalent carbon atoms are not replaced at the same time).

"L_{B}" denotes a group that binds X_{B} and -SO₂-O⁻ and may be a linking group represented by any one of the following general formulae (L_{B}-1) to (L_{B}-7). 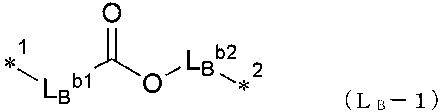 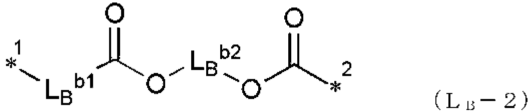 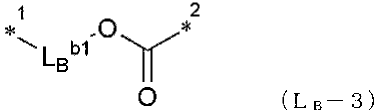 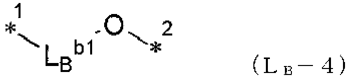 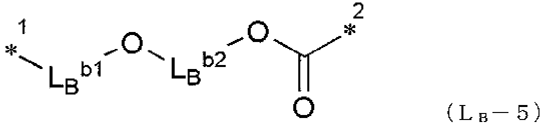 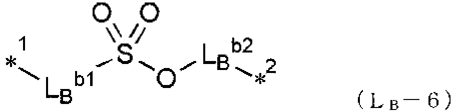 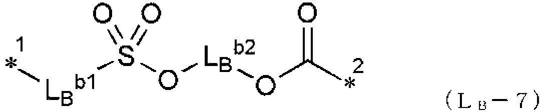 [In the formula, L_{B}^{b1} and L_{B}^{b2} represent a single bond or a C₁₋₈ hydrocarbylene group optionally having a substituent, *1 represents a linking site to X_{B}, and *2 represents a linking site to -SO₂-O⁻.]

L_{B}^{b1} and L_{B}^{b2} are preferably a single bond, or a C₁₋₈ alkylene group or a C₆₋₈ arylene group each optionally having a substituent, and more preferably a single bond or a C₁₋₈ alkylene group optionally having a substituent.

### <Example of Sulfonate Anion>

The sulfonate anion of the above-mentioned sulfonate compound B_{B} or B_{B1} is, for example, but not limited to, a camphorsulfonate anion, an (adamantan-1-yl)methanesulfonate anion, an (adamantane-1-carbonyloxy)ethane-1-sulfonate anion, a cyclohexane sulfonate anion, a 2-(cyclohexanecarbonyloxy)ethane-1-sulfonate anion, a bicyclo[2.2.1]heptane-2-sulfonate anion, a benzenesulfonate anion, a 4-methylbenzenesulfonate anion, or the like.

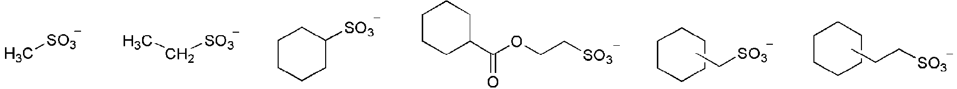

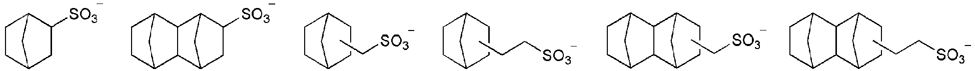

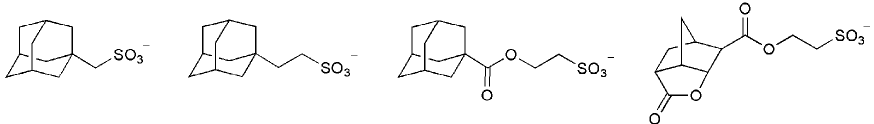

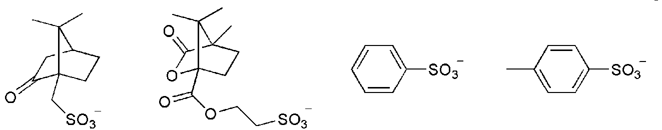

### [1-2-1-3. Sulfonyl Amide Salt Compound B_{C}]

The (B1) photodegradable base can be a salt of a sulfonyl amide anion and an onium cation or onium dication (D^{p+}), such as the "sulfonyl amide salt compound B_{C}" represented by the following general formula (VIII-3).

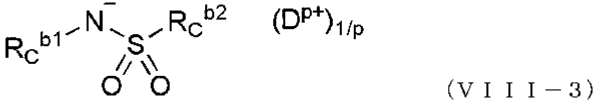

"R_{C}^{b1}" denotes an optionally substituted C₁₋₁₈ hydrocarbyl group, 3- to 18-membered non-aromatic heterocyclic group, or 5- to 18-membered aromatic heterocyclic group in which any divalent carbon atom except the terminal positions may be substituted with -O-, -C(=O)-, -C(=O)O-, -OCO-, - CONH-, -NHCO-, -S-, or -SO₂- (provided that adjacent divalent carbon atoms are not replaced at the same time).

"R_{C}^{b2}" denotes an optionally substituted C₁₋₁₈ hydrocarbyl group, and any divalent carbon atom except the terminal positions may be substituted with -O-, -C(=O)-, -C(=O)O-, -OCO-, -CONH-, -NHCO-, -S-, or -SO₂- (provided that adjacent divalent carbon atoms are not substituted at the same time).

Preferably, R_{C}^{b1} denotes a C₁₋₁₈ hydrocarbyl group optionally having a substituent, and any divalent carbon atom except the terminal positions may be substituted with -O-, -C(=O)-, -C(=O)O-, - OCO-, -CONH-, -NHCO-, -S-, or -SO₂- (provided that adjacent divalent carbon atoms are not substituted at the same time),
more preferably a C₁₋₁₈ alkyl group, a C₃₋₁₈ alicyclic group, a C₆₋₁₈ aryl group, or a C₇₋₁₈ aralkyl group, each optionally having a substituent, and any divalent carbon atom except the terminal positions may be substituted with -O-, -C(=O)-, -C(=O)O-, -OCO-, -CONH-, -NHCO-, -S-, or -SO₂-(provided that adjacent divalent carbon atoms are not substituted at the same time).

R_{C}^{b2} is preferably a C₁₋₁₈ alkyl group or a C₃₋₁₈ alicyclic group each optionally having a substituent, in which any divalent carbon atom except the terminals may be substituted with -O-, - C(=O)-, -C(=O)O-, -OCO-, -CONH-, -NHCO-, -S-, or -SO₂- (provided that adjacent divalent carbon atoms are not substituted at the same time), more preferably a C₁₋₁₂ haloalkyl group, and still more preferably a C₁₋₅ fluorinated alkyl group.

### <Sulfonyl Amide Salt Compound B_{C1}>

The sulfonyl amide salt compound B_{C} represented by the general formula (VIII-3) may be a sulfonyl amide salt compound B_{C1} represented by the following general formula (VIII-3-1).

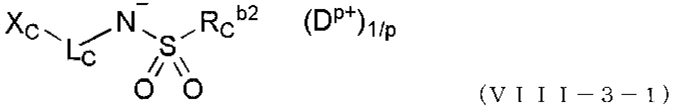

"X_{C}" is a C₁₋₁₈ alkyl group, a C₃₋₁₈ alicyclic group, a C₆₋₁₈ aryl group, or a C₇₋₁₈ aralkyl group, each optionally having a substituent, and any divalent carbon atom except the terminals may be substituted with -O-, -C(=O)-, -C(=O)O-, -OCO-, -CONH-, -NHCO-, -S-, or -SO₂- (provided that adjacent divalent carbon atoms are not substituted at the same time).

X_{C} preferably denotes a C₃₋₁₈ alicyclic group, a C₆₋₁₈ aryl group, or a C₇₋₁₈ aralkyl group each optionally having a substituent and any divalent carbon atom except the terminal positions may be substituted with -O-, -C(=O)-, -C(=O)O-, -OCO-, -CONH-, -NHCO-, -S-, or -SO₂- (provided that adjacent divalent carbon atoms are not replaced at the same time),
more preferably a C₃₋₁₈ alicyclic group or a C₆₋₁₈ aryl group each optionally having a substituent and any divalent carbon atom except the terminal positions may be substituted with -O-, - C(=O)-, -C(=O)O-, -OCO-, -CONH-, -NHCO-, -S-, or -SO₂- (provided that adjacent divalent carbon atoms are not replaced at the same time).

"L_{C}" denotes a group that binds X_{C} and -N⁻-SO₂-R_{C}^{b2} and may be a linking group represented by any one of the following general formulae (L_{C}-1) to (L_{C}-7). 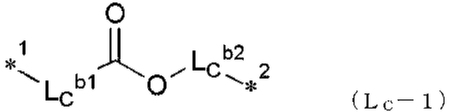 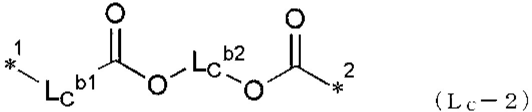 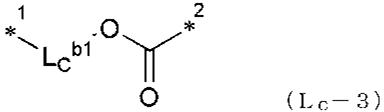 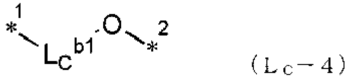 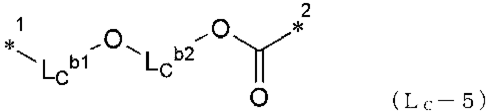 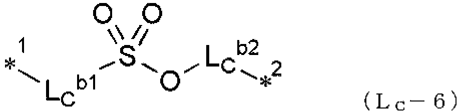 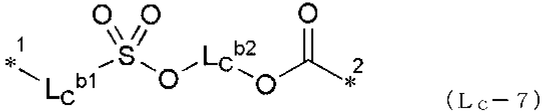 [In the formula, L_{C}^{b1} and L_{C}^{b2} represent a single bond or a C₁₋₁₂ hydrocarbylene group optionally having a substituent, *1 represents a linking site to X_{C}, and *2 represents a linking site to -N⁻-SO₂-R_{C}^{b2}.]

L_{C}^{b1} and L_{C}^{b2} are preferably a single bond, or a C₁₋₁₂ alkylene group, a C₁₋₁₂ cycloalkylene group, or a C₆₋₁₂ arylene group, each optionally having a substituent, and more preferably a single bond, or a C₁₋₈ alkylene group or a C₁₋₈ cycloalkylene group each optionally having a substituent.

### <Examples of Sulfonylamide Anion>

Examples of the sulfonylamide anion of the sulfonylamide salt compound B_{C} or B_{C1} include, but are not particularly limited to, a methyl((trifluoromethyl)sulfonyl)amide anion, an i-propyl((trifluoromethyl)sulfonyl)amide anion, a methacryloyloxy((trifluoromethyl)sulfonyl)amide anion, a 2-(methacryloyloxy)ethyl((trifluoromethyl)sulfonyl)amide anion, a cyclohexyl((trifluoromethyl)sulfonyl)amide anion, a 2-((cyclopentanecarbonyl)oxy)ethyl((trifluoromethyl)sulfonyl)amide anion, a 2-((cyclohexanecarbonyl)oxy)ethyl((trifluoromethyl)sulfonyl)amide anion, a bicyclo[2.2.1]heptan-2-ylmethyl((trifluoromethyl)sulfonyl)amide anion, a bicyclo[2.2.1]heptan-7-ylmethyl((trifluoromethyl)sulfonyl)amide anion, a 2-((adamantan-1-carbonyl)oxy)ethyl((trifluoromethyl)sulfonyl)amide anion, a 2-(adamantan-1-carboxamido)ethyl((trifluoromethyl)sulfonyl)amide anion, a 2-(4-((adamantan-1-carbonyl)oxy)cyclohexyl)ethyl((trifluoromethyl)sulfonyl)amide anion, and a 4-((adamantan-1-carbonyl)oxy)phenyl((trifluoromethyl)sulfonyl)amide anion.

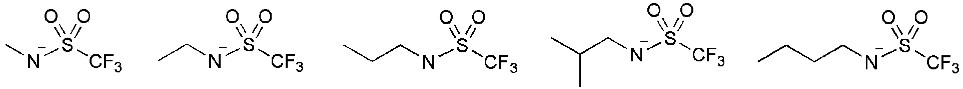

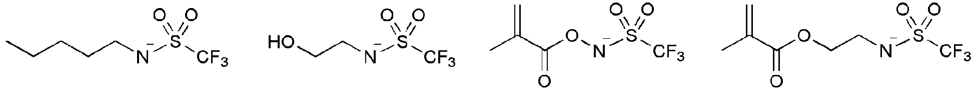

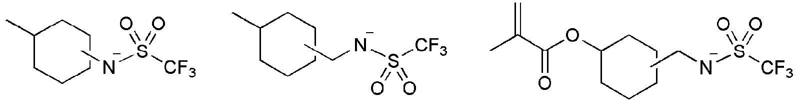

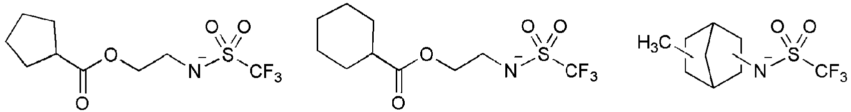

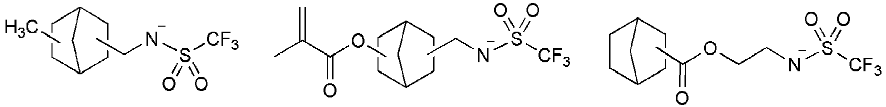

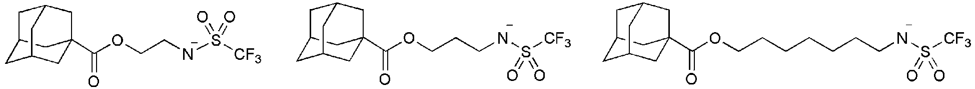

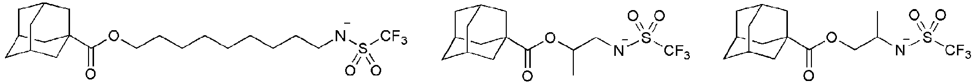

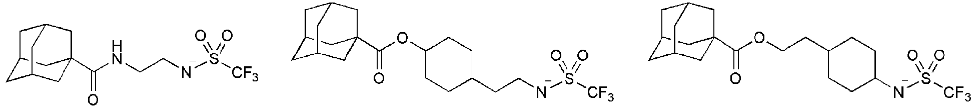

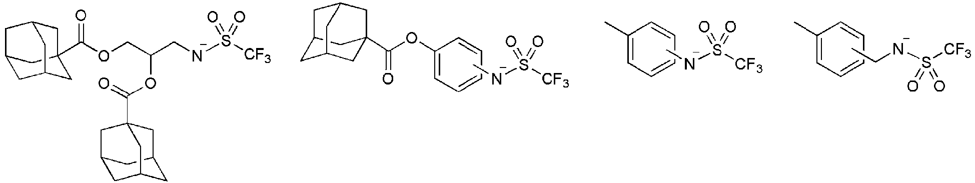

### [1-2-1-4. Onium Cation or Dication (D^{p+})]

The (B1) photodegradable base can have an onium cation or dication (D^{p+}) as a cation moiety. In "(D^{p+})_{1/p}" represented by the general formulae (VIII-1) to (VIII-3), D denotes an onium cation or dication, and p denotes an integer of 1 or 2.

The onium cation or dication is not particularly limited and may be an organic sulfonium cation, an organic sulfonium dication, an organic iodonium cation, an organic quaternary ammonium cation, an organic quaternary ammonium dication, an organic phosphonium cation, an organic phosphonium dication, or the like.

The onium cation or dication (D^{p+}) can be, for example, an organic sulfonium cation represented by the following general formula (IX-1).

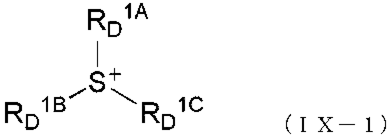

In general formula (IX-1), R_{D}^{1A}, R_{D}^{1B}, and R_{D}^{1C} each independently denote a hydro group, an optionally substituted C₁₋₁₈ hydrocarbyl group, an optionally substituted 3- to 18-membered non-aromatic heterocyclic group, or an optionally substituted 5- to 18-membered aromatic heterocyclic group,
a divalent carbon atom at any position of R_{D}^{1A}, R_{D}^{1B}, and R_{D}^{1C} except the terminal positions may be substituted with -O-, -C(=O)-, -C(=O)O-, -OCO-, -CONH-, -NHCO-, -NH(C=O)O-, -S-, or - SO₂- (provided that adjacent divalent carbon atoms are not substituted at the same time);
any two of R_{D}^{1A}, R_{D}^{1B}, and R_{D}^{1C} may be bonded to each other directly by a single bond or via a divalent linking group -O-, -S-, -C(=O)-, -S(=O)-, -S(=O)₂-, -C(=O)O-, or a C₁₋₃ alkylene group to form a ring together with a sulfur atom in the formula (IX-1).

The onium cation or dication (D^{p+}) can be, for example, an organic sulfonium dication represented by the following general formula (IX-2).

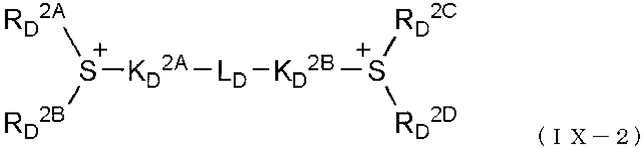

In general formula (IX-2), R_{D}^{2A}, R_{D}^{2B}, R_{D}^{2C}, and R_{D}^{2D} each independently denote a C₁₋₁₈ hydrocarbyl group, a 3- to 18-membered non-aromatic heterocyclic group, or a 5- to 18-membered aromatic heterocyclic group, the hydrocarbyl group and the heterocyclic groups each optionally having a substituent, and
a divalent carbon atom at any position of R_{D}^{2A}, R_{D}^{2B}, R_{D}^{2C}, and R_{D}^{2D} except the terminal positions may be substituted with -O-, -C(=O)-, -C(=O)O-, -OCO-, -CONH-, -NHCO-, -NH(C=O)O-, - S-, or -SO₂- (provided that adjacent divalent carbon atoms are not substituted at the same time);
K_{D}^{2A}, K_{D}^{2B}, and L_{D} each independently represent a C₁₋₁₈ hydrocarbylene group optionally having a substituent, and
a divalent carbon atom at any position of K_{D}^{2A}, K_{D}^{2B}, and L_{D} may be substituted with -O-, - C(=O)-, -C(=O)O-, -OCO-, -CONH-, -NHCO-, -S-, or -SO₂- (provided that adjacent divalent carbon atoms are not substituted at the same time); and
any two of R_{D}^{2A}, R_{D}^{2B}, and K_{D}^{2A} and/or any two of R_{D}^{2C}, R_{D}^{2D}, and K_{D}^{2B} may be linked to each other directly by a single bond or via a divalent linking group -O-, -S-, -C(=O)-, -S(=O)-, - S(=O)₂-, -C(=O)O-, or a C₁₋₃ alkylene group to form a ring together with a sulfur atom in formula (IX-2).

The onium cation or dication (D^{p+}) can be, for example, an organic iodonium cation represented by the following general formula (IX-3).

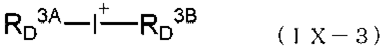

In general formula (IX-3), R_{D}^{3A} and R_{D}^{3B} each independently denote a C₁₋₁₈ hydrocarbyl group, a 3- to 18-membered non-aromatic heterocyclic group, or a 5- to 18-membered aromatic heterocyclic group, the hydrocarbyl group and the heterocyclic groups each optionally having a substituent, and
a divalent carbon atom at any position of R_{D}^{3A} and R_{D}^{3B} except the terminal positions may be substituted with -O-, -C(=O)-, -C(=O)O-, -OCO-, -CONH-, -NHCO-, -NH(C=O)O-, -S-, or -SO₂-(provided that adjacent divalent carbon atoms are not substituted at the same time);
R_{D}^{3A} and R_{D}^{3B} may be bonded to each other directly by a single bond or via a divalent linking group -O-, -S-, -C(=O)-, -S(=O)-, -S(=O)₂-, -C(=O)O-, or a C₁₋₃ alkylene group to form a ring together with the iodine atom in the formula (IX-3).

### [1-2-2. (B2) Nitrogen-containing Organic Compound]

As another (B) acid diffusion control agent, (B2) a nitrogen-containing organic compound that does not correspond to (B1) may be contained. The nitrogen-containing organic compound is not particularly limited, and, for example, an aliphatic amine, an aromatic amine, a heterocyclic amine, or the like can be used.

Examples of the nitrogen-containing organic compound include aliphatic amines such as n-hexylamine, n-heptylamine, diethylamine, di-n-propylamine, di-n-butylamine, triethylamine, tri-n-propylamine, tri-n-butylamine, tri-n-pentylamine, and tri-n-octylamine; aromatic amines such as aniline, N-methylaniline, N-ethylamine, N,N-dimethylaniline, 4-methylaniline, and pyrrole; and heterocyclic amines such as pyridine, imidazole, benzimidazole, piperidine, piperazine, 1,5-diazabicyclo[4.3.0]-5-nonene, 1,8-diazabicyclo[5.4.0]-7-undecene, hexamethylenetetramine, and 1,4-diazabicyclo[2.2.2]octane.

These nitrogen-containing organic compounds may be used alone or in combination of two or more thereof.

### [1-2-3. Blending Amount]

The content of the (B) acid diffusion control agent in the resist material according to the present embodiment is not particularly limited and can be appropriately selected depending on the content, type, or the like of the component (A). The content of the component (B) in the resist material is preferably 0.1 to 30 parts by mass, more preferably 0.2 to 25 parts by mass, and still more preferably 0.5 to 20 parts by mass relative to 100 parts by mass of the component (A).

### [1-3. Organic Solvent]

The resist material according to the present embodiment may further contain an organic solvent. The organic solvent is not particularly limited and may be a known and commonly used one. The organic solvent is preferably an organic solvent that can uniformly dissolve or disperse the (A) heteropolyacid salt having a modified lacunary site or the mixture thereof during preparation.

Examples of the organic solvent include a polar solvent, such as an alcohol solvent, an ether solvent, a ketone solvent, an amide solvent, an ester solvent, a nitrile solvent, or an aprotic polar solvent, and a nonpolar solvent, such as a hydrocarbon solvent. These organic solvents may be used alone or in combination of two or more types thereof.

Specific examples of the polar solvent include an alcohol solvent, such as methanol, ethanol, isopropyl alcohol (IPA), diacetone alcohol (DAA), 3-methoxybutanol, 3-methyl-3-methoxybutanol, 1-methoxy-2-propanol, 4-methyl-2-pentanol, ethylene glycol, diethylene glycol, propylene glycol, dipropylene glycol, or propylene glycol monomethyl ether (PGME);
an ether solvent, such as diethyl ether, dipropyl ether, dibutyl ether, diisoamyl ether, tetrahydrofuran, anisole, propylene glycol monoethyl ether, ethylene glycol monomethyl ether, or ethylene glycol monoethyl ether;
   a ketone solvent, such as acetone, methyl ethyl ketone, cyclopentanone, cyclohexanone, methyl n-pentyl ketone, methyl isopentyl ketone, 2-heptanone, acetophenone, propylene carbonate, or furfural;
an amide solvent, such as N,N-dimethylformamide, N,N-diethylformamide, acetamide, N-methylpyrrolidone, 1-ethyl-2-pyrrolidone, or 1-butyl-2-pyrrolidone;
an ester solvent, such as methyl lactate, ethyl lactate (EL), methyl acetate, ethyl acetate, methyl pyruvate, ethyl pyruvate, methyl methoxypropionate, or propylene glycol monomethyl ether acetate (PGMEA);
a nitrile solvent, such as acetonitrile, propionitrile, or benzonitrile; and
an aprotic polar solvent, such as γ-butyrolactone, δ-valerolactone, γ-lactam, δ-lactam, dimethyl sulfoxide (DMSO), sulfolane, 1,3-dimethyl-2-imidazolidinone, or tetramethylurea; and
the nonpolar solvent may be a hydrocarbon solvent, such as n-pentane, n-hexane, toluene, or xylene; or the like.

These organic solvents may be used alone or in combination of two or more types thereof.

The organic solvent to be contained in the resist material according to the present embodiment is preferably a polar solvent from the perspective of coatability, more preferably an amide solvent, an ester solvent, an alcohol solvent, or a ketone solvent from the perspective of solubility. The amide solvent is preferably at least one selected from the group consisting of N,N-dimethylformamide, N,N-diethylformamide, acetamide, and N-methylpyrrolidone. Furthermore, from the perspective of solubility, the ester solvent or the alcohol solvent preferably has an ester bond and/or a hydroxy group, and among those described above, at least one selected from the group consisting of propylene glycol monomethyl ether, methyl lactate, ethyl lactate, methyl acetate, ethyl acetate, methyl pyruvate, ethyl pyruvate, and propylene glycol monomethyl ether acetate is preferred.

The organic solvent content of the resist material is not particularly limited and can be appropriately determined according to the method for applying the resist material to a substrate or the like, the thickness of the film to be applied, or the like. The organic solvent content of the resist material is such that the solid concentration of the resist material preferably ranges from 0.01% to 20% by mass, more preferably 0.1% to 15% by mass, still more preferably 0.2% to 10% by mass.

### [1-4. Others]

If desired, the resist material according to the present embodiment can appropriately contain, as a miscible additive agent, for example, an additional resin for improving the performance of a resist film, a dissolution inhibitor, a plasticizer, a stabilizer, a colorant, an antihalation agent, a dye, or the like.

The resist material according to the present embodiment preferably does not contain an epoxy resin. Furthermore, hydrogen peroxide is also preferably not contained.

### [2. Pattern Formation Method]

The pattern formation method according to the present embodiment includes a step of applying a resist material to a substrate, a step of exposing a resist film formed by the application step to light, and a step of developing the exposed resist film.

### [2-1. Application Step]

The pattern formation method according to the present embodiment includes the step of applying a resist material to a substrate.

### <Substrate>

The substrate used in the present embodiment is not particularly limited and can be a known and commonly used substrate. The substrate is, for example, a substrate for an electronic component, a substrate on which a predetermined wiring pattern is formed, or the like

The material of the substrate is, for example, but not limited to, a silicon wafer, a substrate made of a metal, such as copper, chromium, iron, or aluminum, a substrate made of an inorganic substance, such as glass, titanium oxide, or silicon dioxide, or the like.

The substrate may have any size, shape, or the like, may have a smooth, curved, or rough surface, and may be a flaky substrate or the like.

The surface of the substrate may be subjected to a surface treatment as necessary. In the case of a substrate having a hydroxy group on a surface layer thereof, the surface of the substrate may be treated with a silane coupling agent capable of reacting with the hydroxy group to change the surface layer of the substrate from hydrophilic to hydrophobic, thereby enhancing the adhesion between the substrate and a film containing a metal compound. The silane coupling agent is, for example, hexamethyldisilazane (HMDS) or the like.

### <Application Method>

The method for applying the resist material to a substrate is not particularly limited and can be a known and commonly used method. The application method includes a dry method, for example, a chemical vapor deposition (CVD) method, such as thermal CVD, plasma CVD, or photo-CVD; a physical vapor deposition (PVD) method, such as vacuum deposition, plasma-assisted vapor deposition, sputtering, or ion plating; or the like. A wet method, for example, a coating method, such as spin coating, bar coating, roll coating, flow coating, dip coating, spray coating, ink jet printing, or screen printing, can also be used.

From the perspective of forming a film with a uniform thickness or the like, the method for applying the resist material according to the present embodiment to a substrate is preferably a wet method, such as a spin coating method or screen printing, more preferably a spin coating method. After the coating film is formed, a backside rinse step, an edge bead removal step, or the like may be performed to remove an edge bead.

A resist film formed by applying the resist material to a substrate may be dried by any method, for example, using a heater (post-apply bake (PAB)), such as a hot plate, or a pressure reduction apparatus.

The baking conditions are not particularly limited and can be appropriately determined according to the type, application, or the like of the resist film. The baking temperature preferably ranges from 80°C to 300°C, more preferably 80°C to 200°C, still more preferably 80°C to 130°C. The baking time preferably ranges from 10 seconds to 300 seconds, more preferably 20 seconds to 180 seconds, still more preferably 30 seconds to 120 seconds.

The thickness of the resist film after drying is preferably, but not limited to, in the range of 0.5 to 100 nm, more preferably 1 to 75 nm, still more preferably 1 to 60 nm.

### [2-2. Exposure Step]

The pattern formation method according to the present embodiment includes a step of exposing the resist film formed by the application step to light.

As an exposure apparatus in the exposure step of the resist film, for example, an ArF exposure apparatus, an electron-beam lithography system, an EUV exposure apparatus, or the like can be used. Furthermore, in the exposure step, exposure may be performed through a mask (mask pattern) on which a predetermined pattern is formed, or selective exposure may be performed by drawing or the like by direct irradiation with an electron beam without using a mask pattern.

The exposure wavelength is not particularly limited, and radiation, such as an ArF excimer laser (wavelength: 193 nm), a KrF excimer laser (248 nm), an F₂ excimer laser (wavelength: 157 nm), extreme ultraviolet (EUV), vacuum ultraviolet (VUV), an electron beam (EB), X-rays, soft X-rays, or the like may be used.

For an ArF excimer laser or a KrF excimer laser, the exposure level on the resist film preferably ranges from 1 to 200 mJ/cm², more preferably 20 to 60 mJ/cm². Furthermore, for extreme ultraviolet, the exposure level is, for example, 500 mJ/cm² or less, preferably 0.1 to 200 mJ/cm², more preferably 3 to 100 mJ/cm², still more preferably 5 to 50 mJ/cm².

For an electron beam, exposure at a dose in the range of 3 µC/cm² to 2 mC/cm² at 50 kV is preferred, and exposure at a dose in the range of 10 µC/cm² to 1.5 mC/cm² is more preferred.

After the resist film is exposed to light, a baking (post-exposure bake (PEB)) treatment may or may not be performed. The baking conditions are not particularly limited and can be appropriately determined according to the type, application, or the like of the resist film. The baking temperature preferably ranges from 80°C to 300°C, more preferably 80°C to 200°C, still more preferably 80°C to 130°C, using a heater, such as a hot plate. The baking time preferably ranges from 10 seconds to 300 seconds, more preferably 20 seconds to 180 seconds, still more preferably 30 seconds to 120 seconds.

### [2-3. Development Step]

The pattern formation method according to the present embodiment includes the step of developing the exposed resist film. In the development step, the exposed resist film can be developed with a developer to form a pattern. A case where the exposed region remains as a pattern after development is a negative patterning process, and a case where the exposed region is removed after development is a positive patterning process. Whether a positive or negative pattern is formed can be appropriately selected depending on the resist material or the developer. Furthermore, the development may be followed by washing with a rinse liquid and drying, and in some cases, further followed by a baking treatment.

As the developer used in the present embodiment, an alkali developer may be used as a developer for an alkali development process, and a developer containing an organic solvent (organic developer) may be used as a developer for an organic solvent development process.

### <Alkali Development Process>

The alkali developer used in the alkali development process is not particularly limited, and a known and commonly used alkali developer can be used. Examples of the alkali developer include aqueous solutions containing one or more of quaternary ammonium salts such as tetramethylammonium hydroxide and (2-hydroxyethyl)trimethylammonium hydroxide; inorganic alkalis such as sodium hydroxide and potassium hydroxide; and alkanolamines such as dimethylethanolamine and triethanolamine.

As the rinsing liquid in the alkali development process, pure water can be used.

### <Organic Solvent Development Process>

Examples of the developer used in the organic solvent development process include developers containing one or more organic solvents such as polar solvents, e.g., ketone solvents, ester solvents, alcohol solvents, nitrile solvents, amide solvents, and ether solvents, and hydrocarbon solvents.

Specific examples of the organic solvent include:
a ketone solvent, such as acetone, methyl ethyl ketone, cyclopentanone, cyclohexanone, methyl n-pentyl ketone, methyl isopentyl ketone, 2-heptanone, acetophenone, propylene carbonate, or furfural;
an ester solvent, such as methyl lactate, ethyl lactate (EL), methyl acetate, ethyl acetate, methyl pyruvate, ethyl pyruvate, methyl methoxypropionate, or propylene glycol monomethyl ether acetate (PGMEA);
an alcohol solvent, such as methanol, ethanol, isopropyl alcohol (IPA), diacetone alcohol (DAA), 3-methoxybutanol, 3-methyl-3-methoxybutanol, 1-methoxy-2-propanol, 4-methyl-2-pentanol, ethylene glycol, diethylene glycol, propylene glycol, dipropylene glycol, or propylene glycol monomethyl ether (PGME);
a nitrile solvent, such as acetonitrile, propionitrile, or benzonitrile;
an amide solvent, such as N,N-dimethylformamide, N,N-diethylformamide, acetamide, N-methylpyrrolidone, 1-ethyl-2-pyrrolidone, or 1-butyl-2-pyrrolidone;
an ether solvent, such as diethyl ether, dipropyl ether, dibutyl ether, diisoamyl ether, tetrahydrofuran, anisole, propylene glycol monoethyl ether, ethylene glycol monomethyl ether, or ethylene glycol monoethyl ether; and
a hydrocarbon solvent, such as n-pentane, n-hexane, toluene, or xylene.
These may be used alone or in combination of two or more types thereof.

Among these, the organic solvent used in the developer is preferably a polar solvent, preferably contains an amide solvent, an alcohol solvent, or an ester solvent, more preferably contains an amide solvent or an ester solvent and an alcohol solvent.
The amide solvent is preferably at least one selected from the group consisting of N,N-dimethylformamide, N,N-diethylformamide, acetamide, and N-methylpyrrolidone.

Furthermore, the ester solvent is preferably one or more selected from the group consisting of methyl lactate, ethyl lactate (EL), methyl acetate, ethyl acetate, methyl pyruvate, ethyl pyruvate, methyl methoxypropionate, and propylene glycol monomethyl ether acetate.

The alcohol solvent is preferably at least one selected from the group consisting of ethanol, isopropyl alcohol (IPA), diacetone alcohol (DAA), 3-methoxybutanol, 3-methyl-3-methoxybutanol, 1-methoxy-2-propanol, 4-methyl-2-pentanol, benzyl alcohol, and 4-methylbenzyl alcohol.

In a case where the developer contains both an amide solvent or an ester solvent and an alcohol solvent, the blend ratio (weight ratio) of the amide solvent or the ester solvent to the alcohol solvent preferably ranges from 5:95 to 95:5, more preferably 10:90 to 90: 10.

The method for developing the exposed resist film using the developer is not particularly limited and can be a known and commonly used method. The method of developing using the developer is, for example, a method of immersing the substrate having the exposed resist film in the developer for a certain period (dip method), a method of spraying the developer on the surface of the exposed resist film (spray method), a method of discharging the developer from a discharge nozzle at a constant speed toward the surface of the exposed resist film on the substrate rotating at a constant speed (dynamic dispense method), or the like.

The development with the developer may be followed by a step of washing with a rinse liquid. The rinse liquid is not particularly limited and may be a known and commonly used rinse liquid. As the rinse liquid, among water or the organic solvent(s) in the developer, a solvent that is less likely to dissolve the resist pattern can be appropriately selected and used.

The rinse liquid is, for example, but not limited to, at least one organic solvent selected from the group consisting of a hydrocarbon solvent, a ketone solvent, an ester solvent, an alcohol solvent, an amide solvent, and an ether solvent. Among these, the rinse liquid is preferably at least one organic solvent selected from the group consisting of a hydrocarbon solvent, a ketone solvent, an ester solvent, an alcohol solvent, and an amide solvent, more preferably at least one selected from the group consisting of an alcohol solvent and an ester solvent, still more preferably at least one alcohol solvent.

The alcohol solvent used in the rinse liquid is preferably a monohydric alcohol with 2 to 8 carbon atoms, and the monohydric alcohol may be linear, branched, or cyclic. Specific examples of the monohydric alcohol include ethanol, isopropyl alcohol (IPA), butanol, 1-hexanol, 1-heptanol, 1-octanol, 2-hexanol, 2-heptanol, 2-octanol, 3-hexanol, 3-heptanol, 3-octanol, 4-octanol, and benzyl alcohol.

These organic solvents may be used alone or in combination of two or more types thereof.

The method for washing the resist pattern with the rinse liquid is not particularly limited and can be a known and commonly used method. The method of washing using the rinse liquid is, for example, a method of immersing the resist pattern in the rinse liquid for a certain period (dip method), a method of spraying the rinse liquid onto the surface of the resist pattern (spray method), and a method of discharging the rinse liquid from a discharge nozzle at a constant speed toward the surface of the resist pattern rotating at a constant speed (dynamic dispense method), or the like.

### [3. Patterned Structure]

A patterned structure according to the present embodiment is produced by forming a pattern of the resist material on a substrate by the pattern formation method.

The average thickness of part or all of the patterned structure according to the present embodiment is not particularly limited and can be appropriately determined depending on the intended use or the like. The patterned structure preferably has a portion with an average thickness in the range of 1 to 100 nm, more preferably has a portion with an average thickness in the range of 5 to 75 nm, and still more preferably has a portion with an average thickness in the range of 10 to 60 nm.

The pitch of part or all of the patterned structure according to the present embodiment is not particularly limited and can be appropriately determined depending on the intended use or the like. The patterned structure preferably has a portion with a pitch of 100 nm or less, more preferably has a portion with a pitch of 50 nm or less, and still more preferably has a portion with a pitch of 20 nm or less.

The resist material according to the present embodiment can be patterned by the pattern formation method to form a portion with a pitch of 50 nm, a portion with a pitch of 20 nm, and a portion with a pitch of 15 nm in part or all of the patterned structure.

### [4. Resist Material for Electron Beam or EUV]

The resist material according to the present embodiment contains a heteropolyacid salt having a modified lacunary site or a mixture thereof. The heteropolyacid salt having a modified lacunary site or the mixture thereof has an anion moiety into which a heteropolyacid anion having a modified lacunary site is introduced. Thus, the heteropolyacid salt having a modified lacunary site or the mixture thereof has good sensitivity to electron beam and EUV sources and can be suitably used as a resist material for these exposure sources.

Furthermore, by introducing a polar group having an acid-dissociable group into the anion moiety of the heteropolyacid salt having a modified lacunary site or the mixture thereof, it is possible to impart a function of changing the solubility in a developer by the action of an acid or the like. Thus, the resist material containing the heteropolyacid salt having a modified lacunary site or the mixture thereof can be suitably used as a resist material for an electron beam or EUV.

Furthermore, the function of generating an acid upon exposure to an electron beam or EUV can be provided by introducing a sulfonium cation, a sulfonium dication, or an iodonium cation into the cation moiety of the heteropolyacid salt having a modified lacunary site or the mixture thereof. Thus, the resist material containing the heteropolyacid salt having a modified lacunary site or the mixture thereof can be suitably used as a resist material for an electron beam or EUV.

### EXAMPLES

The present invention will be more specifically described below with reference to examples, but the present invention is not limited to these examples.

### [1. Synthesis of Heteropolyacid Salt Having Modified Lacunary Site (Polyacid Salt)]

Polyacid salts (A-1) to (A-20) were synthesized by the following methods.

### <Production Example 1: Potassium Undecatungstosilicate (α-K₈[SiW₁₁O₃₉])

380 g of 1 M acetic acid was added to 63 g of silicotungstic acid hydrate (manufactured by Nippon Inorganic Colour & Chemical Co., Ltd.: H₄[SiW₁₂O₄₀]·xH₂O), and the reaction liquid was heated to 45°C. The pH was adjusted to 6.0 by addition of potassium hydrogen carbonate (52 g). The reaction liquid was then cooled to room temperature and was suction-filtered to prepare 56 g of a crude product. 216 g of pure water was added to the crude product, followed by heating to 73°C to redissolve the crude product. The solution was cooled at 4°C for 16 hours to recrystallize, and the resulting crystals were suction-filtered and dried under vacuum to yield 34 g of the target compound. ²⁹Si-NMR (119.22 MHz, D₂O): δ(ppm)= -84.6(s, 1Si).
¹⁸³W-NMR (20.84 MHz, D₂O): δ(ppm)= -101.85(s, 2W), -116.26(s, 2W), -119.29(s, 1W), -125.62(s, 2W), -140.85(s, 2W), -174.53(s, 2W).

### <Synthesis Example 1: tetrakis(bis(2-trifluoromethylphenyl)phenylsulfonium)(1,3-di(4-methoxymethoxyphenyl)disiloxane-1,1,3,3-tetrayl)undecatungstosilicate (polyacid salt (A-1))>

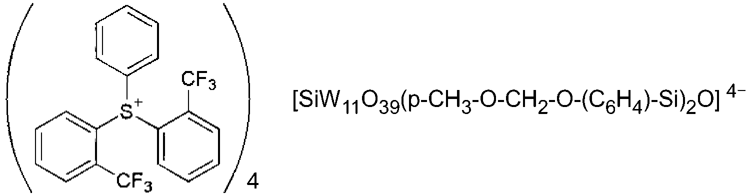

2.8 g (10.9 mmol) of 4-methoxymethoxyphenyltrimethoxysilane was added to a mixed solvent of 402 g of acetonitrile and 184 g of pure water, and 10.9 g (3.6 mmol) of the synthesized mono-lacunary Keggin-type potassium undecatungstosilicate (α-K₈[SiW₁₁O₃₉]) was added thereto. The pH was adjusted to 1.8 using 1 M hydrochloric acid. After stirring for 2 hours, the unreacted powder was filtered off by suction filtration, and the filtrate was concentrated to approximately 200 g using a rotary evaporator. A solution of 9.9 g (18.2 mmol) of bis(2-trifluoromethylphenyl)phenylsulfonium chloride dissolved in 40 g of pure water was added to the concentrate to precipitate a powder. The precipitated powder was filtered off by suction filtration and was washed three times each with 180 mL of pure water, 180 mL of methanol, and 180 mL of methyl-t-butyl ether. The powder was then dispersed and washed with 160 g of methanol for 3 hours, was filtered off again by suction filtration, and was washed with 160 g of methanol three times. Furthermore, the powder was sufficiently dried under vacuum to yield 15.8 g of the target compound, a polyacid salt (A-1), as a white powder.
¹H-NMR (400 MHz, DMSO-d6): δ(ppm)=3.37(s, 6H), 5.22(s, 4H), 7.05(d, 4H), 7.65-8.35(m, 56H). ²⁹Si-NMR (119.22 MHz, DMSO-d6): δ(ppm)=-64.72(s, 2Si), -85.02(s, 1Si).
ESI-MS: POSITIVE m/z 399.1 ([C₂₀H₁₃F₆S]⁺)
   NEGATIVE m/z 755.1 (median) ([C₁₆H₁₈O₄₄Si₃W₁₁]⁴⁻)

### <Synthesis Example 2: tetrakis(bis(2-trifluoromethylphenyl)phenylsulfonium)(1,3-di(2-((1-methylcyclopentyl)oxycarbonyl)ethyl)disiloxane-1,1,3,3-tetrayl)undecatungstosilicate (polyacid salt (A-2))>

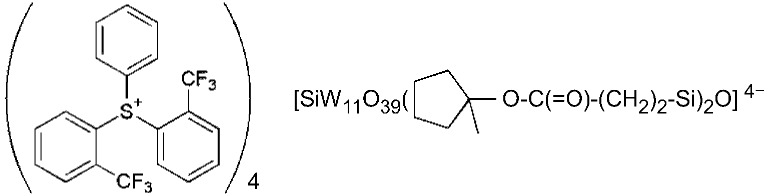

A polyacid salt (A-2) was produced as a target compound in the same manner as in Synthesis Example 1 except that 2-((1-methylcyclopentyl)oxycarbonyl)ethyltrimethoxysilane was used as a raw material compound instead of 4-methoxymethoxyphenyltrimethoxysilane.
¹H-NMR (400 MHz, DMSO-d6): δ(ppm)=0.77-0.81(m, 4H), 1.49-1.84(m, 22H), 2.37-2.42(m, 4H), 7.65-8.35(m, 52H).
²⁹Si-NMR (119.22 MHz, DMSO-d6): δ(ppm)=-53.12(s, 2Si), -85.01(s, 1Si).
ESI-MS: POSITIVE m/z 399.1 ([C₂₀H₁₃F₆S]⁺)
   NEGATIVE m/z 764.4 (median) ([C₁₈H₃₀O₄₄Si₃W₁₁]⁴⁻)

### <Production Example 2: 3-(2-(1-methylcyclopentyloxycarbonyl)ethylthio)propyltrimethoxysilane>

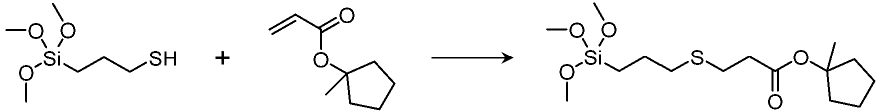

20 mL of methyl ethyl ketone was added to 7.7 g of 1-methylcyclopentyl acrylate and 9.8 g of 3-mercaptopropyltrimethoxysilane, and 0.3 g of 1,1'-azobis(cyclohexane-1-carbonitrile) was added thereto, followed by uniform stirring. Nitrogen was then blown thereinto for 30 minutes for nitrogen bubbling. The reaction liquid was heated from room temperature to 90°C over 30 minutes in nitrogen. The reaction liquid was kept at 90°C for 7 hours. Methyl ethyl ketone was distilled off from the reaction liquid using a rotary evaporator. The reaction liquid was sufficiently dried under vacuum to produce 16.6 g of the target compound as a colorless liquid.
¹H-NMR (400 MHz, DMSO-d6): δ(ppm)=0.56(t, 2H), 1.39(s, 3H), 1.56-1.81(m, 10H), 2.42(t, 2H), 2.58(t, 2H), 2.83(t, 2H), 3.55(s, 9H).

### <Synthesis Example 3: tetrakis(bis(2-trifluoromethylphenyl)phenylsulfonium)(1,3-di(3-(2-(1-methylcyclopentyloxycarbonyl)ethylthio)propyl)disiloxane-1,1,3,3-tetrayl)undecatungstosilicate (polyacid salt (A-3))>

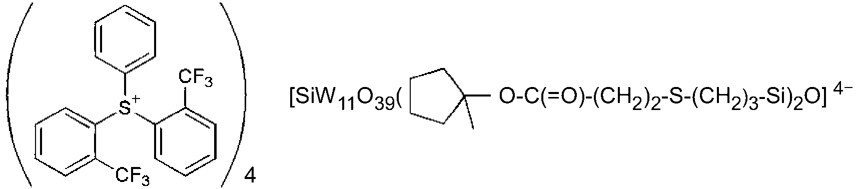

A polyacid salt (A-3) was produced as a target compound in the same manner as in Synthesis Example 1 except that 3-(2-(1-methylcyclopentyloxycarbonyl)ethylthio)propyltrimethoxysilane was used as a raw material compound instead of 4-methoxymethoxyphenyltrimethoxysilane.
¹H-NMR (400 MHz, DMSO-d6): δ(ppm)=0.67(t, 4H), 1.49(s, 6H), 1.54-1.71(m, 16H), 1.99-2.08(m, 4H), 2.49(t, 4H), 2.58(t, 4H), 2.67(t, 4H), 7.65-8.35(m, 52H).
²⁹Si-NMR (119.22 MHz, DMSO-d6): δ(ppm)=-53.02(s, 2Si), -85.04(s, 1Si).
ESI-MS: POSITIVE m/z 399.1 ([C₂₀H₁₃F₆S]⁺)
   NEGATIVE m/z 801.1 (median) ([C₂₄H₄₂O₄₄S₂Si₃W₁₁]⁴⁻)

### <Synthesis Example 4: tetrakis((4-(2-((1-ethylcyclopentyl)oxy)-2-oxoethoxy)-3,5-dimethylphenyl)diphenylsulfonium)(1,3-di(4-methoxymethoxyphenyl)disiloxane-1,1,3,3-tetrayl)undecatungstosilicate (polyacid salt (A-4))>

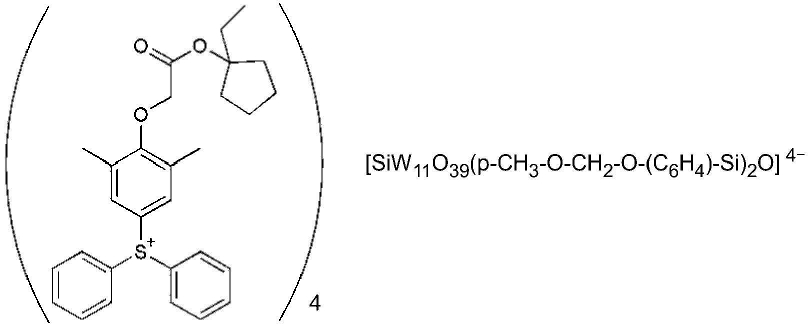

A polyacid salt (A-4) was produced as a target compound in the same manner as in Synthesis Example 1 except that (4-(2-((1-ethylcyclopentyl)oxy)-2-oxoethoxy)-3,5-dimethylphenyl)diphenylsulfonium bromide was used as a raw material compound instead of bis(2-trifluoromethylphenyl)phenylsulfonium chloride.
¹H-NMR (400 MHz, DMSO-d6): δ(ppm)=0.77-0.81(t, 12H), 1.48-1.75(m, 24H), 1.90-1.93(m, 16H), 2.29(m, 24H), 3.37(s, 6H), 4.55(s, 8H), 5.22(s, 4H), 7.05(d, 4H), 7.59(s, 8H), 7.66(d, 4H), 7.75-7.82(m, 40H).
²⁹Si-NMR (119.22 MHz, DMSO-d6): δ(ppm)=-64.72(s, 2Si), -85.02(s, 1Si).
ESI-MS: POSITIVE m/z 461.2 ([C₂₉H₃₃O₃S]⁺)
   NEGATIVE m/z 755.1 (median) ([C₁₆H₁₅O₄₄Si₃W₁₁]⁴⁻)

### <Synthesis Example 5: tetrakis((4-(2-((1-ethylcyclopentyl)oxy)-2-oxoethoxy)-3,5-dimethylphenyl)diphenylsulfonium)(1,3-di(2-((1-methylcyclopentyl)oxycarbonyl)ethyl)disiloxane-1,1,3,3-tetrayl)undecatungstosilicate (polyacid salt (A-5))>

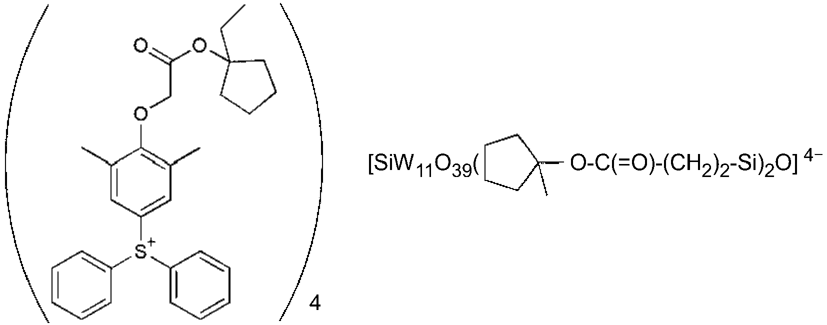

A polyacid salt (A-5) was produced as a target compound in the same manner as in Synthesis Example 1 except that, as raw material compounds, (4-(2-((1-ethylcyclopentyl)oxy)-2-oxoethoxy)-3,5-dimethylphenyl)diphenylsulfonium bromide was used instead of bis(2-trifluoromethylphenyl)phenylsulfonium chloride, and 2-((1-methylcyclopentyl)oxycarbonyl)ethyltrimethoxysilane was used instead of 4-methoxymethoxyphenyltrimethoxysilane.
¹H-NMR (400 MHz, DMSO-d6): δ(ppm)=0.77-0.81(m, 16H), 1.48-1.93(m, 62H), 2.29(m, 24H), 2.37-2.42(m, 4H), 4.55(s, 8H), 7.59(s, 8H), 7.76-7.82(m, 40H).
²⁹Si-NMR (119.22 MHz,DMSO-d6): δ(ppm)=-53.12(s, 2Si), -85.01(s, 1Si).
ESI-MS: POSITIVE m/z 461.2 ([C₂₉H₃₃O₃S]⁺)
   NEGATIVE m/z 764.4 (median) ([C₁₈H₃₀O₄₄Si₃W₁₁]⁴⁻)

### <Synthesis Example 6: tetrakis((4-(2-((1-ethylcyclopentyl)oxy)-2-oxoethoxy)-3,5-dimethylphenyl)diphenylsulfonium)(1,3-di(2-((2-methyl-2-adamantyl)oxycarbonyl)ethyl)disiloxane-1,1,3,3-tetrayl)undecatungstosilicate (polyacid salt (A-6))>

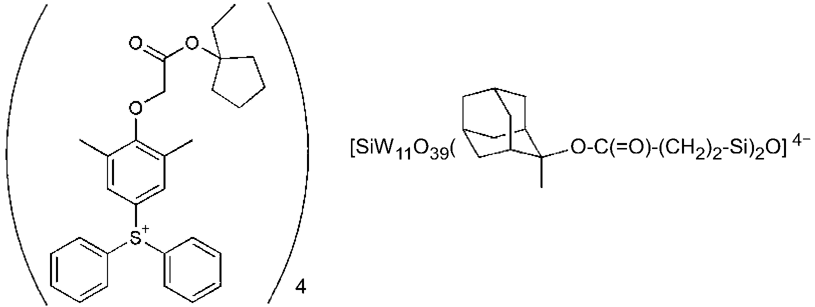

A polyacid salt (A-6) was produced as a target compound in the same manner as in Synthesis Example 1 except that, as raw material compounds, (4-(2-((1-ethylcyclopentyl)oxy)-2-oxoethoxy)-3,5-dimethylphenyl)diphenylsulfonium bromide was used instead of bis(2-trifluoromethylphenyl)phenylsulfonium chloride, and 2-((2-methyl-2-adamantyl)oxycarbonyl)ethyltrimethoxysilane was used instead of 4-methoxymethoxyphenyltrimethoxysilane.
¹H-NMR (400 MHz, DMSO-d6): δ(ppm)=0.76-0.81(t, 16H), 1.45-2.00(m, 74H), 2.29(m, 24H), 2.38-2.44(m, 4H), 4.55(s, 8H), 7.59(s, 8H), 7.76-7.82(m, 40H).
²⁹Si-NMR (119.22 MHz,DMSO-d6): δ(ppm)=-53.07(s, 2Si), -85.03(s, 1Si).
ESI-MS: POSITIVE m/z 461.2 ([C₂₉H₃₃O₃S]⁺)
   NEGATIVE m/z 797.1 (median) ([C₂₈H₄₂O₄₄Si₃W₁₁]⁴⁻)

### <Synthesis Example 7: tetrakis(benzyltriethylammonium)(1,3-di(3-(2-(1-methylcyclopentyloxycarbonyl)ethylthio)propyl)disiloxane-1,1,3,3-tetrayl)undecatungstosilicate (polyacid salt (A-7))>

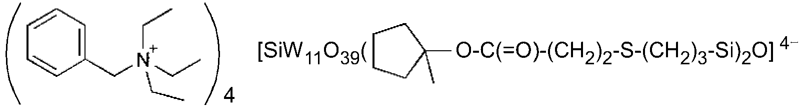

A polyacid salt (A-7) was produced as a target compound in the same manner as in Synthesis Example 1 except that, as raw material compounds, benzyltriethylammonium chloride was used instead of bis(2-trifluoromethylphenyl)phenylsulfonium chloride, and 3-(2-(1-methylcyclopentyloxycarbonyl)ethylthio)propyltrimethoxysilane was used instead of 4-methoxymethoxyphenyltrimethoxysilane.
¹H-NMR (400 MHz, DMSO-d6): δ(ppm)=0.67(t, 4H), 1.34(t, 36H), 1.49(s, 6H), 1.54-1.71(m, 16H), 1.99-2.08(m, 4H), 2.49(t, 4H), 2.58(t, 4H), 2.67(t, 4H), 3.20(q, 24H), 4.49(s, 8H), 7.52(m, 20H).
²⁹Si-NMR (119.22 MHz, DMSO-d6): δ(ppm)=-53.02(s, 2Si), -85.04(s, 1Si).
ESI-MS: POSITIVE m/z 192.2 ([C₁₃H₂₂N]⁺)
   NEGATIVE m/z 801.1 (median) ([C₂₄H₄₂O₄₄S₂Si₃W₁₁]⁴⁻)

### <Synthesis Example 8: tetrakis(benzyltrimethylammonium)(1,3-di(2-((1-methylcyclopentyl)oxycarbonyl)ethyl)disiloxane-1,1,3,3-tetrayl)undecatungstosilicate (polyacid salt (A-8))>

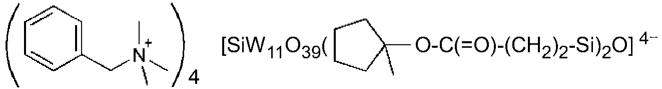

A polyacid salt (A-8) was produced as a target compound in the same manner as in Synthesis Example 1 except that, as raw material compounds, benzyltrimethylammonium chloride was used instead of bis(2-trifluoromethylphenyl)phenylsulfonium chloride, and 2-((1-methylcyclopentyl)oxycarbonyl)ethyltrimethoxysilane was used instead of 4-methoxymethoxyphenyltrimethoxysilane.
¹H-NMR (400 MHz, DMSO-d6): δ(ppm)=0.77-0.81(m, 4H), 1.49-1.84(m, 22H), 2.37-2.42(m, 4H), 3.04(s, 36H), 4.53(s, 8H), 7.50-7.57(m, 20H).
²⁹Si-NMR (119.22 MHz, DMSO-d6): δ(ppm)=-53.12(s, 2Si), -85.01(s, 1Si).
ESI-MS: POSITIVE m/z 150.1 ([C₁₀H₁₆N]⁺)
   NEGATIVE m/z 764.4 (median) ([C₁₈H₃₀O₄₄Si₃W₁₁]⁴⁻)

### <Synthesis Example 9: tetrakis(hexyltriethylammonium)(1,3-di(4-methoxymethoxyphenyl)disiloxane-1,1,3,3-tetrayl)undecatungstosilicate (polyacid salt (A-9))>

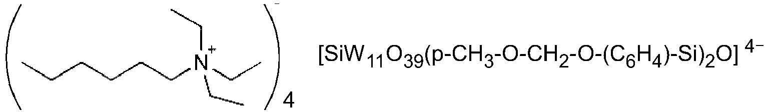

A polyacid salt (A-9) was produced as a target compound in the same manner as in Synthesis Example 1 except that hexyltriethylammonium chloride was used as a raw material compound instead of bis(2-trifluoromethylphenyl)phenylsulfonium chloride.
¹H-NMR (400 MHz, DMSO-d6): δ(ppm)=0.88(t, 12H), 1.17-1.21(m, 36H), 1.31(br, 24H), 1.58(br, 8H), 3.10-3.14(m, 8H), 3.26(q, 24H), 3.37(s, 6H), 5.22(s, 4H), 7.05(d, 4H), 7.66(d, 4H).
²⁹Si-NMR (119.22 MHz, DMSO-d6): δ(ppm)=-64.72(s, 2Si), -85.02(s, 1Si).
ESI-MS: POSITIVE m/z 186.2 ([C₁₂H₂₈N]⁺)
   NEGATIVE m/z 755.1 (median) ([C₁₆H₁₈O₄₄Si₃W₁₁]⁴⁻)

### <Synthesis Example 10: tetrakis((2-trifluoromethylbenzyl)triallylammonium)(1,3-diphenyldisiloxane-1,1,3,3-tetrayl)undecatungstosilicate (polyacid salt (A-10))>

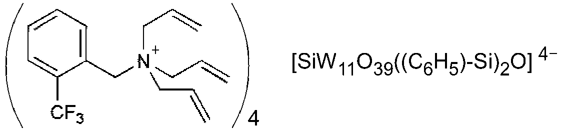

A polyacid salt (A-10) was produced as a target compound in the same manner as in Synthesis Example 1 except that, as raw material compounds, (2-trifluoromethylbenzyl)triallylammonium bromide was used instead of bis(2-trifluoromethylphenyl)phenylsulfonium chloride, and phenyltrimethoxysilane was used instead of 4-methoxymethoxyphenyltrimethoxysilane.
¹H-NMR (400 MHz, DMSO-d6): δ(ppm)=4.04(d, 24H), 4.73(s, 8H), 5.65(d, 12H), 5.73(d, 12H), 6.02-6.12(m, 12H), 7.38-7.45(m, 6H), 7.74-7.88(m, 16H), 7.94(d, 4H).
²⁹Si-NMR (119.22 MHz, DMSO-d6): δ(ppm)=-65.54(s, 2Si), -84.97(s, 1Si).
ESI-MS: POSITIVE m/z 296.2 ([C₁₇H₂₁F₃N]⁺)
   NEGATIVE m/z 725.1 (median) ([C₁₂H₁₀O₄₀Si₃W₁₁]⁴⁻)

### <Synthesis Example 11: tetrakis(cyanomethyltriphenylphosphonium)(1,3-di(4-methoxymethoxyphenyl)disiloxane-1,1,3,3-tetrayl)undecatungstosilicate (polyacid salt (A-11))>

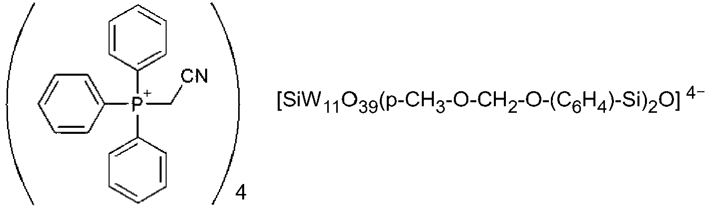

A polyacid salt (A-11) was produced as a target compound in the same manner as in Synthesis Example 1 except that cyanomethyltriphenylphosphonium chloride was used as a raw material compound instead of bis(2-trifluoromethylphenyl)phenylsulfonium chloride.
¹H-NMR (400 MHz, DMSO-d6): δ(ppm)=3.37(s, 6H), 5.22(s, 4H), 6.32(d, 8H), 7.05(d, 4H), 7.66(d, 4H), 7.81-8.01(m, 60H).
²⁹Si-NMR (119.22 MHz, DMSO-d6): δ(ppm)=-64.72(s, 2Si), -85.02(s, 1Si).
ESI-MS: POSITIVE m/z 302.1 ([C₂₀H₁₇NP]⁺)
   NEGATIVE m/z 755.1 (median) ([C₁₆H₁₈O₄₄Si₃W₁₁]⁴⁻)

### <Synthesis Example 12: tetrakis(allyltriphenylphosphonium)(1,3-di(3-mercaptopropyl)disiloxane-1,1,3,3-tetrayl)undecatungstosilicate (polyacid salt (A-12))>

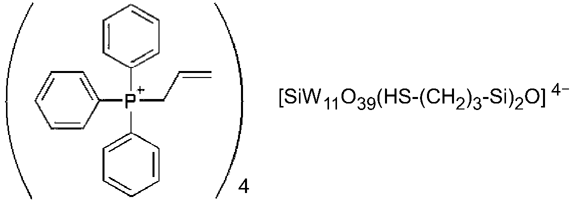

A polyacid salt (A-12) was produced as a target compound in the same manner as in Synthesis Example 1 except that, as raw material compounds, allyltriphenylphosphonium chloride was used instead of bis(2-trifluoromethylphenyl)phenylsulfonium chloride, and 3-mercaptopropyltrimethoxysilane was used instead of 4-methoxymethoxyphenyltrimethoxysilane. ¹H-NMR (400 MHz, DMSO-d6): δ(ppm)=0.67(t, 4H), 1.70-1.83(m, 4H), 2.14(t, 2H), 2.53-2.61(m, 4H), 4.89(dd, 8H), 5.38-5.42(m, 4H), 5.64-5.74(m, 8H), 7.69-7.88(m, 60H).
²⁹Si-NMR (119.22 MHz, DMSO-d6): δ(ppm)=-53.06(s, 2Si), -85.20(s, 1Si).
ESI-MS: POSITIVE m/z 303.1 ([C₂₁H₂₀P]⁺)
   NEGATIVE m/z 724.1 (median) ([C₆H₁₄O₄₀S₂Si₃W₁₁]⁴⁻)

### <Synthesis Example 13: tetrakis(bis(2-trifluoromethylphenyl)phenylsulfonium)(1,3-divinyldisiloxane-1,1,3,3-tetrayl)undecatungstosilicate (polyacid salt (A-13))>

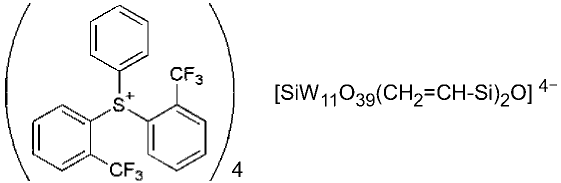

A polyacid salt (A-13) was produced as a target compound in the same manner as in Synthesis Example 1 except that vinyltrimethoxysilane was used as a raw material compound instead of 4-methoxymethoxyphenyltrimethoxysilane.
¹H-NMR (400 MHz, DMSO-d6): δ(ppm)=5.94(dd, 2H), 6.08(dd, 2H), 6.13(dd, 2H), 7.65-8.35(m, 52H).
²⁹Si-NMR (119.22 MHz, DMSO-d6): δ(ppm)=-66.56(s, 2Si), -85.29(s, 1Si).
¹⁸³W-NMR (20.84 MHz, DMSO-d6): δ(ppm)=-105.52(s, 2W), -107.54(s, 2W), -112.04(s, 1W), - 126.08(s, 2W), -170.95(s, 2W), -247.66(s, 2W).
ESI-MS: POSITIVE m/z 399.1 ([C₂₀H₁₃F₆S]⁺)
   NEGATIVE m/z 700.3 (median) ([C₄H₆O₄₀Si₃W₁₁]⁴⁻)

### <Synthesis Example 14: tetrakis(triphenylsulfonium)silicotungstate (polyacid salt (A-14))>

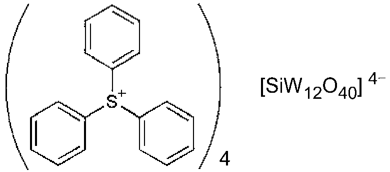

25.6 g of triphenylsulfonium chloride was dissolved in 50 g of cyclohexanone, 41.06 g of silicotungstic acid (H₄[SiW₁₂O₄₀]·26H₂O) was added thereto, and the reaction liquid was stirred at room temperature for 2 hours. A powder produced by filtering the reaction liquid was dried under reduced pressure at room temperature for 18 hours. The dried powder was crystallized at room temperature using dichloromethane and acetonitrile to produce a polyacid salt (A-14) as a target compound.
¹H-NMR (400 MHz, DMSO-D6): δ(ppm)=7.74-7.90(m, 60H).
¹⁸³W-NMR (20.84 MHz, DMSO-D6): δ(ppm)=-92.7(s, 12W).
ESI-MS: NEGATIVE m/z 718.5 (median) ([SiW₁₂O₄₀]⁴⁻)

### <Synthesis Example 15: tetrakis(bis(4-t-butylphenyl)iodonium)(1,3-di(4-methoxymethoxyphenyl)disiloxane-1,1,3,3-tetrayl)undecatungstosilicate (polyacid salt (A-15))>

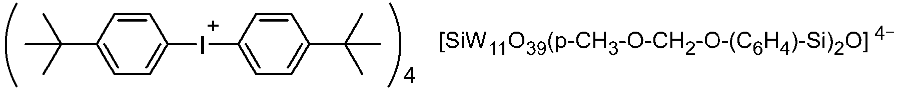

The target compound was produced in the same manner as in Synthesis Example 1 except that bis(4-t-butylphenyl)iodonium methyl sulfate was used as a raw material compound instead of bis(2-trifluoromethylphenyl)phenylsulfonium chloride.
¹H-NMR (400 MHz, DMSO-D6): δ(ppm)=1.25(s, 72H), 3.37(s, 6H), 5.22(s, 4H), 7.05(d, 4H), 7.56(d, 16H), 7.66(d, 4H), 8.18(d, 16H).
²⁹Si-NMR (119.22 MHz, DMSO-d6): δ(ppm)=-64.72(s, 2Si), -85.02(s, 1Si).
ESI-MS: POSITIVE m/z 393.1 ([C₂₀H₂₆I]⁺)
   NEGATIVE m/z 755.1 (median) ([C₁₆H₁₈O₄₄Si₃W₁₁]⁴⁻)

### <Synthesis Example 16: tetrakis(bis(mesityl)iodonium)(1,3-dimethyldisiloxane-1,1,3,3-tetrayl)undecatungstosilicate (polyacid salt (A-16))>

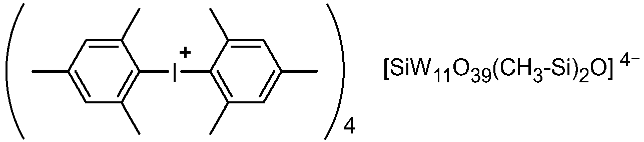

The target compound was produced in the same manner as in Synthesis Example 1 except that, as raw material compounds, a methanol solution of bis(mesityl)iodonium triflate was used instead of bis(2-trifluoromethylphenyl)phenylsulfonium chloride, and methyltrimethoxysilane was used instead of 4-methoxymethoxyphenyltrimethoxysilane.
¹H-NMR (400 MHz, DMSO-D6): δ(ppm)=0.04(s, 6H), 2.29(s, 24H), 2.47(s, 48H), 7.19(s, 16H).
²⁹Si-NMR (119.22 MHz, DMSO-d6): δ(ppm)=-51.15(s, 2Si), -85.08(s, 1Si).
ESI-MS: POSITIVE m/z 365.1 ([C₁₈H₂₂I]⁺)
   NEGATIVE m/z 694.1 (median) ([C₂H₆O₄₀Si₃W₁₁]⁴⁻)

### <Production Example 3: 3-(2-(2-cyclopentenyloxycarbonyl)ethylthio)propyltrimethoxysilane>

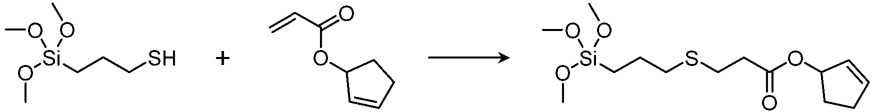

The target compound was produced in the same manner as in Production Example 2 except that 2-cyclopentenyl acrylate was used as a raw material compound instead of 1-methylcyclopentyl acrylate.
¹H-NMR (400 MHz, DMSO-d6): δ(ppm)=0.56(t, 2H), 1.62(quint, 2H), 2.02-2.33(m, 4H), 2.42(t, 2H), 2.62(t, 2H), 2.83(t, 2H), 3.55(s, 9H), 5.45-5.60(m, 3H).

### <Synthesis Example 17: tetrakis(bis(2-trifluoromethylphenyl)phenylsulfonium)(1,3-di(3-(2-((2-cyclopentenyl)oxycarbonyl)ethylthio)propyl)disiloxane-1,1,3,3-tetrayl)undecatungstosilicate (polyacid salt (A-17))>

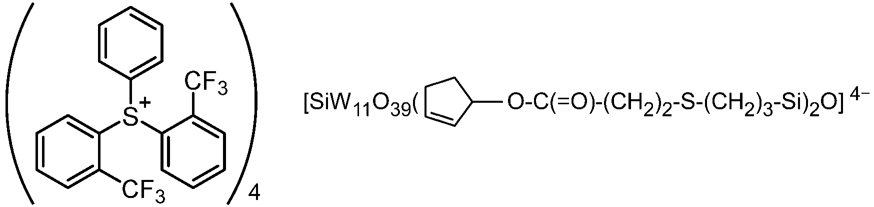

The target compound was produced in the same manner as in Synthesis Example 1 except that 3-(2-(2-cyclopentenyloxycarbonyl)ethylthio)propyltrimethoxysilane was used as a raw material compound instead of 4-methoxymethoxyphenyltrimethoxysilane.
¹H-NMR (400 MHz, DMSO-d6): δ(ppm)=0.67(t, 4H), 1.62(quint, 4H), 2.02-2.33(m, 8H), 2.42(t, 4H), 2.62-2.67(m, 8H), 5.45-5.60(m, 6H), 7.65-8.35(m, 52H).
²⁹Si-NMR (119.22 MHz, DMSO-d6): δ(ppm)=-53.02(s, 2Si), -85.04(s, 1Si).
ESI-MS: POSITIVE m/z 399.1 ([C₂₀H₁₃F₆S]⁺)
   NEGATIVE m/z 793.1 (median) ([C₂₂H₃₄O₄₄S₂Si₃W₁₁]⁴⁻)

### <Production Example 4: 3-(2-(2-cyclohexenyloxycarbonyl)ethylthio)propyltrimethoxysilane>

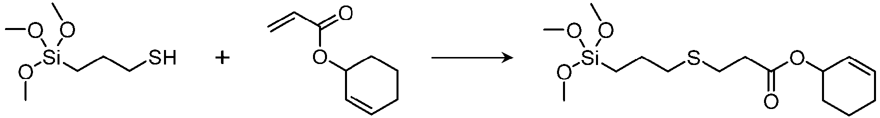

The target compound was produced in the same manner as in Production Example 2 except that 2-cyclohexenyl acrylate was used as a raw material compound instead of 1-methylcyclopentyl acrylate.
¹H-NMR (400 MHz, DMSO-d6): δ(ppm)=0.56(t, 2H), 1.60-2.08(m, 8H), 2.42(t, 2H), 2.62(t, 2H), 2.83(t, 2H), 3.55(s, 9H), 5.13(m, 1H), 5.59-5.65(m, 2H).

### <Synthesis Example 18: tetrakis(bis(2-trifluoromethylphenyl)phenylsulfonium)(1,3-di(3-(2-((2-cyclohexenyl)oxycarbonyl)ethylthio)propyl)disiloxane-1,1,3,3-tetrayl)undecatungstosilicate (polyacid salt (A-18))>

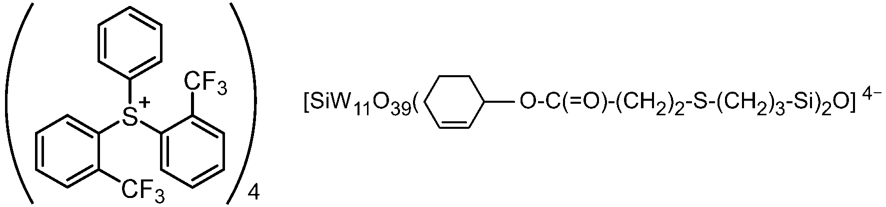

The target compound was produced in the same manner as in Synthesis Example 1 except that 3-(2-((2-cyclohexenyl)oxycarbonyl)ethylthio)propyltrimethoxysilane was used as a raw material compound instead of 4-methoxymethoxyphenyltrimethoxysilane.
¹H-NMR (400 MHz, DMSO-d6): δ(ppm)=0.67(t, 4H), 1.60-2.08(m, 16H), 2.42(t, 4H), 2.62-2.67(m, 8H), 5.13(m, 2H), 5.59-5.65(m, 4H), 7.65-8.35(m, 52H).
²⁹Si-NMR (119.22 MHz, DMSO-d6): δ(ppm)=-53.02(s, 2Si), -85.04(s, 1Si).
ESI-MS: POSITIVE m/z 399.1 ([C₂₀H₁₃F₆S[⁺)
   NEGATIVE m/z 800.1 (median) ([C₂₄H₃₈O₄₄S₂Si₃W₁₁]⁴⁻)

### <Production Example 5: 3-(2-((3-methyl-2-cyclohexenyl)oxycarbonyl)ethylthio)propyltrimethoxysilane>

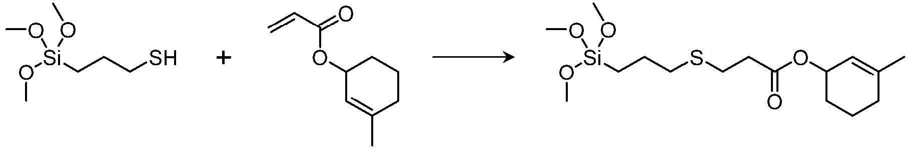

The target compound was produced in the same manner as in Production Example 2 except that 3-methyl-2-cyclohexenyl acrylate was used as a raw material compound instead of 1-methylcyclopentyl acrylate.
¹H-NMR (400 MHz, DMSO-d6): δ(ppm)=0.56(t, 2H), 1.60-2.01(m, 11H), 2.42(t, 2H), 2.62(t, 2H), 2.83(t, 2H), 3.55(s, 9H), 5.13(m, 1H), 5.37(d, 1H).

### <Synthesis Example 19: tetrakis(bis(2-trifluoromethylphenyl)phenylsulfonium)(1,3-di(3-(2-((3-methyl-2-cyclohexenyl)oxycarbonyl)ethylthio)propyl)disiloxane-1,1,3,3-tetrayl)undecatungstosilicate (polyacid salt (A-19))>

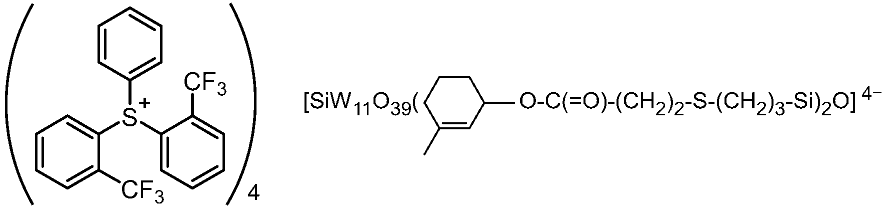

The target compound was produced in the same manner as in Synthesis Example 1 except that 3-(2-((3-methyl-2-cyclohexenyl)oxycarbonyl)ethylthio)propyltrimethoxysilane was used as a raw material compound instead of 4-methoxymethoxyphenyltrimethoxysilane.
¹H-NMR (400 MHz, DMSO-d6): δ(ppm)=0.67(t, 4H), 1.60-2.01(m, 22H), 2.42(t, 4H), 2.62-2.67(m, 8H), 5.13(m, 2H), 5.37(d, 2H), 7.65-8.35(m, 52H).
²⁹Si-NMR (119.22 MHz, DMSO-d6): δ(ppm)=-53.02(s, 2Si), -85.04(s, 1Si).
ESI-MS: POSITIVE m/z 399.1 ([C₂₀H₁₃F₆S]⁺)
   NEGATIVE m/z 807.1 (median) ([C₂₆H₄₂O₄₄S₂Si₃W₁₁]⁴⁻)

### <Production Example 6: 3-(2-(1-indanyloxycarbonyl)ethylthio)propyltrimethoxysilane>

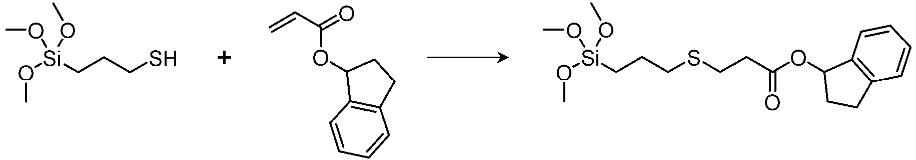

The target compound was produced in the same manner as in Production Example 2 except that 1-indanyl acrylate was used as a raw material compound instead of 1-methylcyclopentyl acrylate. ¹H-NMR (400 MHz, DMSO-d6): δ(ppm)=0.56(t, 2H), 2.15-2.42(m, 6H), 2.62(t, 2H), 2.83(t, 2H), 3.11-3.21(m, 2H), 3.55(s, 9H), 6.08(t, 1H), 7.06-7.26(m, 4H).

### <Synthesis Example 20: tetrakis(bis(2-trifluoromethylphenyl)phenylsulfonium)(1,3-di(3-(2-(1-indanyloxycarbonyl)ethylthio)propyl)disiloxane-1,1,3,3-tetrayl)undecatungstosilicate (polyacid salt (A-20))>

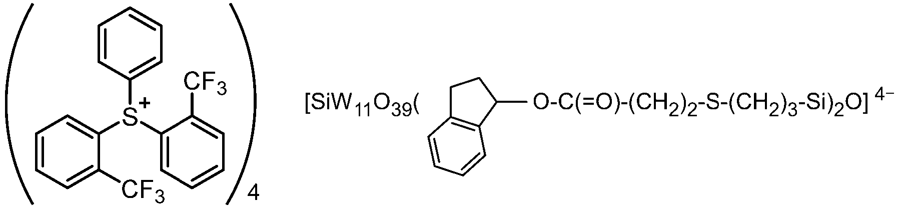

The target compound was produced in the same manner as in Synthesis Example 1 except that 3-(2-(1-indanyloxycarbonyl)ethylthio)propyltrimethoxysilane was used as a raw material compound instead of 4-methoxymethoxyphenyltrimethoxysilane.
¹H-NMR (400 MHz, DMSO-d6): δ(ppm)=0.67(t, 4H), 2.15-2.42(m, 12H), 2.62-2.67(m, 8H), 3.11-3.21(m, 4H), 6.08(t, 2H), 7.06-7.26(m, 8H), 7.65-8.35(m, 52H).
²⁹Si-NMR (119.22 MHz, DMSO-d6): δ(ppm)=-53.02(s, 2Si), -85.04(s, 1Si).
ESI-MS: POSITIVE m/z 399.1 ([C₂₀H₁₃F₆S]⁺)
   NEGATIVE m/z 818.1 (median) ([C₃₀H₃₈O₄₄S₂Si₃W₁₁]⁴⁻)

### [2. Preparation of Test Resist Material and Formation of Resist Film]

Test resist materials (R-1) to (R-19) were prepared by blending the synthesized polyacid salts (A-1) to (A-13) and (A-15) to (A-20) and an organic solvent as test resist materials so as to have the contents (unit: parts by mass) shown in Table 1 below.

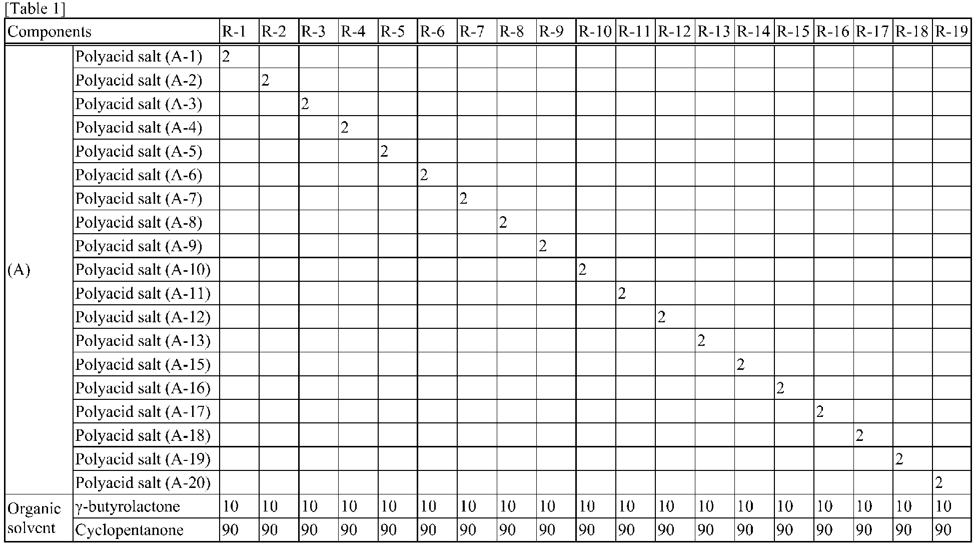

Each of the resist materials R-1 to R-19 was applied using a spinner to an 8-inch silicon substrate subjected to a hexamethyldisilazane (HMDS) treatment, was subjected to a post-apply bake (PAB) treatment on a hot plate at a temperature of 120°C for 60 seconds, and was dried to form a resist film with a thickness of 50 nm. The thickness of the formed film was measured with a thickness measuring apparatus ("M-2000D" manufactured by J. A. Woollam).

When the resist materials (R-1) to (R-19) were used, it was confirmed that uniform resist films without defects were formed.

### [3. Formation of LS Pattern]

Test resist materials (R'-1) to (R'-17) were prepared by blending the synthesized polyacid salts (A-1) to (A-6), (A-14), (A-15), and (A-17) to (A-20), an acid diffusion control agent, and an organic solvent as test resist materials so as to have the contents (unit: parts by mass) shown in Table 2 below.

Acid diffusion control agents (B-1) to (B-3) described below were used as the (B) acid diffusion control agents described in Table 2.
- Acid diffusion control agent (B-1): an acid diffusion control agent that is a salt of a triphenylsulfonium cation represented by the following formula (B-1) and a salicylic acid anion 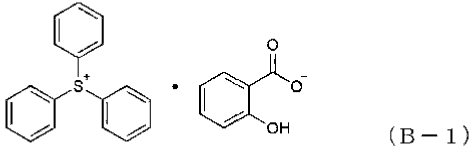
- Acid diffusion control agent (B-2): an acid diffusion control agent that is a salt of a (4-(2-((1-ethylcyclopentyl)oxy)-2-oxoethoxy)-3,5-dimethylphenyl)diphenylsulfonium cation represented by the following formula (B-2) and a salicylic acid anion 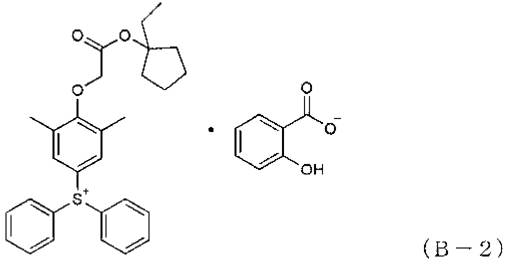
- Acid diffusion control agent (B-3): an acid diffusion control agent that is a salt of a triphenylsulfonium cation represented by the following formula (B-3) and a heptafluorobutyric acid anion

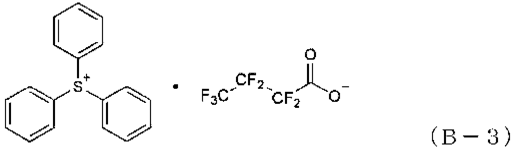

**[Table 2]**

| Components | | R'-1 | R'-2 | R'-3 | R'-4 | R'-5 | R'-6 | R'-7 | R'-8 | R'-9 | R'-10 | R'-11 | R'-12 | R'-13 | R'-14 | R'-15 | R'-16 | R'-17 |
|---|---|---|---|---|---|---|---|---|---|---|---|---|---|---|---|---|---|---|
| (A) | Polyacid salt (A-1) | 2 | 2 | | | | | | | | | | | | | | | |
| | Polyacid salt (A-2) | | | 2 | | | | | | | | | | | | | | |
| | Polyacid salt (A-3) | | | | 2 | | | | | | | | | | | | | |
| | Polyacid salt (A-4) | | | | | 2 | 2 | | | | | | | | | | | |
| | Polyacid salt (A-5) | | | | | | | 2 | | 2 | 2 | | | | | | | |
| | Polyacid salt (A-6) | | | | | | | | 2 | | | | | | | | | |
| | Polyacid salt (A-14) | | | | | | | | | | | 2 | 2 | | | | | |
| | Polyacid salt (A-15) | | | | | | | | | | | | | 2 | | | | |
| | Polyacid salt (A-17) | | | | | | | | | | | | | | 2 | | | |
| | Polyacid salt (A-18) | | | | | | | | | | | | | | | 2 | | |
| | Polyacid salt (A-19) | | | | | | | | | | | | | | | | 2 | |
| | Polyacid salt (A-20) | | | | | | | | | | | | | | | | | 2 |
| (B) | Acid diffusion control agent (B-1) | | 0.12 | 0.12 | 0.12 | | 0.12 | 0.12 | 0.12 | | | | 0.12 | 0.12 | 0.12 | 0.12 | 0.12 | 0.12 |
| | Acid diffusion control agent (B-2) | | | | | | | | | 0.12 | | | | | | | | |
| | Acid diffusion control agent (B-3) | | | | | | | | | | 0.12 | | | | | | | |
| Organic solvent | γ-butyrolactone | 10 | 10 | 10 | 10 | 10 | 10 | 10 | 10 | 10 | 10 | 15 | 15 | 10 | 10 | 10 | 10 | 10 |
| | Cyclopentanone | 90 | 90 | 90 | 90 | 90 | 90 | 90 | 90 | 90 | 90 | | | 90 | 90 | 90 | 90 | 90 |
| | Diacetone alcohol | | | | | | | | | | | 85 | 85 | | | | | |

Each of the resist materials R'-1 to R'-17 was applied using a spinner to an 8-inch silicon substrate subjected to a hexamethyldisilazane (HMDS) treatment, was subjected to a post-apply bake (PAB) treatment on a hot plate at a temperature of 120°C for 60 seconds, and was dried to form a resist film with a thickness of 50 nm. The thickness of the formed film was measured with a thickness measuring apparatus ("M-2000D" manufactured by J. A. Woollam).

Lithography (exposure) was performed on the resist film using an electron-beam lithography system F7000S-VD2 (manufactured by Advantest Corporation) at an accelerating voltage of 50 kV such that the target size was a 1:1 line-and-space pattern (hereinafter also referred to as an "LS pattern") with a line width of 50 nm. Post-exposure bake (PEB) treatment was then performed at 90°C for 60 seconds.

Development was then performed at 23°C for 60 seconds using a developer (NMD-W (manufactured by Tokyo Ohka Kogyo Co., Ltd.)), and rinsing was performed for 15 seconds using pure water.

As a result, 1:1 LS patterns with a line width of 50 nm were formed, and LS patterns (LS-1) to (LS-17) corresponding to the test resist materials (R'-1) to (R'-17) were formed. All of the LS patterns (LS-1) to (LS-17) are positive patterns.

### [4. Evaluation of Shape of LS Pattern]

The shapes of the LS patterns (LS-1) to (LS-17) were observed with a critical dimension scanning electron microscope (SEM) (accelerating voltage: 10 kV, trade name: SU-5000, manufactured by Hitachi High-Tech Corporation) and were evaluated in accordance with the following criteria. Table 3 shows the results.
A: Almost no tailing is observed in the LS pattern of the SEM image, and the resolution is good.
B: Tailing is slightly observed in part of the LS pattern of the SEM image.
C: The LS pattern is not formed (not resolved) in the entire SEM image.

**[Table 3]**

| LS pattern | LS-1 | LS-2 | LS-3 | LS-4 | LS-5 | LS-6 | LS-7 | LS-8 | LS-9 | LS-10 | LS-11 | LS-12 |
|---|---|---|---|---|---|---|---|---|---|---|---|---|
| Pattern resolution | B | A | A | A | B | A | A | A | A | A | C | C |
| LS pattern | LS-13 | LS-14 | LS-15 | LS-16 | LS-17 | | | | | | | |
| Pattern resolution | A | A | A | A | A | | | | | | | |

The results of Table 3 show that by using the resist materials (R'-1) to (R'-10) or (R'-13) to (R'-17) containing the polyacid salts (A-1) to (A-6), (A-15), or (A-17) to (A-20), which are heteropolyacid salts having a modified lacunary site, LS patterns with a line width of 50 nm with little or no tailing can be formed with high resolution ((LS-1) to (LS-10) and (LS-13) to (LS-17)). Furthermore, when the pattern resolutions of (LS-1) and (LS-2), and (LS-5) and (LS-6) are compared, it is found that as compared with the case of using the resist material (R'-1) or (R'-5) containing the polyacid salt (A-1) or (A-4), which is a heteropolyacid salt having a modified lacunary site, the use of the resist material (R'-2) or (R'-6) further containing the acid diffusion control agent (B-1) further improves the resolution, and an LS pattern with a line width of 50 nm with almost no tailing can be formed ((LS-2) and (LS-6)).

## Claims

1. A resist material comprising (A) a heteropolyacid salt having a modified lacunary site or a mixture thereof.

2. The resist material according to claim 1, wherein the (A) heteropolyacid salt having a modified lacunary site or the mixture thereof has an anion moiety that is a heteropolyacid anion having a lacunary site in which the lacunary site is modified.

3. The resist material according to claim 2, wherein the heteropolyacid anion has a polyatom of Mo, W, V, Nb, or Ta and a heteroatom of P, Si, B, S, or Ge.

4. The resist material according to claim 2, wherein the heteropolyacid anion having the lacunary site is a lacunary Keggin-type heteropolyacid anion or a lacunary Dawson-type heteropolyacid anion.

5. The resist material according to claim 2, wherein the modification is performed by bonding a group having one or more heteroatoms selected from P, Si, Ge, or Sn, to which one or more organic groups are bonded, to the heteropolyacid anion having the lacunary site via a part or all of the heteroatoms.

6. The resist material according to claim 5, wherein the organic group has one or more polar groups each having an acid-dissociable group.

7. The resist material according to claim 6, wherein the acid-dissociable group is a tertiary-carbon-type acid-dissociable group, an allyl- or benzyl-type acid-dissociable group, an acetal-type acid-dissociable group, or an aminocarbonyl-type acid-dissociable group.

8. The resist material according to claim 1, wherein (A) the heteropolyacid salt having a modified lacunary site or the mixture thereof has one or more H⁺, metal ions, onium cations, or onium dications in a cation moiety thereof.

9. The resist material according to claim 8, wherein the onium cations or the onium dications are ammonium cations, ammonium dications, phosphonium cations, phosphonium dications, sulfonium cations, sulfonium dications, or iodonium cations.

10. The resist material according to claim 1, wherein the (A) heteropolyacid salt having a modified lacunary site or the mixture thereof is a heteropolyacid salt having a modified lacunary site represented by the general formula (I) or a mixture thereof.
(A^{m+})ₐ(C^{(am)-}) (I)
[in the formula (I),
A^{m+} each independently denotes H⁺, a metal ion, an onium cation, or an onium dication; C^{(am)-} denotes a heteropolyacid anion having a lacunary site in which the lacunary site is modified; and
m denotes an integer in the range of 1 to 5, and a denotes a real number greater than 0]

11. The resist material according to claim 10, wherein the heteropolyacid anion having a lacunary site in which the lacunary site is modified has one or more polar groups each having an acid-dissociable group.

12. The resist material according to claim 1, wherein the (A) heteropolyacid salt having a modified lacunary site or the mixture thereof is a heteropolyacid salt having a modified lacunary site represented by the general formula (I') or a mixture thereof.
(A^{'m'+})_{a'}(Bⁿ⁺)_{b}(C'^{(a'm'+bn)-}) (I')
[in the formula (I'),
A'^{m'+} each independently denotes H⁺, a metal ion, an ammonium cation, an ammonium dication, a phosphonium cation, or a phosphonium dication;
Bⁿ⁺ each independently denotes a sulfonium cation, a sulfonium dication, or an iodonium cation;
C'^{(a'm'+bn)-} denotes a heteropolyacid anion having a lacunary site in which the lacunary site is modified; and
m' denotes an integer in the range of 1 to 5, n denotes an integer of 1 or 2, a' denotes a real number, and b denotes a real number greater than 0]

13. The resist material according to claim 12, wherein the heteropolyacid anion having a lacunary site in which the lacunary site is modified has one or more polar groups each having an acid-dissociable group.

14. The resist material according to claim 1, further comprising (B) an acid diffusion control agent.

15. The resist material according to claim 14, wherein the (B) acid diffusion control agent is (B1) a photodegradable base.

16. The resist material according to claim 1, further comprising an organic solvent.

17. The resist material according to any one of claims 1 to 16, which is a resist material for an electron beam or EUV.

18. A pattern formation method comprising:
a step of forming a resist film using the resist material according to any one of claims 1 to 16;
a step of exposing the resist film; and
a step of developing the exposed resist film using a developer.

19. The pattern formation method according to claim 18, wherein the step of exposing the resist film includes a step of exposing the resist film to an electron beam with a dose of 2 mC/cm² or less or extreme ultraviolet of 200 mJ/cm² or less.

20. A patterned structure formed by patterning the resist material according to any one of claims 1 to 16.
